# EUROPÄISCHE PATENTSCHRIFT

(11) **EP 3 036 979 B1**
(45) Veröffentlichungstag und Bekanntmachung des Hinweises auf die Patenterteilung: **01.11.2023**
(21) Anmeldenummer: 14783762.9
(22) Anmeldetag: 21.08.2014
(51) Int. Cl.: H05K 1/02, G05B 19/042, G06F 30/34, G06F 30/39

(54) **INTELLIGENTE PERIPHERIEKOPPLUNGSBAUGRUPPE NEBST COMPUTERGESTÜTZTEN VERFAHREN ZU IHRER ERSTELLUNG ODER HERSTELLUNG, SOWIE COMPUTERGESTÜTZTES VERFAHREN ZUR KONFIGURATION EINES DATENNETZWERKBASIERTEN SYSTEMS ZUR STEUERUNG UND/ODER REGELUNG UND/ODER ÜBERWACHUNG VON ZUMINDEST EINEM PERIPHERIEGERÄT MITTELS DATENÜBERTRAGUNG ZWISCHEN TEILNEHMERN EINES DATENNETZWERKS**
INTELLIGENT PERIPHERAL COUPLING ASSEMBLY AND COMPUTER-ASSISTED METHOD FOR CREATION OR PRODUCTION THEREOF AND COMPUTER-ASSISTED METHOD FOR CONFIGURATION OF A DATA NETWORK-BASED SYSTEM FOR CONTROLLING AND/OR REGULATING AND/OR MONITORING AT LEAST ONE PERIPHERAL DEVICE BY MEANS OF DATA TRANSFER BETWEEN PARTICIPANTS IN A DATA NE
MODULE INTELLIGENT DE COUPLAGE DE PÉRIPHÉRIQUES AINSI QUE PROCÉDÉ ASSISTÉ PAR ORDINATEUR PERMETTANT DE CRÉER OU DE FABRIQUER LEDIT MODULE, ET PROCÉDÉ ASSISTÉ PAR ORDINATEUR PERMETTANT DE CONFIGURER UN SYSTÈME BASÉ SUR UN RÉSEAU DE DONNÉES POUR LA COMMANDE ET/OU LA RÉGULATION ET/OU LA SURVEILLANCE D'AU MOINS UN PÉRIPHÉRIQUE

(30) Priorität: 22.08.2013 DE 102013013811
(43) Veröffentlichungstag der Anmeldung: 29.06.2016
(73) Patentinhaber: Anedo GmbH, 49406 Eydelstedt (DE)
(72) Erfinder: MÖLLER, Andreas, 49424 Goldenstedt-Lutten (DE)
(74) Vertreter: Springorum, Harald
(86) Internationale Anmeldenummer: PCT/DE2014/000430
(87) Internationale Veröffentlichungsnummer: WO 2015/024552

(56) Entgegenhaltungen:
- DE-U- 6 809 065
- US-A- 4 613 924
- US-A- 5 828 864
- US-A- 6 040 985
- US-B1- 6 625 670

## Beschreibung

Die vorliegende Erfindung betrifft eine intelligente Peripheriekopplungsbaugruppe nebst computergestützten Verfahren zu ihrer Erstellung oder Herstellung, sowie computergestütztes Verfahren zur Konfiguration eines datennetzwerkbasierten Systems zur Steuerung und/oder Regelung und/oder Überwachung von zumindest einem Peripheriegerät mittels Datenübertragung zwischen Teilnehmern eines Datennetzwerks - vorzugsweise eines (echtzeitfähigen) Feldbusses -, wobei die intelligente Peripheriekopplungsbaugruppe auf der einen Seite zum Anschluß an ein (zentrales) Steuergerät über das Datennetzwerk und auf der anderen Seite zur elektrischen oder optischen oder drahtlosen Kopplung mit zumindest einem zu steuernden und/oder zu regelnden und/oder zu überwachenden Peripheriegerät - vorzugsweise einer Maschine, etwa einer Landmaschine oder eine Baumaschine, bzw. einer Komponente der Maschine - vorgesehen ist.

Derartige intelligente Peripheriekopplungsbaugruppen, die - im Gegensatz zur Situation wie früher in der Regel üblich - nicht mehr direkt in einem Prozeßrechner (Computer zum Anschluß und/oder zur Steuerung und/oder Regelung und/oder Überwachung etc. von externen Geräten wie Sensoren und/oder Aktoren, wie etwa zur Maschinenüberwachung, -steuerung oder -regelung) enthalten sind, sondern an einen (zentralen) Computer über ein Datennetzwerk angeschlossen werden, sind seit vielen Jahren - etwa in der Kfz-Industrie - Stand der Technik.

Sie bieten den Vorteil, den nicht immer einfachen Anschluß an die jeweiligen Sensoren oder Aktoren in unmittelbarer Nähe dieser Geräte vornehmen zu können, wodurch die Verbindungsleitungen entsprechend kurz gehalten werden können und etwa auch eine dort zumeist schon vorhandene Energieversorgung (mit-)genutzt werden kann. Zum eigentlichen (zentralen) Computer (oftmals auch [zentrales] Steuergerät genannt, siehe oben) verläuft dann nur noch die zum Datennetzwerkanschluß erforderliche Leitung, über die die Kommunikation zwischen intelligenter Peripheriekopplungsbaugruppe und (zentralem) Steuergerät abgewickelt wird, was den Verkabelungsaufwand in aller Regel massiv reduziert und so zu erheblichen Kosteneinsparungen führt.

Dieses Konzept der sogenannten verteilten Intelligenz verhilft so zu einem recht flexiblen Lösungsansatz, bei dem das Problem des Anschlusses der oftmals sehr individuell ausgestalteten Peripheriegeräte in deren unmittelbarer Nähe gelöst werden kann, was häufig auch aus elektrischer Sicht wünschenswert ist, weil es etwa längere und damit störanfällige Signalübertragungswege vermeidet.

Derartige intelligente Peripheriekopplungsbaugruppen nach dem Stand der Technik sind dabei auf einer Platine, zumeist in Mehrschichtleiterbahntechnik (sogenannte Multilayer) angeordnet, wobei
- eine Netzwerkkopplungs-Unterbaugruppe zur Kopplung der intelligenten Peripheriekopplungsbaugruppe an das zentrale Steuergerät über ein Datennetzwerk, und
- eine Microcontroller-Unterbaugruppe zum programmierten Betrieb der intelligenten Peripheriekopplungsbaugruppe, was die Intelligenz der Peripheriekopplungsbaugruppe ausmacht, und desweiteren
- eine (optionale) programmierbare Logik zur Anschaltung - etwa der Microcontroller-Unterbaugruppe - an eine oder mehrere Peripheriekopplungs-Unterbaugruppe(n), die der Kopplung mit zumindest einem zu steuernden und/oder zu regelnden und/oder zu überwachenden Peripheriegerät dienen, sowie
- die Peripheriekopplungs-Unterbaugruppe(n) zur Kopplung mit zumindest einem zu steuernden und/oder zu regelnden und/oder zu überwachenden Peripheriegerät und
- ein Konnektorbauelement - also etwa eine Steckerleiste oder Buchsenleiste - zur elektrischen oder optischen oder gegebenenfalls auch drahtlosen Verbindung (etwa eine Bluetooth- (eingetragene Marke) oder auch WLAN-Sende-/Empfangseinheit) der Peripheriekopplungs-Unterbaugruppe(n) mit dem oder den Peripheriegerät(en)
vorgesehen ist, und
die programmierbare Logik - soweit sie vorgesehen worden ist - und/oder die Microcontroller-Unterbaugruppe und/oder die Netzwerkkopplungs-Unterbaugruppe eine elektrische Verbindung über eine oder mehrere Leitung(en) mit der oder den Peripheriekopplungs-Unterbaugruppe(n) zur Kopplung mit zumindest einem zu steuernden und/oder zu regelnden und/oder zu überwachenden Peripheriegerät aufweist bzw. aufweisen, und
die Peripheriekopplungs-Unterbaugruppe(n) jeweils eine elektrische Verbindung über eine oder mehrere Leitung(en) mit einem oder mehreren Pin(s) des Konnektorbauelements aufweist.

Auf diese Art und Weise können etliche Teile der intelligenten Peripheriekopplungsbaugruppe bereits standardisiert ausgeführt werden, namentlich
- die Netzwerkkopplungs-Unterbaugruppe zur Kopplung der Peripheriekopplungsbaugruppe an das zentrale Steuergerät über ein Datennetzwerk, die - solange dieselbe Datennetzwerkanschlußtechnik verwendet wird - auch bei Anschluß gänzlich unterschiedlicher Peripheriegerät keiner Modifikation bedarf,
- die Microcontroller-Unterbaugruppe zum programmierten Betrieb der Peripheriekopplungsbaugruppe, die jedenfalls hardwareseitig nicht verändert zu werden braucht, solange der Anschluß der unterschiedlichen Peripheriegeräte hier über die Software, also die Programmierung angepaßt werden kann.

Wird die Netzwerkkopplungs-Unterbaugruppe nicht nur zur Kopplung der Peripheriekopplungsbaugruppe an das zentrale Steuergerät über ein Datennetzwerk eingesetzt, sondern auch mit der oder den Peripheriekopplungs-Unterbaugruppen elektrisch verbunden, was etwa durch die Verwendung eines entsprechenden intelligenten ASIC (anwendungsspezifische integrierte Schaltung) geschehen kann, so kann die Intelligenz der Peripheriekopplungsbaugruppe auch bereits in einer derartigen intelligenten ASIC liegen. Sie können nämlich digitale Ein- und/oder Ausgänge in Abhängigkeit der über das Datennetzwerk zum zentralen Steuergerät hin empfangenen und/oder gesendeten Daten setzen oder einlesen. Hierdurch ist es dann in einfacheren Fällen einer Peripheriegeräteanschaltung möglich, auch ohne Microcontroller oder programmierbare Logik die Peripheriegeräte-Unterbaugruppe(n) zur Anschaltung des jeweiligen Peripheriegerätes mit der so ausgestalteten Netzwerkkopplungs-Unterbaugruppe zu verbinden.

Auch die programmierbare Logik - soweit sie vorgesehen worden ist - kann flexibel, eben durch ihre Programmierung (oft auch Konfiguration genannt) auf die jeweiligen Anschlußerfordernisse etwa der Microcontroller-Unterbaugruppe und/oder der Netzwerkkopplungs-Unterbaugruppe an die (intelligente[n]) Peripheriekopplungs-Unterbaugruppe(n) zugeschnitten werden und zwar ebenfalls ohne, daß es einer Änderung der Hardware und ihrer Verdrahtung auf der Platine der intelligenten Peripheriekopplungsbaugruppe bedarf, wobei hier unter dem Begriff der programmierbaren Logik alle programmierbaren Logikschaltungen in weitestem Sinne, also insbesondere etwa
- programmierbare Nur-Lese-Speicher (PROM ~ Programmable Read-Only-Memory),
- sogenannte Programmable Array Logic (PAL) oder sogenannte Generic Array Logic (GAL),
- programmierbare logische Anordnungen (PLA),
- sogenannte PLD's (Programmable Logic Devices), wie etwa
   - sogenannte Complex Programmable Logic Devices (CPLD) oder
   - sogenannte Field Programmable Gate Arrays (FPGA)
verstanden werden. Insbesondere die modernen programmierbaren Logiken, also CPLD und FPGA bieten hierbei vorzugsweise sogar die Möglichkeit, unterschiedliche Signalpegel (wie etwa TTL, PCI oder LVDS) zu realisieren.

Etwa die letztgenannten Ausführungsformen einer programmierbaren Logik, also sogenannte PLD's (Programmable Logic Devices) oder auch etwa die sogenannten Complex Programmable Logic Devices (CPLD) oder sogenannte Field Programmable Gate Arrays (FPGA) bieten auch recht weitgehende Ausgestaltungsmöglichkeiten einer programmierbaren Logik, die ebenfalls die Intelligenz der Peripheriekopplungsbaugruppe ausmachen kann, was es auch ermöglicht, etwa ganz auf einen Microcontroller zu verzichten, da etwa alle benötigten intelligenten Funktionen durch die programmierbare Logik realisiert werden. Auch kann die programmierbare Logik so programmiert werden, daß sie die Funktion anderer (Unter-)baugruppen gleich mit übernimmt. So ist es etwa möglich, eine Microcontrolle-Unterbaugruppe dadurch vorzusehen, daß der entsprechende Microcontroller einfach als Programmierung in die programmierbare Logik geladen wird und so dann ohne eigene Hardware, aber dennoch als voll funktionsfähige Microcontroller-Unterbaugruppe zur Verfügung steht. Grundsätzlich ist dies auch für die Netzwerkkopplungs-Unterbaugruppe möglich.

Einzig die jeweils über eine oder mehrere Leitung(en) mit einem oder mehreren Pin(s) des Konnektorbauelements verbundene(n) Peripheriekopplungs-Unterbaugruppe(n), die der Kopplung mit zumindest einem zu steuernden und/oder zu regelnden und/oder zu überwachenden Peripheriegerät dienen, bedürfen aufgrund der Vielzahl der denkbaren anzuschließenden Peripheriegeräte einer jeweiligen individuellen hardwareseitigen Gestaltung, also etwa der Ausstattung mit Leistungsbauelementen zur Ansteuerung von Motoren oder mit Digital-/Analog-Wandlern oder auch umgekehrt mit Analog-Digitalwandlern, wo Meßelemente als Sensoren angeschaltet werden sollen. Insbesondere der Übergang von digitalen zu analogen Daten und umgekehrt ist dabei nicht immer einfach und verschließt sich aufgrund der Anforderungen im Einzelfall - insbesondere der dabei oftmals auftretenden diffizilen Abstimmprobleme der Analogschaltkreise - weitgehend einer Standardisierung.

Diese Problematik ließe sich technisch zwar durch eine Restriktion der verwendbaren Peripheriekopplungs-Unterbaugruppen auf eine Anzahl gewisser Grundtypen lösen, dies wäre aber inflexibel, hieße dies doch auf einen großen Vorteil des Konzepts der verteilten Intelligenz (siehe oben) verzichten, die ja gerade eine Vielzahl individueller Peripherie anzukoppeln helfen soll, indem sie die hierzu erforderliche Intelligenz, also etwa den entsprechenden programmierbaren Microcontroller in die Nähe dieser Peripherie bringt. Diese Intelligenz, also gegebenenfalls die programmierbaren Möglichkeiten des Microcontrollers, der etwaigen programmierbaren Logik oder auch einer etwaigen intelligenten Netzwerkkopplungs-Unterbaugruppe (etwa ein entsprechend intelligentes ASIC, siehe oben) zu den Peripheriekopplungs-Unterbaugruppen hin, die damit sozusagen ,*vor Ort'*, also in räumlicher Nähe des jeweiligen Peripheriegerätes über eine kurze Verbindung zu diesem grundsätzlich nutzbar ist, gleichwohl nicht voll für die Kopplung mit jeder wünschenswerten und auf die jeweilige zu lösende technische Aufgabe zugeschnittenen Peripherie ausnutzen zu können, da die entsprechenden zwischenliegenden Peripheriekopplungs-Unterbaugruppen standardisiert werden und somit nicht jedes Peripheriegerät ansteuern zu können, wäre somit technisch nicht erstrebenswert.

Andererseits erscheint aber eine möglichst hohe Standardisierung schon aus Kostengründen von Nutzen, ist doch das Leiterplattendesign für derart individuelle Baugruppen, wie sie hier in Rede stehen, recht aufwendig und muß zudem bei jeder Anpassung an ein neues individuelles Peripheriegerät stets aufs Neue aufwendig durchgeführt werden.

Standardisierungsbemühungen des Baugruppenaufbaus und/oder der zugehörigen Platine mit verschiedenen Funktionseinheiten ist dabei im Stand der Technik grundsätzlich nicht unbekannt.

So lehrt etwa die DE 299 04 507 U1 die Anordnung einer Speisung von Funktionseinheiten eines Gesamtsystems, bei der jeweils der Masseanschluß der Versorgungsspannung für die eine Funktionseinheit mit dem Masseanschluß für die andere Funktionseinheit durch eine Kapazität unmittelbar verbunden ist, um so die Störaussendung auf Netzleitungen zu minimieren.

Die US 5 761 051 zeigt ein Spannungsversorgungssystem für eine Mehrschichtleiterplatte mit einem Versorgungsbus, bestimmten Versorgungsschichten und Isolationsvorrichtungen, wobei dieses Spannungsversorgungssystem es erleichtert, die an verschiedenen Orten der Mehrschichtleiterplatte angeordneten unterschiedlichen Funktionseinheiten, wie CPU, Speicherkomponenten, Eingabe-/Ausgabekomponenten, Graphikbaugruppen usw. mit der notwendigen elektrischen Spannung zu versorgen, da hierzu nur ein Anschluß der Funktionseinheit an die entsprechende Schicht des Spannungsversorgungssystems nötig ist, die an jedem Ort der Mehrschichtleiterplatte zur Verfügung steht.

Die WO 02/096048 A1 zeigt eine Kommunikationsbaugruppe zur Kopplung mit einem externen Kommunikationsmedium und insbesondere eine Kondensatorstruktur zur Verwendung als Hochspannungsisolation zur Isolation der Baugruppe vom (Telefon-)Netz mit seinen dortigen hohen Spannungsspitzen. Die dortige Kondensatorstruktur kann dabei zur bestmöglichen Flächenausnutzung auf der Platine flexibel gestaltet werden und wird als Leiterbahnen(schicht)struktur in etwa zwei oder mehr Schichten einer Mehrschichtleiterplatte ausgebildet.

Die DE 80 05 879 U1 will die Herstellung von Prototypenplatinen oder dergleichen Einzelstücke vereinfachen, indem sie eine standardisierte gerasterte Kupferschicht zeigt, die sich einer ätzbeständiger Folienabdeckung entlang der Rasterung bei anschließender Wegätzung der nicht abgedeckten Leiterbahnen bedient.

Die US 6 625 670 zeigt eine Peripheriekopplungsbaugruppe mit einer Netzwerkkopplungs-Unterbaugruppe zur Kopplung der Peripheriekopplungsbaugruppe über ein Datennetzwerk einerseits und einer Peripheriekopplungs-Unterbaugruppe zur Kopplung eines Peripheriegeräts andererseits.

Die US 5 828 864 zeigt ebenfalls eine intelligente Peripheriekopplungsbaugruppe, die auf einer Platine mit einer Leiterbahnenschicht Unterbaugruppen aufweist, wobei eine Netzwerkkopplungs-Unterbaugruppe zur Kopplung der Peripheriekopplungsbaugruppe an ein Steuergerät über ein Datennetzwerk (LAN), sowie einer Peripheriekopplungs-Unterbaugruppe zur Kopplung mit dem zu steuernden und/oder zu regelnden und/oder zu überwachenden Peripheriegerät nebst einem Konnektorbauelement zur elektrischen Verbindung der Peripheriekopplungs-Unterbaugruppe mit dem Peripheriegerät vorgesehen ist.

Die US 4 613 924 bezieht sich auf die Erstellung von Platinenprototypen und zeigt eine Gedruckte Rasterplatte mit einer Bestückungsfläche, mit einer Verdrahtungsfläche und mit mehreren Reihen durchkontaktierter Löcher.

Die US 6 040 985 zeigt eine Leiterplatte, die einen Bereich zur Montage allgemeiner elektrischer Bauteile und einen programmierbaren Bereich zur Montage programmierbarer digitaler elektrischer Bauteile enthält, die auf derselben Leiterplatte vorgesehen sind.

Die DE 68 09 065 U zeigt eine elektronische Baugruppe mit einer Leiterplatte, auf der elektronische Baueinheiten unterschiedlicher Große angebracht sind, wobei auf der Leiterplatte für die Baueinheiten spalten- und zeilenweise geordnete rechteckige Bestückungsplätze vorgesehen sind, deren Größe den kleinsten Baueinheiten angepasst ist, und wobei die Baueinheiten jeweils einen oder mehrere Bestückungsplätze überdecken und das Raster ihrer Anschlussdrähte gleich ist.

Vor diesem Hintergrund ist es daher Aufgabe der vorliegenden Erfindung eine intelligente Peripheriekopplungsbaugruppe vorzuschlagen, die so aufgebaut ist, daß sie einerseits zwar eine hohe Flexibilität im Hinblick auf die Ankoppelbarkeit von möglichst individuellen Peripheriegeräten erhält, andererseits gleichwohl aber dennoch Standardisierungspotentiale des Baugruppenaufbaus erschließt und damit das Leiterplattendesign der intelligenten Peripheriekopplungsbaugruppe vereinfacht.

Diese Aufgabe wird ausgehend vom vorstehend dargestellten Stand der Technik nach der vorliegenden Erfindung durch eine intelligente Peripheriekopplungsbaugruppe nach Anspruch 1, 3 oder 4 sowie durch ein Computergestütztes Verfahren zur modularen Erstellung eines Leiterbahnen-Layouts (IP-L) für eine herzustellende intelligente Peripheriekopplungsbaugruppe (IP) nach Anspruch 15 gelöst.

Zweckmäßige Ausführungsformen der intelligenten Peripheriekopplungsbaugruppe ergeben sich dabei aus den Unteransprüchen 2 und 5 bis 15.

Auf diese erfindungsgemäße Weise werden nicht die, nach wie vor gänzlich individuell ausgestaltbaren Peripheriekopplungs-Unterbaugruppen selbst standardisiert, gleichwohl aber der Aufbau ihrer jeweiligen Einbettung in die intelligente Peripheriekopplungsbaugruppe hinsichtlich ihrer Ansteuerung von Seiten der Microcontroller-Unterbaugruppe und/oder der programmierbaren Logik und/oder der Netzwerkkopplungs-Unterbaugruppe her wie auch der Verbindung zum Konnektorbauelement, also zur Seite der Peripheriegeräte hin.

Dies geschieht, indem ein Raster mit Rasterplätzen vorgesehen ist, die die Peripheriekopplungs-Unterbaugruppen ganz oder teilweise einnehmen können und an denen jeweils einerseits eine oder mehrere Leitung(en), die einerseits der Zonen-Verbindung zur programmierbaren Logik und/oder zum Microcontroller und/oder zur Netzwerkkopplungs-Unterbaugruppe hin dienen und andererseits eine oder mehrere Leitungen, die die Verbindung mit einem oder mehreren Pin(s) des Konnektorbauelements herstellen, vorgesehen sind, wobei diese Leitungen in einer bestimmten Leiterplattenebene der erfindungsgemäßen intelligenten Peripheriekopplungsbaugruppe liegen.

Auf diese Weise kann der Leiterplattendesignaufwand für die erfindungsgemäße intelligente Peripheriekopplungsbaugruppe auch bei Verwendung höchst individueller Peripheriekopplungs-Unterbaugruppen ganz erheblich gesenkt werden, indem diese jeweiligen Unterbaugruppen - abgesehen einerseits von ihren jeweiligen Schnittstellenverbindungen zum Microcontroller und/oder zur programmierbaren Logik und/oder zur Netzwerkkopplungs-Unterbaugruppe und andererseits von ihren jeweiligen Verbindungen zum Konnektorbauelement (also letztlich zum Peripheriegerät) hin - isoliert von allen anderen Peripheriekopplungs-Unterbaugruppen nur für sich entworfen und - gegebenenfalls in verschiedenen Leiterplattenebenen geroutet (also die jeweiligen zugehörigen Bauteile oder Bauteilplätze durch Leiterplattenverbindungen miteinander verbunden) werden.

Lediglich die Schnittstellenverbindungen zu den drei Verbindungsbaugruppen, also Microcontroller und/oder programmierbare Logik und/oder die Netzwerkkopplungs-Unterbaugruppe einerseits und Konnektorbauelement (mit etwaigem Peripheriegerät damit verbunden) andererseits müssen in Abhängigkeit zu der erfindungsgemäßen intelligenten Peripheriekopplungsbaugruppe hergestellt werden, was etwa einfach dadurch geschieht, daß die betreffende Verbindung so hergestellt wird, daß eine Kontaktierung (gegebenenfalls eine Durchkontaktierung, auch VIAS genannt) von dem Kontakt - vorzugsweise einer genügend großen Kontaktfläche innerhalb des Leiterbahnenlayouts der Peripheriekopplungs-Unterbaugruppe - des entsprechenden Bauteileingangs oder -ausgangs der Peripheriekopplungs-Unterbaugruppe zu dem entsprechenden Kontakt - vorzugsweise einer genügend großen Kontaktfläche - in der hierfür bestimmten Leiterplattenebene an dem jeweiligen Rasterplatz, den die Peripheriekopplungs-Unterbaugruppe ganz oder teilweise einnimmt, erstellt wird.

Auf diese Weise kann das einmal erstellte Leiterplattendesign in seinen standardisierten (etwaig vorgesehenen) Teilen, also der Netzwerkkopplungs-Unterbaugruppe, der Microcontroller-Unterbaugruppe und der programmierbaren Logik, sowie hinsichtlich des Konnektorbauelements zum Anschluß an die Peripheriegeräte immer wieder unverändert genutzt werden.

Das gleiche gilt für bereits fertiggestellte Peripheriekopplungs-Unterbaugruppen, die nur noch platziert zu werden brauchen, was leicht anhand des vorgesehenen Rasters geschehen kann. Ein neues Routing der Leiterbahnen ist auch hier nicht erforderlich. Die jeweilige Unterbaugruppe muß nur an einen oder mehrere Rasterplätze so ausgerichtet werden, daß die entsprechenden Schnittstellen dort zur Verfügung stehen und eine entsprechende Verbindung zur jeweiligen Unterbaugruppe - etwa vermittels (Durch-)Kontaktierung - hergestellt werden kann, wobei die jeweilige Peripheriekopplungs-Unterbaugruppe(n) in der Peripheriekopplungs-Unterbaugruppen-Zone vorzugsweise einen solchen Rasterplatz oder mehrere solche Rasterplätze in dem Raster der Peripheriekopplungs-Unterbaugruppen-Zone ganz oder teilweise einnimmt oder einnehmen.

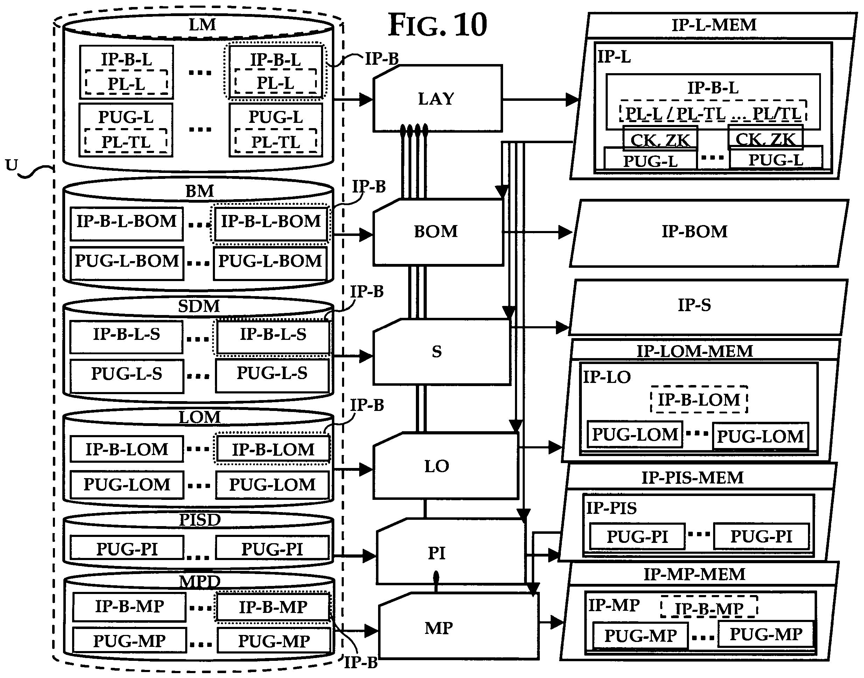

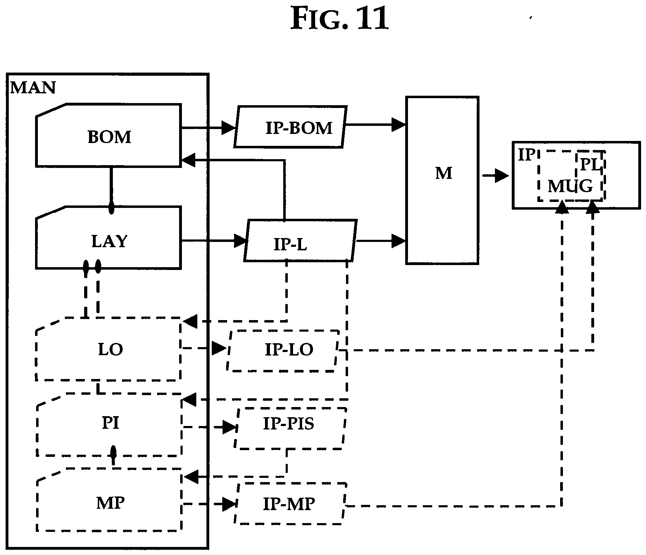

Demgemäß sind nach der vorliegenden Erfindung auch computergestützte Verfahren zur modularen Erstellung eines Leiterbahnen-Layouts, eines Bauteil-Bestückungsplans, eines Schaltplans, einer Logik-Programmierung für eine programmierbare Logik, einer (Daten-)Struktur des Prozeßabbilds, und einer Microcontroller-Programmierung für eine Microcontroller-Unterbaugruppe zum programmierten Betrieb jeweils der erfindungsgemäßen herzustellenden intelligenten Peripheriekopplungsbaugruppe vorgesehen und zwar vorzugsweise als jeweilige Teilschritte (Teilverfahren) zur erfindungsgemäßen Herstellung einer erfindungsgemäßen intelligenten Peripheriekopplungsbaugruppe, besonders bevorzugterweise im Zusammenwirken vorgenannter erfindungsgemäßer Verfahren. Nähere Details hierzu sind dabei insbesondere den Ausführungsformen nachstehender Fig. 10 und 11 der Zeichnung zur vorliegenden Erfindung und hierzu gehöriger nachstehender Beschreibung zu entnehmen.

Auch sieht die vorliegende Erfindung ein computergestütztes Verfahren zur Konfiguration eines datennetzwerkbasierten (vorzugsweise [echtzeitfähigen] feldbusbasierten) Systems zur Steuerung und/oder Regelung und/oder Überwachung von zumindest einem Peripheriegerät- vorzugsweise einer Maschine (besonders bevorzugterweise einer Landmaschine oder Baumaschine) oder einer Maschinenkomponente - durch ein - vorzugsweise zentrales - Steuergerät mittels Datenübertragung zwischen Teilnehmern eines Datennetzwerks (vorzugsweise eines [echtzeitfähigen] Feldbusses, etwa eines Industrial Ethernet, vorzugsweise EtherCAT [geschützte Marke] oder Ethernet-POWERLINK [geschützte Marke] oder auch Profibus [geschützte Marke]) vor, bei dem zumindest eine erfindungsgemäße intelligente Peripheriekopplungsbaugruppe als Teilnehmer mit dem Datennetzwerk verbunden ist und der Steuerung und/oder Regelung und/oder Überwachung des zumindest einen Peripheriegerätes dient.

Vorzugsweise weist die Netzwerkkopplungs-Unterbaugruppe der erfindungsgemäßen intelligenten Peripheriekopplungsbaugruppe eine anwendungsspezifische integrierte Schaltung (ASIC) mit digitalen Ein- und/oder Ausgängen auf, die in Abhängigkeit der über das Datennetzwerk zum (zentralen) Steuergerät hin empfangenen und/oder gesendeten Daten gesetzt oder eingelesen werden können, was in Fällen der Ankopplung einfacherer Peripheriegeräte (über eine jeweilige Peripherieankopplungs-Unterbaugruppe) auch den Verzicht auf einen Microcontroller und/oder eine programmierbare Logik ermöglicht (siehe oben). Insbesondere in diesen Fällen kann die Zonen-Verbindung auch unmittelbar zwischen der Netzwerkkopplungs-Unterbaugruppe und der oder den Peripheriekopplungs-Unterbaugruppe(en) in der Peripheriekopplungs-Unterbaugruppen-Zone bestehen.

Eine bevorzugte Ausführungsform der intelligenten Peripheriekopplungsbaugruppe nach der vorliegenden Erfindung zeichnet sich dadurch aus, daß zumindest ein Rasterplatz in dem Raster der Peripheriekopplungs-Unterbaugruppen-Zone vorgesehen ist, den eine Peripheriekopplungs-Unterbaugruppe ganz oder teilweise einnehmen kann, dem in zumindest einer hierfür vorbestimmten Leiterbahnschicht der Platine alle Leitungen der Zonen-Verbindung zugeordnet sind, mit der die jeweilige Peripheriekopplungs-Unterbaugruppe über eine oder mehrere Kontaktierung(en) elektrisch verbunden werden kann. Eine derartige - vorzugsweise datenbusartige - Zonen-Verbindung ermöglicht jeder an einem bestimmten Rasterplatz ganz oder teilweise befindlichen Peripheriekopplungs-Unterbaugruppe den Zugriff auf alle (Daten-)Leitungen hin zu den - vorzugsweise intelligenten - jeweiligen Unterbaugruppen der erfindungsgemäßen Peripheriekopplungsbaugruppe in der ersten Zone, der zweiten Zone und/oder der dritten Zone und erleichtert so insbesondere die Platzierung der Peripheriekopplungs-Unterbaugruppe, da keine Rücksicht darauf genommen werden muß, welche (Daten-)Leitungen der Zonen-Verbindung an welchem Rasterplatz zur Verfügung stehen.

Eine weitere bevorzugte Ausführungsform der intelligenten Peripheriekopplungsbaugruppe nach der vorliegenden Erfindung ist ferner dadurch gekennzeichnet, daß zumindest ein Rasterplatz in dem Raster der Peripheriekopplungs-Unterbaugruppen-Zone vorgesehen ist, den eine Peripheriekopplungs-Unterbaugruppe ganz oder teilweise einnehmen kann, dem in zumindest einer hierfür vorbestimmten Leiterbahnschicht der Platine alle Leitungen der Konnektorbaulement-Verbindung zugeordnet sind, mit der die jeweilige Peripheriekopplungs-Unterbaugruppe über eine oder mehrere Kontaktierung(en) elektrisch verbunden werden kann, wodurch auch in dieser Hinsicht der Platzierungsaufwand reduziert wird, da dann auch alle Leitungen zu den jeweiligen Peripheriegeräten hin an jedem Rasterplatz zur Verfügung stehen.

Eine weitere besonders bevorzugte Ausführungsform der erfindungsgemäßen intelligenten Peripheriekopplungsbaugruppe nach der vorliegenden Erfindung sieht zumindest einen Rasterplatz in dem Raster der Peripheriekopplungs-Unterbaugruppen-Zone vor, den eine Peripheriekopplungs-Unterbaugruppe ganz oder teilweise einnehmen kann, dem in zumindest einer hierfür vorbestimmten Leiterbahnschicht der Platine genau eine einzige Leitung der Konnektorbaulement-Verbindung zugeordnet ist, mit der die jeweilige Peripheriekopplungs-Unterbaugruppe über eine einzige Kontaktierung elektrisch verbunden werden kann. Eine solche Ausführungsform, die selbstverständlich insbesondere auch mit den vorstehend beschriebenen Ausführungsformen der vorliegenden Erfindung kombiniert werden kann (etwa indem für verschiedene Rasterplätze verschiedene Anzahl von Verbindungen vorgesehen werden), ist vorzugsweise dann vorteilhaft einzusetzen, wenn etwa größere elektrische Leistungen über eine Leitung der Konnektor-Verbindung hin zum jeweiligen Peripheriegerät geschaltet werden sollen. Sie ermöglicht es nämlich eine entsprechend breite Leiterbahn vorzusehen, da auf die anderen Leiterbahnen für die anderen Leitungen der Konnektor-Verbindung ganz verzichtet werden kann, wodurch ein entsprechend großer (breiter) Platz zur Leitungsführung für die verbliebene Leitung bleibt.

Vorzugsweise ist das Raster der Peripheriekopplungs-Unterbaugruppen-Zone so aufgebaut, daß die Rasterplätze schachbrettartig angeordnet sind.

Die Leitung(en) der Zonen-Verbindung, die die programmierbare Logik und/oder die Microcontroller-Unterbaugruppe und/oder die Netzwerkkopplungs-Unterbaugruppe mit der oder den Peripheriekopplungs-Unterbaugruppe(n) in der Peripheriekopplungs-Unterbaugruppen-Zone verbindet oder verbinden, ist oder sind in maximal zwei Leiterbahnenschichten der Platine angeordnet. Eine solche Anordnung ist immer möglich, da die Leiterbahnen, die die programmierbare Logik und/oder die Microcontroller-Unterbaugruppe und/oder die Netzwerkkopplungs-Unterbaugruppe mit der oder den Peripheriekopplungs-Unterbaugruppe(n) in der Peripheriekopplungs-Unterbaugruppen-Zone verbindet oder verbinden, immer in einer Ebene von einer Seite her an den jeweiligen Rasterplatz (vorzugsweise datenbusartig) herangeführt werden können. Hat man nur eine Reihe von Rasterplätzen, so kann dies völlig kreuzungsfrei in nur einer einzigen Leiterplattenebene geschehen. Verwendet man mehrere Rasterplatzreihen, so bedarf es gegebenenfalls einer zweiten Leiterplattenebene, in der die Querverbindungen zwischen den (vorzugsweise datenbusartig verlaufenden) Leitungen zu den verschiedenen Rasterplatzreihen hergestellt werden.

Wie die Zonen-Verbindung, die die programmierbare Logik und/oder die Microcontroller-Unterbaugruppe und/oder die Netzwerkkopplungs-Unterbaugruppe mit der oder den Peripheriekopplungs-Unterbaugruppe(n) in der Peripheriekopplungs-Unterbaugruppen-Zone verbindet oder verbinden, kann oder können auch die Leitung(en) der Konnektorbaulement-Verbindung, die die Peripheriekopplungs-Unterbaugruppe(n) in der Peripheriekopplungs-Unterbaugruppen-Zone mit einem oder mehreren Pin(s) des Konnektorbauelements verbindet oder verbinden in maximal zwei Leiterbahnenschichten der Platine angeordnet sein, da hier die gleichen Überlegungen, wie vorstehend für die Zonen-Verbindung dargelegt, gelten.

Besonders bevorzugterweise sind sowohl die Leitung(en) der Zonen-Verbindung als auch die Leitung(en) der Konnektorbaulement-Verbindung in derselben oder denselben beiden Leiterbahnenschichten der Platine angeordnet, was topologisch möglich ist, wenn man etwa die ersteren auf einer Seite zuführt, die zweiten auf der anderen Seite in derselben Leiterplattenebene abführt, wobei die Querverbindungen beider in einer zweiten Ebene, vorzugsweise außerhalb des Rasters, parallel zueinander geführt werden. Diese Anordnung ist besonders effizient und daher günstig, da sie zwar außerhalb des Rasters zwei Leiterplattenebenen benötigt, innerhalb des Rasters aber, also im Bereich der Rasterplätze, die durch Peripheriekopplungs-Unterbaugruppen ganz oder teilweise eingenommen werden können, nur eine einzige Leiterplattenebene, nämlich zur Verbindung mit den jeweiligen Peripheriekopplungs-Unterbaugruppen benötigt. Alle anderen Leiterplattenebenen hingegen stehen den jeweiligen Peripheriekopplungs-Unterbaugruppen für ihre eigene interne ,Verdrahtung' zur Verfügung.

Besonders bevorzugterweise ist die intelligente Peripheriekopplungsbaugruppe nach der vorliegenden Erfindung dadurch gekennzeichnet, daß auf der Platine verschiedene für die Unterbaugruppen vorgesehene Zonen angeordnet sind, wobei
die Netzwerkkopplungs-Unterbaugruppe in einer ersten Zone der Platine,
die Microcontroller-Unterbaugruppe in einer zweiten Zone der Platine, und
die programmierbare Logik in einer dritten Zone der Platine
vorgesehen ist.

In einer weiteren bevorzugten Ausführungsform der intelligenten Peripheriekopplungsbaugruppe nach der vorliegenden Erfindung grenzt die dritte Zone an die Peripheriekopplungs-Unterbaugruppen-Zone an, wobei vorzugsweise zudem die erste Zone an die zweite Zone und die zweite Zone an die dritte Zone angrenzt. Besonders bevorzugterweise liegt dabei die erste Zone am entgegengesetzten Ende der Platine wie die Peripheriekopplungs-Unterbaugruppen-Zone, und zwischen diesen beiden liegt die zweite Zone und die dritte Zone. Durch letztere erfindungsgemäße Variante ergibt sich ein besonders günstiger länglicher Aufbau der erfindungsgemäßen intelligenten Peripheriekopplungsbaugruppe, der es etwa erlaubt, bei gleichbleibender Breite der Baugruppe den Bereich der Peripheriekopplungs-Unterbaugruppen-Zone je nach Platzbedarf der dort verwendeten Peripheriekopplungs-Unterbaugruppen einfach zu verlängern, was die Verwendung standardisierter, gleich breit bleibender Gehäuse ermöglicht, wie sie sich etwa durch Einsatz von Strangpreßprofilen gleicher Breite, aber in variabler Länge leicht und wirtschaftlich herstellen lassen.

Das Konnektorbauelement zur Verbindung mit der Peripherie, also dem oder den Peripheriegeräten wird vorzugsweise selbst in der Peripheriekopplungs-Unterbaugruppen-Zone oder jedenfalls unmittelbar angrenzend an diese angeordnet. Es kann als zumindest ein in die Platine eingebrachtes - etwa eingepreßtes oder eingelötetes - Bauelement ausgestaltet sein, also etwa als eine Steckerleiste oder Buchsenleiste zur Steckverbindung mit dem oder den zu steuernden und/oder zu regelnden und/oder zu überwachenden Peripheriegerät(en). Es kann sich aber auch um ein Sende-Empfangsteil handeln, das zur drahtlosen Verbindung mit dem oder den zu steuernden und/oder zu regelnden und/oder zu überwachenden Peripheriegerät(en) dient, etwa in Gestalt eines Sende-/Empfangsteils für eine drahtlose sogenannte Bluetooth- (eingetragene Marke) oder WLAN-Verbindung zu einem Peripheriegerät.

In einer weiteren bevorzugten Ausführungsform der intelligenten Peripheriekopplungsbaugruppe nach der vorliegenden Erfindung münden die Leitung(en) der Zonen-Verbindung, die die programmierbare Logik in der dritten Zone der Platine und/oder die Microcontroller-Unterbaugruppe in der zweiten Zone und/oder die Netzwerkkopplungs-Unterbaugruppe in der ersten Zone mit der oder den Peripheriekopplungs-Unterbaugruppe(n) in der Peripheriekopplungs-Unterbaugruppen-Zone verbindet oder verbinden auf der Seite der Peripheriekopplungs-Unterbaugruppen-Zone in diese ein, die an die dritte Zone grenzt.

Auch verlassen die Leitung(en) der Konnektorbaulement-Verbindung, die die Peripheriekopplungs-Unterbaugruppe(n) in der Peripheriekopplungs-Unterbaugruppen-Zone mit einem oder mehreren Pin(s) des Konnektorbauelements verbindet oder verbinden besonders bevorzugterweise die Peripheriekopplungs-Unterbaugruppen-Zone in Richtung der Seite, die derjenigen gegenüberliegt, die an die dritte Zone grenzt.

Die Kombination der beiden zuletzt zuvor genannten Leitungsführungen ermöglicht - wie bereits schon oben erwähnt - eine besonders effiziente und günstige Topologie der Leitungsführung, da auf diese Weise maximal zwei Leiterbahnebenen im Bereich der Peripheriekopplungs-Unterbaugruppen-Zone benötigt werden und zudem im Bereich des Rasters selbst nur eine solche Ebene vonnöten ist, was die übrigen Ebenen für die Leitungsführung der internen Verdrahtung der dortigen Peripheriekopplungs-Unterbaugruppen beläßt.

Auch kann es bei einer intelligenten Peripheriekopplungsbaugruppe nach der vorliegenden Erfindung so sein, daß in der Peripheriekopplungs-Unterbaugruppen-Zone der Platine zumindest eine Teilzone vorgesehen ist, die ein Baugruppenverbindungssystem, vorzugsweise einen Baugruppensockel aufweist, wobei das Baugruppenverbindungssystem mit der/den Leitung(en) der Zonen-Verbindung und/oder der/den Leitung(en) der Konnektor-Verbindung elektrisch verbunden ist. Eine solche Ausführungsform ermöglicht es, einzelne Peripheriekopplungs-Unterbaugruppen bereits vorzusehen, diese aber erst später aufzustecken. Ist etwa eine erfindungsgemäße Peripheriekopplungsbaugruppe grundsätzlich zur Ansteuerung von vier Motoren vorgesehen, kauft der Kunde der Baugruppe aber zunächst nur eine Peripherieeinheit mit zwei Motoren, so kann ihm - wenn etwa die jeweiligen Peripheriekopplungs-Unterbaugruppen zur Motoransteuerung aufwendig und damit auch teuer sind - zunächst eine Baugruppe mit nur zwei Peripheriekopplungs-Unterbaugruppen zur Motoransteuerung angeboten werden. Stockt er dann das Peripheriegerät auf ein solches mit vier Motoren auf, so brauchen auf der erfindungsgemäßen Baugruppe nur zwei Peripheriekopplungs-Unterbaugruppen zur Ansteuerung der Motoren in die entsprechenden Baugruppensockel eingesteckt zu werden.

Besonders bevorzugterweise eignet sich ein solches Baugruppenverbindungssystem für eine Testversion der erfindungsgemäßen intelligenten Peripheriekopplungsbaugruppe, bei dem mit diversen Peripheriekopplungs-Unterbaugruppen an verschiedenen Rasterplätzen experimentiert wird. Die Peripheriekopplungs-Unterbaugruppen kommunizieren dabei vorzugsweise über die Zonen-Verbindung eine Identifikation, um so ihre jeweilige Position im Raster anzuzeigen, was im Falle eines fest gewählten Leiterplattenlayouts nicht erforderlich ist, da dort ja die Position der Unterbaugruppe im Layout diese auch zugleich identifiziert und so ihre Integration in die erfindungsgemäße intelligente Baugruppe ermöglicht.

Im folgenden werden nicht einschränkend zu verstehende Ausführungsbeispiele anhand der Zeichnung besprochen. In dieser zeigen:

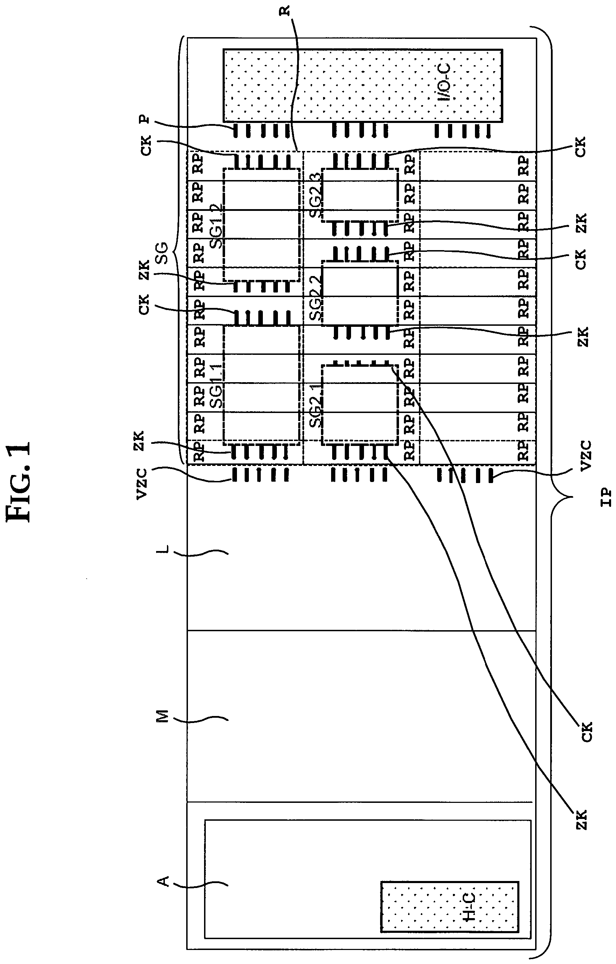

- Fig. 1: eine schematische Darstellung einer Ausführungsform der intelligenten Peripheriekopplungsbaugruppe nach der vorliegenden Erfindung im Überblick mit vier (noch mit Baugruppen unbestückten) Zonen und fünf Teilzonen für Peripheriekopplungs-Unterbaugruppen sowie einem Konnektorbauelement zur Ankopplung an Peripheriegeräte und einem Konnektor zur Ankopplung an ein zentrales Steuergerät über ein Datennetzwerk;

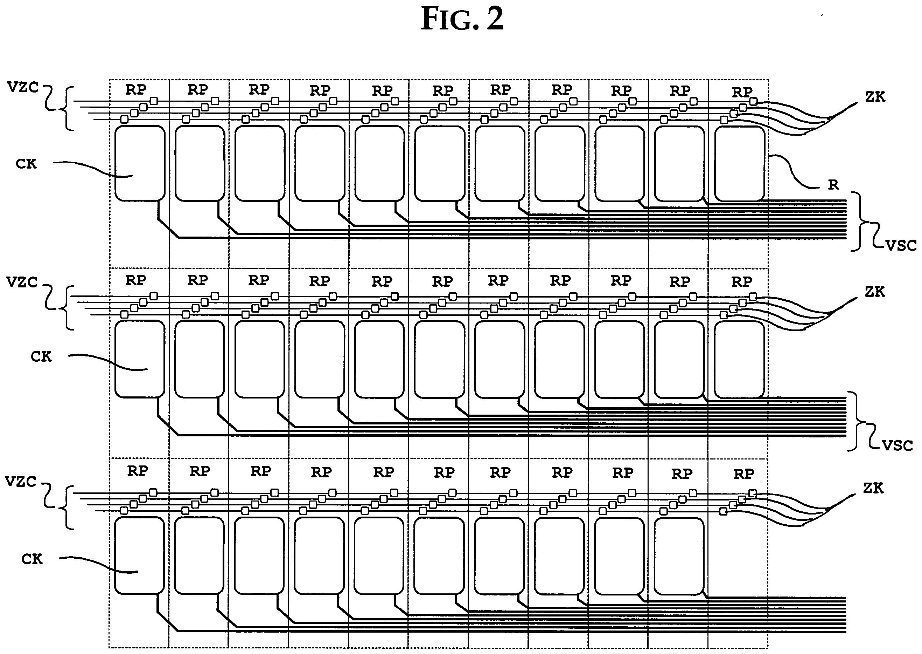

- Fig. 2: eine schematische Darstellung der Peripheriekopplungs-Unterbaugruppen-Zone einer bevorzugten Ausführungsform der intelligenten Peripheriekopplungsbaugruppe nach der vorliegenden Erfindung in schematischer Darstellung im Detail in einer Platinenebene, in der sowohl Leitung(en) der Zonen-Verbindung als auch Leitungen der Konnektorbauelement-Verbindung verlaufen;

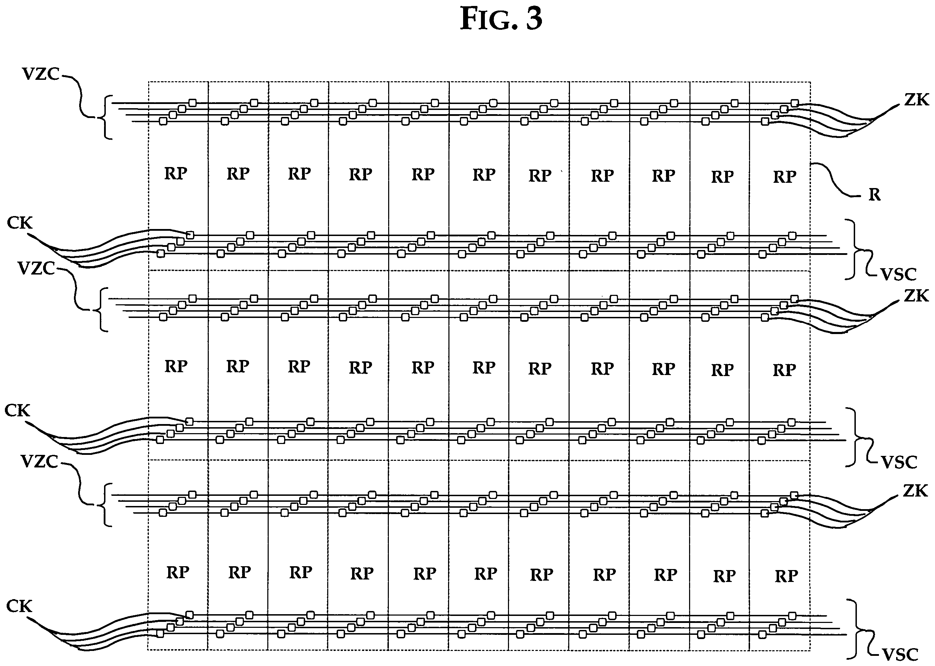

- Fig. 3: eine schematische Darstellung der Peripheriekopplungs-Unterbaugruppen-Zone einer weiteren besonders bevorzugten Ausführungsform der intelligenten Peripheriekopplungsbaugruppe nach der vorliegenden Erfindung in schematischer Darstellung im Detail in einer Platinenebene, in der sowohl Leitung(en) der Zonen-Verbindung als auch Leitungen der Konnektorbauelement-Verbindung verlaufen;

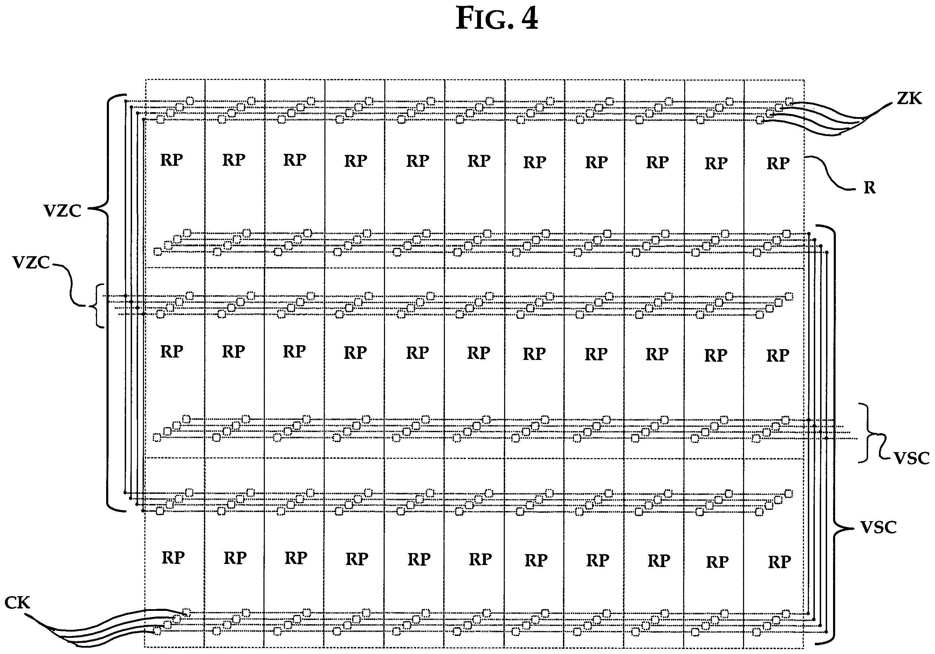

- Fig. 4: eine schematische Darstellung der Peripheriekopplungs-Unterbaugruppen-Zone der Ausführungsform der intelligenten Peripheriekopplungsbaugruppe nach Fig. 3 in mehreren - hier vier - gleichzeitig schematisch dargestellten Platinenebenen, in der jeweils sowohl Leitung(en) der Zonen-Verbindung als auch Leitungen der Konnektorbauelement-Verbindung verlaufen;

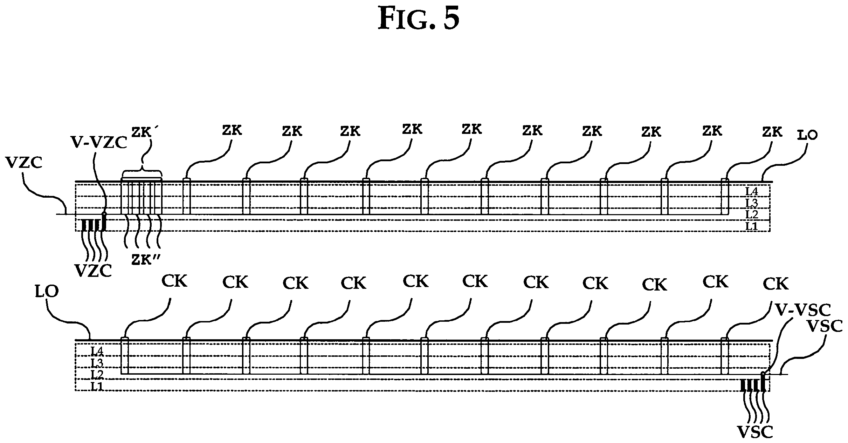

- Fig. 5: eine schematische Darstellung der Peripheriekopplungs-Unterbaugruppen-Zone der Ausführungsform der intelligenten Peripheriekopplungsbaugruppe nach Fig. 4 in vier gleichzeitig schematisch dargestellten Platinenebenen in zwei Schnitten durch die Platine (einer im oberen, einer im unteren Teil der Darstellung), in der jeweils sowohl Leitung(en) der Zonen-Verbindung als auch Leitungen der Konnektorbauelement-Verbindung in zwei Leiterbahnenschichten verlaufen;

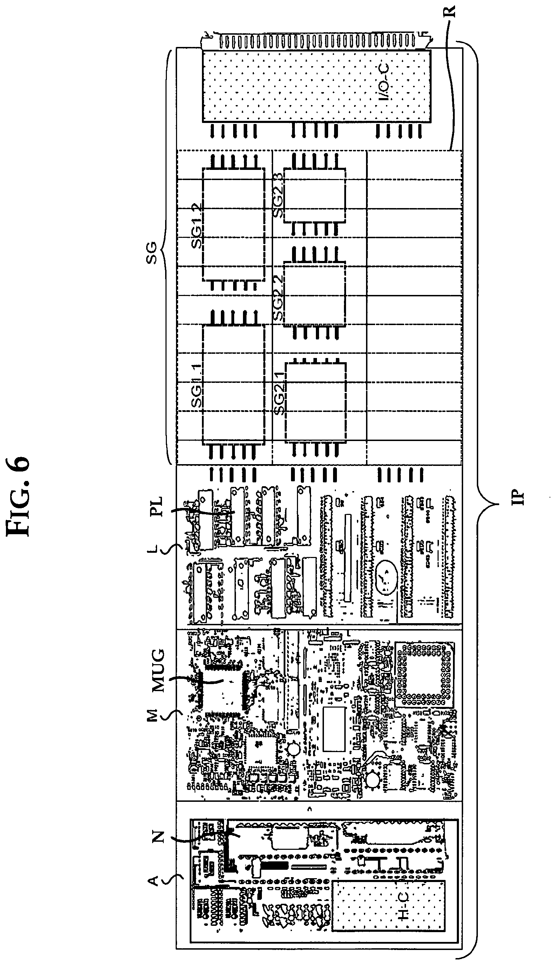

- Fig. 6: eine schematische Darstellung der intelligenten Peripheriekopplungsbaugruppe nach der vorliegenden Erfindung entsprechend Fig. 1 mit drei, bereits mit Baugruppen bestückten Zonen und einer Peripheriekopplungs-Unterbaugruppen-Zone (hier als vierte Zone) mit fünf (noch mit Unterbaugruppen unbestückten) Teilzonen für Peripheriekopplungs-Unterbaugruppen sowie einem Konnektorbauelement zur Ankopplung an Peripheriegeräte und einem Konnektor zur Ankopplung an ein zentrales Steuergerät über ein Datennetzwerk;

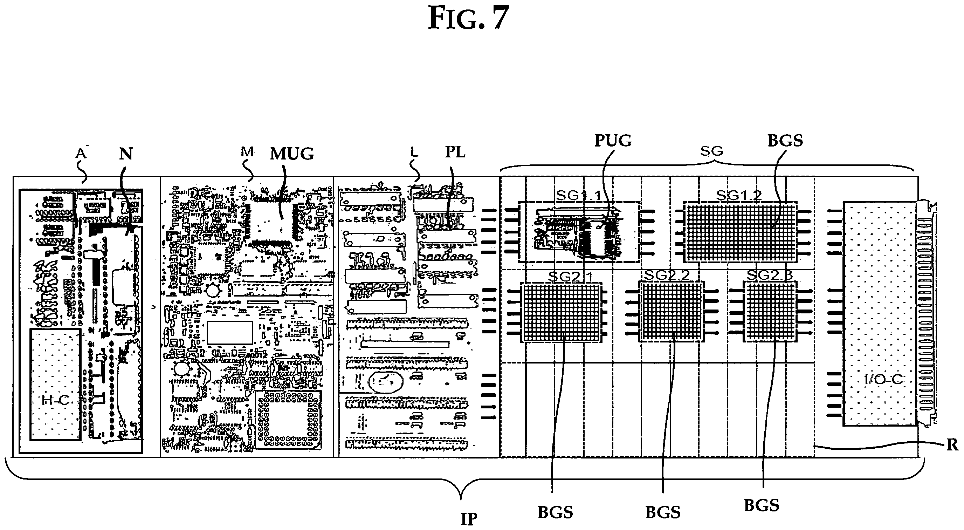

- Fig. 7: eine schematische Darstellung der intelligenten Peripheriekopplungsbaugruppe nach der vorliegenden Erfindung entsprechend Fig. 1 und 2 mit drei bereits mit Baugruppen bestückten Zonen und einer Peripheriekopplungs-Unterbaugruppen-Zone (hier als vierte Zone) mit einer bereits mit einer Peripheriekopplungs-Unterbaugruppe bestückten Teilzone und vier, noch mit Unterbaugruppen unbestückten, Teilzonen für Peripheriekopplungs-Unterbaugruppen sowie einem Konnektorbauelement zur Ankopplung an Peripheriegeräte und einem Konnektor zur Ankopplung an ein zentrales Steuergerät über ein Datennetzwerk;

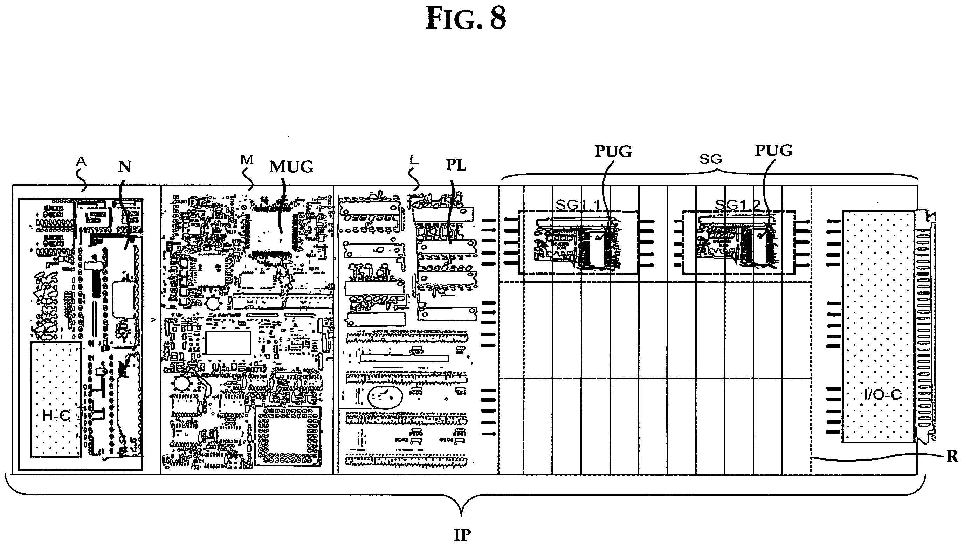

- Fig. 8: eine schematische Darstellung einer weiteren Ausführungsform der intelligenten Peripheriekopplungsbaugruppe nach der vorliegenden Erfindung mit vier bereits mit Baugruppen bestückten Zonen, wobei die Peripheriekopplungs-Unterbaugruppen-Zone (hier als vierte Zone) zwei bereits mit Peripheriekopplungs-Unterbaugruppen bestückte Teilzonen aufweist, sowie einem Konnektorbauelement zur Ankopplung an Peripheriegeräte und einem Konnektor zur Ankopplung an ein zentrales Steuergerät über ein Datennetzwerk,

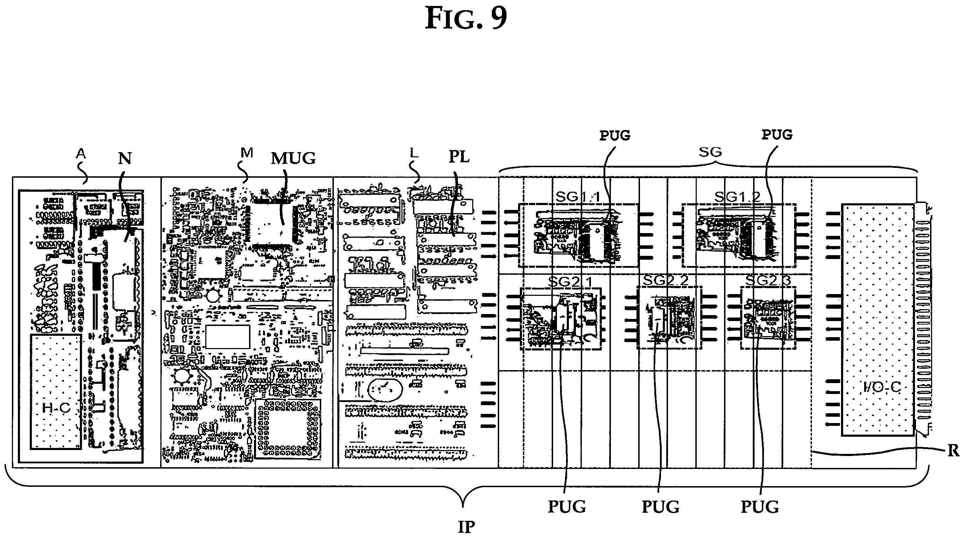

- Fig. 9: eine schematische Darstellung einer weiteren bevorzugten Ausführungsform der intelligenten Peripheriekopplungsbaugruppe nach der vorliegenden Erfindung ebenfalls mit vier bereits mit Baugruppen bestückten Zonen, wobei die Peripheriekopplungs-Unterbaugruppen-Zone (hier als vierte Zone) hier fünf mit Peripheriekopplungs-Unterbaugruppen bestückte Teilzonen aufweist, sowie einem Konnektorbauelement zur Ankopplung an Peripheriegeräte und einem Konnektor zur Ankopplung an ein zentrales Steuergerät über ein Datennetzwerk,
- Fig. **10**: ein schematisches Diagramm betreffend die Funktionsweise jeweilig bevorzugter Ausführungsformen der erfindungsgemäßen computergestützten Verfahren
- zur modularen Erstellung eines Leiterbahnen-Layouts einer herzustellenden erfindungsgemäßen intelligenten Peripheriekopplungsbaugruppe,
- zur Erstellung eines Bauteil-Bestückungsplans einer herzustellenden erfindungsgemäßen intelligenten Peripheriekopplungsbaugruppe,
- zur Erstellung eines Schaltplans einer herzustellenden erfindungsgemäßen intelligenten Peripheriekopplungsbaugruppe,
- zur Erstellung einer Logik-Programmierung für eine programmierbare Logik einer herzustellenden erfindungsgemäßen intelligenten Peripheriekopplungsbaugruppe,
- zur Erstellung einer (Daten-)Struktur des Prozeßabbilds der herzustellenden erfindungsgemäßen intelligenten Peripheriekopplungsbaugruppe - vorliegend Intelligente-Peripheriekopplungsbaugruppe-Prozeßabbild-Struktur genannt -, und
- zur Erstellung einer Microcontroller-Programmierung für eine Microcontroller-Unterbaugruppe zum programmierten Betrieb einer herzustellenden erfindungsgemäßen intelligenten Peripheriekopplungsbaugruppe
vorzugsweise als jeweilige Teilschritte (Teilverfahren) zur erfindungsgemäßen Herstellung einer erfindungsgemäßen intelligenten Peripheriekopplungsbaugruppe sowie das vorzugsweise Zusammenwirken vorgenannter erfindungsgemäßer Verfahren,
- Fig. **11**: ein schematisches Diagramm betreffend die Funktionsweise jeweilig bevorzugter Ausführungsformen des computergestützten Verfahrens nach der vorliegenden Erfindung zur Herstellung einer erfindungsgemäßen intelligenten Peripheriekopplungsbaugruppe; und

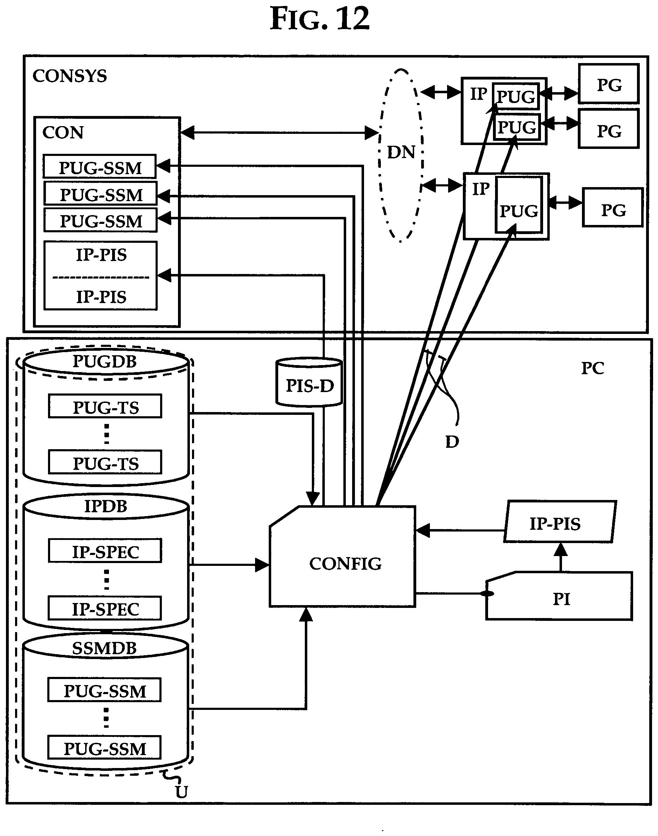

- Fig. **12**: ein schematisches Diagramm betreffend die Funktionsweise einer bevorzugten Ausführungsform des computergestützten Verfahrens nach der vorliegenden Erfindung zur Konfiguration eines datennetzwerkbasierten Systems zur Steuerung und/oder Regelung und/oder Überwachung von zumindest einem Peripheriegerät durch ein - vorzugsweise zentrales -Steuergerät mittels Datenübertragung zwischen Teilnehmern eines Datennetzwerks, bei dem zumindest eine erfindungsgemäße intelligente Peripheriekopplungsbaugruppe als Teilnehmer mit dem Datennetzwerk verbunden ist und der Steuerung und/oder Regelung und/oder Überwachung des zumindest einen Peripheriegerätes dient.

Fig. **1** zeigt eine schematische Darstellung einer Ausführungsform der erfindungsgemäßen intelligenten Peripheriekopplungsbaugruppe **IP** auf einer Platine mit mehreren Leiterbahnebenen nach der vorliegenden Erfindung im Überblick mit vier (noch mit Baugruppen unbestückten) Zonen, nämlich
eine erste Zone **A** der Platine für eine Netzwerkkopplungs-Unterbaugruppe zur Kopplung der Peripheriekopplungsbaugruppe **IP** an zumindest ein zentrales Steuergerät über ein Datennetzwerk, wozu das hier schematisch dargestellte Netzwerkkonnektorbauelement **H-C** dient,
eine an die erste Zone **A** unmittelbar angrenzende zweite Zone **M** der Platine für eine Microcontroller-Unterbaugruppe zum programmierten Betrieb der Peripheriekopplungsbaugruppe **IP**, und
eine wiederum an die zweite Zone **M** unmittelbar angrenzende dritte Zone **L** der Platine für eine programmierbare Logik zur Anschaltung an fünf Peripheriekopplungs-Unterbaugruppen, die der Kopplung mit fünf verschiedenen zu steuernden und/oder zu regelnden und/oder zu überwachenden Peripheriegeräten dienen, wobei die Peripheriekopplungs-Unterbaugruppen hier noch nicht bestückt aber für die Teilzonen **SG1.1, SG1.2, SG2.1, SG2.2** und **SG2.3** in der Peripheriekopplungs-Unterbaugruppen-Zone **SG** (hier als vierte Zone) vorgesehen sind.

Auch ist ein Konnektorbauelement **I/O-C**, vorzugsweise eine in die Platine - etwa durch Einpressen oder Einlöten - eingebrachte Steckerbauleiste mit einer bestimmten Anzahl von Kontakten zur elektrischen Verbindung der fünf hier vorgesehenen Peripheriekopplungs-Unterbaugruppen mit den Peripheriegeräten zu sehen.

Ferner ist eine Zonen-Verbindung **VZC** zur elektrischen Verbindung der in der dritten Zone **L** vorgesehenen programmierbaren Logik über mehrere Leitungen mit den in den Teilzonen **SG1.1, SG1.2, SG2.1, SG2.2** und **SG2.3** noch zu bestückenden Peripheriekopplungs-Unterbaugruppen in der Peripheriekopplungs-Unterbaugruppen-Zone **SG** vorgesehen. Auch weisen die für die Peripheriekopplungs-Unterbaugruppen in der Peripheriekopplungs-Unterbaugruppen-Zone **SG** vorgesehenen Teilzonen **SG1.1, SG1.2, SG2.1, SG2.2** und **SG2.3** jeweils eine Konnektorbaulement-Verbindung **VSC** zur elektrischen Verbindung der noch zu bestückenden Peripheriekopplungs-Unterbaugruppen über mehrere Leitungen mit Pins **P** des Konnektorbauelements **I/O-C** auf, die dann jeweils den elektrischen Kontakt zu den Kontakten zum Anschluß an das jeweilige Peripheriegerät herstellen.

Die - noch zu bestückenden - Peripheriekopplungs-Unterbaugruppen in der Peripheriekopplungs-Unterbaugruppen-Zone **SG** sind an einem Raster **R** mit mehreren - hier 33 Rasterplätzen **RP -** ausgerichtet, wobei hier jedem Rasterplatz **RP** in dem Raster **R** der Peripheriekopplungs-Unterbaugruppen-Zone **SG,** den eine Peripheriekopplungs-Unterbaugruppe ganz oder teilweise einnehmen wird, in zumindest einer hierfür vorbestimmten Leiterbahnschicht der Platine mehrere Leitungen der Zonen-Verbindung **VZC** zugeordnet sind, mit der die jeweilige Peripheriekopplungs-Unterbaugruppe über mehrere Kontaktierungen **ZK** elektrisch etwa mit der programmierbaren Logik in der dritten Zone **L** verbunden wird.

Auch sind hier jedem Rasterplatz **RP** in dem Raster **R** der Peripheriekopplungs-Unterbaugruppen-Zone **SG**, den eine Peripheriekopplungs-Unterbaugruppe ganz oder teilweise einnimmt, in zumindest einer hierfür vorbestimmten Leiterbahnschicht der Platine mehrere Leitungen der Konnektorbaulement-Verbindung **VSC** zugeordnet, mit der die jeweilige Peripheriekopplungs-Unterbaugruppe über mehrere Kontaktierungen **CK** mit den jeweiligen Pins **P** des Konnektorbauelements **I/O-C** elektrisch verbunden wird.

Fig. **2** zeigt eine schematische Darstellung der Peripheriekopplungs-Unterbaugruppen-Zone **SG** einer bevorzugten Ausführungsform der intelligenten Peripheriekopplungsbaugruppe **IP** nach der vorliegenden Erfindung in schematischer Darstellung im Detail in einer Leiterplattenebene, in der sowohl Leitungen der Zonen-Verbindung **VZC** als auch Leitungen der Konnektorbauelement-Verbindung **VSC** verlaufen.

Die Peripheriekopplungs-Unterbaugruppen - hier nicht zu sehen - sind an einem Raster **R** - mit hier 33 Rasterplätzen **RP** - ausgerichtet, wobei den Rasterplätzen **RP** in dem Raster **R** der Peripheriekopplungs-Unterbaugruppen-Zone **SG**, die eine Peripheriekopplungs-Unterbaugruppe ganz oder teilweise einnehmen kann, in der hier zu sehenden hierfür bestimmten Leiterbahnschicht der Platine mehrere Leitungen - hier vier Leitungen - der Zonen-Verbindung **VZC** zugeordnet sind, mit der die jeweilige Peripheriekopplungs-Unterbaugruppe über mehrere - hier vier - Kontaktierungen **ZK** elektrisch mit etwa der programmierbaren Logik - vorzugsweise in der dritten Zone **L** - verbunden werden kann und vorzugsweise auch ist.

Auch sind den ersten 32 Rasterplätzen **RP** in dem Raster **R** der Peripheriekopplungs-Unterbaugruppen-Zone **SG**, die eine Peripheriekopplungs-Unterbaugruppe (vorzugsweise auf der Platinenoberseite oder -unterseite) ganz oder teilweise einnehmen kann, in der hier zu sehenden hierfür bestimmten Leiterbahnschicht der Platine genau eine einzige Leitung der Konnektorbaulement-Verbindung **VSC** zugeordnet, mit der die jeweilige Peripheriekopplungs-Unterbaugruppe über diese jeweils eine einzige Kontaktierung **CK** mit einem jeweiligen Pin **P** des Konnektorbauelements **I/O-C** elektrisch verbunden werden kann und vorzugsweise auch ist. Hat das Konnektorbauelement **I/O-C** also etwa 32 Pins und damit auch 32 Kontakte nach au-ßen zu etwaigen Peripheriegeräten hin, so ist dem ersten Rasterplatz **RP** etwa der Pin 1 des Konnektorbauelements **I/O-C** zur Kopplung mit den Peripheriegerät(en) zugeordnet, dem zweiten Rasterplatz **RP** dann Pin 2 und so fort bis hin zu Rasterplatz **RP** 32 , der dem 32.-ten Pin des Konnektorbauelements **I/O-C** zur Verbindung mit dem/den Peripheriegerät(en) zugeordnet ist. Die jeweilige Peripheriekopplungs-Unterbaugruppe muß also so in der Peripheriekopplungs-Unterbaugruppen-Zone **SG** platziert werden, daß sie all die Rasterplätze **RP** ganz oder zumindest teilweise einnimmt, die in der hier zu sehenden Leiterplattenebene eine Verbindung zu den vorgesehenen Pins **P** des Konnektorbauelements **I/O-C** zur Peripheriegeräteverbindung aufweisen.

Eine solche Anordnung ist insbesondere dann vorteilhaft, wenn die Leitungen, die in der Peripheriekopplungs-Unterbaugruppe **PUG** in Richtung des jeweiligen Peripheriegeräts **PG** abgehen, höhere elektrische Ströme führen, also etwa im Falle der Anschaltung einer Leistungselektronik oder Leistungselektrik, wie vorzugsweise einer Motoransteuerung oder Motorregelung.

Fig. **3** zeigt eine schematische Darstellung der Peripheriekopplungs-Unterbaugruppen-Zone **SG** einer weiteren besonders bevorzugten Ausführungsform der intelligenten Peripheriekopplungsbaugruppe **IP** nach der vorliegenden Erfindung in schematischer Darstellung im Detail in einer Platinenebene, in der sowohl Leitung(en) der Zonen-Verbindung **VZC** als auch Leitungen der Konnektorbauelement-Verbindung **VSC** verlaufen.

Die Peripheriekopplungs-Unterbaugruppen - hier wiederum nicht zu sehen - sind an einem Raster **R** - mit hier ebenfalls 33 Rasterplätzen **RP** - ausgerichtet, wobei den Rasterplätzen **RP** in dem Raster **R** der Peripheriekopplungs-Unterbaugruppen-Zone **SG,** die eine Peripheriekopplungs-Unterbaugruppe ganz oder teilweise einnehmen kann, in der hier zu sehenden hierfür bestimmten Leiterbahnschicht der Platine mehrere Leitungen - hier vier Leitungen - der Zonen-Verbindung **VZC** zugeordnet sind, mit der die jeweilige Peripheriekopplungs-Unterbaugruppe über mehrere - hier vier - Kontakte **ZK** elektrisch etwa mit der programmierbaren Logik - vorzugsweise in der dritten Zone **L** - verbunden werden kann und vorzugsweise auch ist.

Auch sind hier jedem der Rasterplätze **RP** in dem Raster **R** der Peripheriekopplungs-Unterbaugruppen-Zone **SG**, die eine Peripheriekopplungs-Unterbaugruppe (vorzugsweise auf der Platinenoberseite oder -unterseite) ganz oder teilweise einnehmen kann, in der hier zu sehenden hierfür bestimmten Leiterbahnschicht der Platine vier Leitungen der Konnektorbaulement-Verbindung **VSC** zugeordnet, mit der die jeweilige Peripheriekopplungs-Unterbaugruppe über vier Kontakte **CK** mit dem jeweilig zugehörigen Pin **P** des Konnektorbauelements **I/O-C** elektrisch verbunden werden kann und vorzugsweise auch ist. Hier hat das Konnektorbauelement vier Pins und damit auch vier Kontakte nach außen zu etwaigen Peripheriegeräten **PG** hin, mit denen die jeweilige Peripheriekopplungs-Unterbaugruppe von jedem Rasterplatz **RP** so - vorzugsweise mittels einer Durchkontaktierung - verbunden werden kann.

Fig. 4 zeigt eine schematische Darstellung der Peripheriekopplungs-Unterbaugruppen-Zone **SG** der Ausführungsform der intelligenten Peripheriekopplungsbaugruppe nach Fig. 3 in zwei gleichzeitig schematisch dargestellten Platinenebenen, in der jeweils sowohl Leitung(en) der Zonen-Verbindung **VZC** als auch Leitungen der Konnektorbauelement-Verbindung **VSC** verlaufen.

Die Leitung(en) der Zonen-Verbindung **VZC**, die etwa die programmierbare Logik - vorzugsweise in der dritten Zone der Platine **L** - und/oder die Microcontroller-Unterbaugruppe - vorzugsweise in der zweiten Zone **M** - und/oder die Netzwerkkopplungs-Unterbaugruppe - vorzugsweise in der ersten Zone **A** - mit der oder den Peripheriekopplungs-Unterbaugruppe(n) in der Peripheriekopplungs-Unterbaugruppen-Zone **SG** verbindet oder verbinden ist oder sind hier in zwei Leiterbahnenschichten der Platine angeordnet. Eine solche Anordnung ist immer möglich, da die Leiterbahnen, die die programmierbare Logik - etwa in der dritten Zone **L** der Platine - und/oder die Microcontroller-Unterbaugruppe - etwa in der zweiten Zone **M** - und/oder die Netzwerkkopplungs-Unterbaugruppe - etwa in der ersten Zone **A** - mit der oder den Peripheriekopplungs-Unterbaugruppe(n) in der Peripheriekopplungs-Unterbaugruppen-Zone **SG** verbindet oder verbinden immer in einer Ebene von einer Seite her an den jeweiligen Rasterplatz **RP** - hier datenbusartig - herangeführt werden können. Hat man - wie hier sichtbar - mehrere - hier drei verschiedene - Rasterplatzreihen, so bedarf es einer zweiten Leiterplattenebene, in der die Querverbindungen zwischen den - hier datenbusartig verlaufenden - Leitungen der Zonen-Verbindung **VZC** zu den verschiedenen Rasterplatzreihen **RP** hergestellt werden, wenn man alle Rasterpläte mit allen Leitungen der Zonen-Verbindung **VZC** versorgen will.

Wie die Zonen-Verbindung **VZC,** die etwa die programmierbare Logik - vorzugsweise in der dritten Zone **L** der Platine - und/oder die Microcontroller-Unterbaugruppe - etwa in der zweiten Zone **M** - und/oder die Netzwerkkopplungs-Unterbaugruppe - vorzugsweise in der ersten Zone **A** - mit der oder den Peripheriekopplungs-Unterbaugruppe(n) in der Peripheriekopplungs-Unterbaugruppen-Zone **SG** verbindet oder verbinden, kann oder können auch die Leitungen der Konnektorbaulement-Verbindung **VSC**, die die Peripheriekopplungs-Unterbaugruppe(n) in der Peripheriekopplungs-Unterbaugruppen-Zone **SG** mit den Pins des Konnektorbauelements **I/O-C** verbindet oder verbinden - wie hier zu sehen - in zwei Leiterbahnenschichten der Platine angeordnet sein, da hier die gleichen Überlegungen, wie vorstehend für die Zonen-Verbindung **VZC** dargelegt, gelten.

Hier sind sogar sowohl die Leitungen der Zonen-Verbindung **VZC** als auch die Leitungen der Konnektorbaulement-Verbindung **VSC** in denselben beiden Leiterbahnenschichten der Platine angeordnet, was topologisch möglich ist, wenn man etwa die ersteren auf einer - hier der linken - Seite zuführt, die zweiten auf der anderen - hier der rechten - Seite in derselben Leiterplattenebene abführt, wobei die Querverbindungen beider in einer zweiten Ebene, hier außerhalb des Rasters **R,** parallel - und hier auch senkrecht zu den Verbindungen in der ersten Leiterplattenebene - zueinander geführt werden. Diese Anordnung ist besonders effizient und daher günstig, da sie zwar außerhalb des Rasters **R** zwei Leiterplattenebenen benötigt, innerhalb des Rasters aber, also im Bereich der Rasterplätze **RP,** die durch Peripheriekopplungs-Unterbaugruppen ganz oder teilweise eingenommen werden können, nur eine einzige Leiterplattenebene, nämlich zur Verbindung mit den jeweiligen Peripheriekopplungs-Unterbaugruppen benötigt. Alle anderen Leiterplattenebenen hingegen stehen den jeweiligen Peripheriekopplungs-Unterbaugruppen **PUG** für ihre eigene interne ,Verdrahtung' zur Verfügung.

Auf diese Weise können grundsätzlich alle Peripheriekopplungs-Unterbaugruppen **PUG** an allen Rasterplätzen **RP** mit allen Leitungen der Zonen-Verbindung **VZC** und auch mit allen Leitungen der Konnektor-Verbindung **VSC** konnektiert werden, soweit dies die Platzverhältnisse und die über die jeweiligen Leitungen fließenden Ströme erlauben, was die Platzierung der Peripheriekopplungs-Unterbaugruppen **PUG** erleichtert. In der tatsächlichen Realisierung wird man aber - insbesondere für die Zonen-Verbindung **VZC** - wesentlich mehr Leitungen als hier aus zeichnerischen Gründen der Übersichtlichkeit halber dargestellt, vorsehen. Tatsächlich werden für die jeweilige Peripheriekopplungs-Unterbaugruppe **PUG** vier - oder auch sechs - Leitungen bevorzugt, so daß bei hier 33 Rasterplätzen 33 x 4, also 132 Leitungen oder sogar 33 x 6, mithin 198 Leitungen benötigt werden, die zu jedem Rasterplatz **RP** zu führen sind.

Vorzugsweise sind je Peripheriekopplungs-Unterbaugruppe **PUG** folgende Leitungen für folgende Signale als Zonen-Verbindung **VZC** vorgesehen:
- Eine von der Peripheriekopplungs-Unterbaugruppe **PUG** kommende und in Richtung der Netzwerkkopplungs-Unterbaugruppe **N** (vorzugsweise in der ersten Zone **A** der Platine) und/oder der programmierbaren Logik **PL** (vorzugsweise in der dritten Zone L der Platine) und/oder der Microcontroller-Unterbaugruppe **MUG** (vorzugsweise in der zweiten Zone **M**) gehende analoge Eingangsleitung, und
- eine Leitung zur Ein- und/oder Ausgabe von Frequenzsignalen, etwa zur Pulsweitenmodulation zwischen der Peripheriekopplungs-Unterbaugruppe **PUG** und/oder der Netzwerkkopplungs-Unterbaugruppe **N** und/oder der programmierbaren Logik **PL** und/oder der Microcontroller-Unterbaugruppe **MUG,** sowie
- zwei Leitungen für jeweils ein digitales Signal (also etwa insgesamt 4 Zustände bei bevorzugter dualer Codierung) - vorzugsweise zur Konfiguration der Peripheriekopplungs-Unterbaugruppe **PUG** - von der Peripheriekopplungs-Unterbaugruppe **PUG** hin zu der Netzwerkkopplungs-Unterbaugruppe **N** und/oder der programmierbaren Logik **PL** und/oder der Microcontroller-Unterbaugruppe **MUG.**

Besonders bevorzugterweise treten zu den vorgenannten jeweils vier Leitungen noch jeweils zwei weitere Leitungen der Zonen-Verbindung **VZC** hinzu, nämlich etwa zur Ansteuerung zumindest einer - z.B. zweifarbigen - Leuchtdiode - vorzugsweise einer rot/grün-Leuchtdiode - von Seiten der Peripheriekopplungs-Unterbaugruppe **PUG** her und/oder von Seiten der Netzwerkkopplungs-Unterbaugruppe **N** und/oder der programmierbaren Logik **PL** und/oder der Microcontroller-Unterbaugruppe **MUG** her, um so den Betriebs- oder Fehlerzustand oder dergleichen der zugehörigen Peripheriekopplungs-Unterbaugruppe **PUG** anzuzeigen oder zu signalisieren oder dergleichen.

Grundsätzlich können Leitungen natürlich auch gemeinsam von mehreren Peripheriekopplungs-Unterbaugruppe **PUG** genutzt werden; dies setzt aber voraus, daß die betreffende Leitung dann von allen mit ihr verbundenen Peripheriekopplungs-Unterbaugruppen **PUG** als eine gemeinsam genutzte Busleitung behandelt wird, was an dieser Stelle einer intelligenten Peripheriekopplungsbaugruppe **IP** - wie die vorgenannten Ausführungsbeispiele bereits zeigen - wohl etwas ungewöhnlich, gleichwohl aber auch möglich ist.

Wird die Anzahl der zu den einzelnen Rasterplätzen zu führenden Leitungen zu groß, so kann natürlich auch gruppenweise reduziert werden, etwa indem jeweils in einer Reihe eine Gruppe von Leitungen, also etwa 66 Leitungen - für 6 Leitungen für jeweils 11 Rasterplätze - in 3 Reihen, etwa wie in den Fig. 2 und 3 - dort allerdings aus Darstellungsgründen nur für 4 Leitungen je Reihe - zu sehen, angeordnet werden.

Am einfachsten für die Einfügung der Kontaktierungen **ZK, CK** mit der jeweiligen Peripheriekopplungs-Unterbaugruppe **PUG** ist es natürlich, wenn auch die Leitungen der Zonen-Verbindung **VZC** jeweils einem festen Ort zur Kontaktierung am jeweiligen Rasterplatz **RP** zugeführt werden, wie hier auch für die Konnektorbauelement-Verbindung **VSC** - freilich nur für eine einzige Leitung je Rasterplatz **RP** - zu sehen ist.

Eine solche Leitungsführung ist aber nur dann möglich, wenn eine feste (maximale) Anzahl von Leitungen für jeden Rasterplatz **RP** vorgesehen werden kann. Auch müssen dann jeweils alle Leitungen den vorgesehenen - vorzugsweise an einer festen Position des jeweiligen Rasterplatzes liegenden - Orten zur Kontaktierung **ZK**, **CK** an jedem Rasterplatz so zugeführt werden, daß sie den jeweiligen zur Kontaktierung **ZK**, **CK** vorgesehenen Orten aller jeweils anderen Rasterplätze **RP** und ihren jeweiligen Leitungszuführungen nicht im (Leitungs-)Wege sind. Dies ist möglich, wie die in Fig. 2 zu sehende Ausgestaltung der Konnektorbaulement-Verbindung **VSC** zeigt, die ja - freilich nur für jeweils eine einzige Leitung der Konnektorbaulement-Verbindung **VSC** je Rasterplatz **RP** - bereits in dieser Weise ausgestaltet ist. Allerdings zeigt die Darstellung in Fig. 2 auch, daß eine solche Ausführung, insbesondere wenn sie eine Vielzahl von Leitungen und Kontaktierungsstellen je Rasterplatz **RP** vorsieht, schnell sehr viel Platz für die parallele Leitungsführung benötigt.

So ist denn eine solche Ausführung zwar für die Schaffung der jeweiligen Kontaktierungen **ZK, CK** mit der jeweiligen Peripheriekopplungs-Unterbaugruppe **PUG** besonders einfach, da die Kontaktierung **ZK, CK** dann immer an einem festen Ort bezogen auf den jeweiligen Rasterplatz **RP** erfolgen kann, gleichwohl ist sie recht platzraubend.

Glücklicherweise ist sie aber auch nicht notwendig, da es etwa vollkommen ausreicht, beim Leiterplatten-Layout der jeweiligen Peripheriekopplungs-Unterbaugruppe **PUG** innerhalb der Peripheriekopplungs-Unterbaugruppe **PUG** in der jeweiligen Leiterbahnschicht **LO,** aus der diese Kontaktierung **ZK, CK** erfolgen soll, etwa einen ausreichend großen Bereich als Kontaktfläche **ZK** vorzusehen, die es etwa erlaubt, eine einfache (Durch-)Kontaktierung **ZK, CK** an unterschiedliche Orte - und damit auch zu unterschiedlichen Leitungen der Zonen-Verbindung **VZC** oder auch der Konnektorbaulement-Verbindung **VSC** - in der Fläche der Leiterbahnebene **L2** herzustellen, in der die jeweilige Leitung der Zonen-Verbindung **VZC** oder der Konnektorbaulement-Verbindung **VSC** liegt (vgl. hierzu auch Fig. 5).

Fig. **5** zeigt eine schematische Darstellung der Peripheriekopplungs-Unterbaugruppen-Zone **SG** der Ausführungsform der intelligenten Peripheriekopplungsbaugruppe nach Fig. 4 in mehreren - hier fünf - Platinenebenen **L1, L2, L3,** L4 und **LO** in zwei Schnitten (ein erster Schnitt im oberen Teil, ein zweiter Schnitt im unteren Teil hier dargestellt) durch die Platine, in der jeweils sowohl die Leitung(en) der Zonen-Verbindung **VZC** als auch die Leitung(en) der Konnektorbauelement-Verbindung **VSC** in verschiedenen - hier zwei - Leiterbahnenschichten **L1** und **L2** verlaufen.

Die Leitung(en) der Zonen-Verbindung **VZC,** die die programmierbare Logik - etwa in der dritten Zone der Platine **L** - und/oder die Microcontroller-Unterbaugruppe - etwa in der zweiten Zone **M** - und/oder die Netzwerkkopplungs-Unterbaugruppe - etwa in der ersten Zone **A** - mit der oder den Peripheriekopplungs-Unterbaugruppe(n) in der Peripheriekopplungs-Unterbaugruppen-Zone **SG** verbindet oder verbinden ist oder sind hier in zwei Leiterbahnenschichten **L1** und **L2** der Platine angeordnet. Eine solche Anordnung ist immer möglich, da die Leiterbahnen, die die programmierbare Logik - etwa in der dritten Zone **L** der Platine - (und/oder die Microcontroller-Unterbaugruppe - etwa in der zweiten Zone **M -** und/oder die Netzwerkkopplungs-Unterbaugruppe - etwa in der ersten Zone **A** -) mit der oder den Peripheriekopplungs-Unterbaugruppe(n) in der Peripheriekopplungs-Unterbaugruppen-Zone **SG** verbindet oder verbinden, immer in einer Ebene - hier in der Ebene **L2** - von einer Seite her an den jeweiligen Rasterplatz **RP** - hier datenbusartig - herangeführt werden können, wie etwa in Fig. 4 zu sehen ist. Vorliegend sieht man im oberen Teil der Darstellung in der Ebene **L2** eine einzige solche Leitung der Zonen-Verbindung **VZC.** Hat man - wie ebenfalls wiederum in Fig. 4 zu sehen - mehrere - hier drei verschiedene - Rasterplatzreihen, so bedarf es - wenn man alle Leitungen zu allen Rasterplätzen **RP** führen will - einer zweiten Leiterplattenebene, hier nämlich der Leiterplattenebene **L1**, in der die Querverbindungen zwischen den - hier datenbusartig verlaufenden - Leitungen der Zonen-Verbindung **VZC** hergestellt werden, was in Leiterplattenebene **L1** am linken Rand im oberen Teil der Darstellung hier zu sehen ist, wo auch die Durchkontaktierung **V-VZC** einer Leitung der Zonen-Verbindung **VZC** zwischen den Leiterplattenebenen (auch Leiterplattenschichten genannt) **L1** und **L2** zu sehen ist. Die Leitung der Zonen-Verbindung **VZC,** die hier in Leiterplattenschicht **L2** liegt, weist zur Verbindung mit den jeweiligen Peripheriekopplungs-Unterbaugruppen weitere Kontakte **ZK** auf, die hier ebenfalls als Durchkontaktierung (auch VIAS genannt) von der Leiterplattenschicht **L2,** in der die (jeweilige) Leitung der Zonen-Verbindung **VZC** liegt, hin zum jeweiligen Bauteil der jeweiligen Peripheriekopplungs-Unterbaugruppe etwa in der jeweiligen dortigen Leiterbahnschicht **LO** (vorzugsweise an oder oberhalb der Platinenoberfläche) ausgelegt ist.

Das Leiterplatten-Layout der jeweiligen Peripheriekopplungs-Unterbaugruppe **PUG** innerhalb der Peripheriekopplungs-Unterbaugruppe **PUG** ist in der jeweiligen Leiterbahnschicht **LO,** aus der diese Kontaktierung **ZK, CK** erfolgen soll, vorzugsweise so ausgestaltet, daß etwa ein ausreichend großer Bereich als Kontaktfläche **ZK '** vorgesehen ist, die es erlaubt, eine einfache (Durch-)Kontaktierung **ZK** an unterschiedliche Kontakt-Orte **ZK** " - und damit auch zu unterschiedlichen Leitungen der Zonen-Verbindung **VZC** - in der Fläche der Leiterbahnebene **L2** herzustellen, in der die jeweilige Leitung der Zonen-Verbindung **VZC** liegt. Entsprechendes kann vorzugsweise auch zur (Durch-)Kontaktierung der Peripheriekopplungs-Unterbaugruppe **PUG** mit den Leitungen der Konnektorbauelement-Verbindung **VSC** vorgesehen sein.

Wie bei der Zonen-Verbindung **VZC,** die die programmierbare Logik - etwa in der dritten Zone **L** der Platine - (und/oder die Microcontroller-Unterbaugruppe - etwa in der zweiten Zone **M** - und/oder die Netzwerkkopplungs-Unterbaugruppe - etwa in der ersten Zone **A** -) mit der oder den Peripheriekopplungs-Unterbaugruppe(n) in der Peripheriekopplungs-Unterbaugruppen-Zone **SG** verbindet oder verbinden, kann oder können auch die Leitung(en) der Konnektorbaulement-Verbindung **VSC,** die die Peripheriekopplungs-Unterbaugruppe(n) in der Peripheriekopplungs-Unterbaugruppen-Zone **SG** mit den Pins des Konnektorbauelements **I/O-C** verbindet oder verbinden - wie hier im unteren Teil der Darstellung zu sehen - in zwei Leiterbahnenschichten **L1** und **L2** der Platine angeordnet sein, da hier die gleichen Überlegungen, wie vorstehend für die Zonen-Verbindung **VZC** dargelegt, gelten. Dies ist hier im unteren Teil der Darstellung zu sehen, wo in Leiterplattenebene **L1** am rechten Rand auch die Durchkontaktierung **V-VSC** einer Leitung der Konnektorbauelement-Verbindung **VSC** zwischen den Leiterplattenebenen (auch Leiterplattenschichten genannt) **L1** und **L2** dargestellt ist. Die Leitung der Konnektorbauelement-Verbindung **VSC,** die hier in Leiterplattenschicht **L2** liegt, weist zur Verbindung mit der jeweiligen Peripheriekopplungs-Unterbaugruppe **PUG** mit dem/den Pin(s) **P** des Konnektorbaulements **I/O-C** weitere Kontakte **CK** auf, die auch hier wiederum als Durchkontaktierung (auch VIAS genannt) von der Leiterplattenschicht **L2,** in der die (jeweilige) Leitung der Konnektorbauelement-Verbindung **VSC** liegt, hin zum jeweiligen Bauteil der jeweiligen Peripheriekopplungs-Unterbaugruppe etwa in der jeweiligen dortigen Leiterbahnschicht **LO** (vorzugsweise an oder oberhalb der Platinenoberfläche) ausgelegt ist.

Hier sind also sowohl die Leitungen der Zonen-Verbindung **VZC** als auch die Leitungen der Konnektorbaulement-Verbindung **VSC** in denselben beiden Leiterbahnenschichten **L1** und **L2** der Platine angeordnet, was topologisch dadurch ermöglicht wird, daß man etwa die ersteren **VZC** auf einer - hier der linken - Seite zuführt, die zweiten **VSC** auf der anderen - hier der rechten - Seite in derselben Leiterplattenebene **L2** abführt, wobei die Querverbindungen beider in einer zweiten Ebene **L1,** hier außerhalb des Rasters **R** (vgl. etwa Fig. 4), parallel - und hier auch senkrecht zu den Verbindungen in der ersten Leiterplattenebene **L2** - zueinander geführt werden. Diese Anordnung ist besonders effizient und daher günstig, da sie zwar außerhalb des Rasters **R** zwei Leiterplattenebenen **L1** und **L2** benötigt, innerhalb des Rasters **R** aber, also im Bereich der Rasterplätze **RP,** die durch Peripheriekopplungs-Unterbaugruppen ganz oder teilweise eingenommen werden können, nur eine einzige Leiterplattenebene **L2,** nämlich zur Verbindung mit den jeweiligen Peripheriekopplungs-Unterbaugruppen benötigt. Alle anderen Leiterplattenebenen hier **L1, L3, L4, LO** hingegen stehen den jeweiligen Peripheriekopplungs-Unterbaugruppen (hier innerhalb des Rasters **R**) für ihre eigene interne ,Verdrahtung' zur Verfügung.

Fig. **6** zeigt eine schematische Darstellung der intelligenten Peripheriekopplungsbaugruppe **IP** nach der vorliegenden Erfindung entsprechend Fig. 1 mit drei, bereits mit Baugruppen bestückten Zonen **A, M** und **L** und eine Peripheriekopplungs-Unterbaugruppen-Zone **SG** (hier als vierte Zone) mit fünf (noch mit Unterbaugruppen unbestückten) Teilzonen **SG1.1, SG1.2, SG2.1, SG2.2** und **SG2.3** für Peripheriekopplungs-Unterbaugruppen sowie ein Konnektorbauelement **I/O-C** zur Ankopplung an Peripheriegeräte und einem Konnektor **H-C** zur Ankopplung an ein zentrales Steuergerät über ein Datennetzwerk.

Fig. **7** zeigt eine schematische Darstellung der intelligenten Peripheriekopplungsbaugruppe **IP** nach der vorliegenden Erfindung entsprechend Fig. 1 mit drei bereits mit Baugruppen bestückten Zonen **A, M** und **L** und einer Peripheriekopplungs-Unterbaugruppen-Zone **SG** (hier als vierte Zone) mit einer bereits mit einer Peripheriekopplungs-Unterbaugruppe **PUG** bestückten Teilzone **SG1.1** und vier, noch mit Unterbaugruppen unbestückten Teilzonen **SG1.2, SG2.1, SG2.2** und **SG2.3** für Peripheriekopplungs-Unterbaugruppen sowie einem Konnektorbauelement **I/O-C** zur Ankopplung an Peripheriegeräte und einem Konnektor **H-C** zur Ankopplung an ein zentrales Steuergerät über ein Datennetzwerk. Hierzu ist anzumerken, daß die hier noch mit Unterbaugruppen unbestückten Teilzonen **SG1.2, SG2.1, SG2.2** und **SG2.3** statt unmittelbar bestückt zu werden auch mit einem entsprechenden Baugruppen-Verbindungssystem, etwa einem Baugruppensockel **BGS** zur Aufnahme einer Unterbaugruppe ausgestattet werden können. In diesem Falle ist bereits die vollständige Verdrahtung für die Unterbaugruppe vorhanden, die dann, ähnlich wie ein Mikroprozessor, später aufgesteckt und in Betrieb genommen werden kann.

Fig. **8** zeigt eine schematische Darstellung einer weiteren Ausführungsform der intelligenten Peripheriekopplungsbaugruppe **IP** nach der vorliegenden Erfindung mit vier bereits mit Baugruppen bestückten Zonen **A, M, L** und **SG,** wobei die Peripheriekopplungs-Unterbaugruppen-Zone **SG** (hier als vierte Zone) zwei Peripheriekopplungs-Unterbaugruppen **PUG** in Teilzonen **SG1.2** und **SG1.2** in einer Reihe angeordnet aufweist sowie ein Konnektorbauelement **I/O-C** zur Ankopplung an Peripheriegeräte und einem Konnektor **H-C** zur Ankopplung an ein zentrales Steuergerät über ein Datennetzwerk.

Fig. **9** zeigt eine schematische Darstellung einer weiteren bevorzugten Ausführungsform der intelligenten Peripheriekopplungsbaugruppe **IP** nach der vorliegenden Erfindung ebenfalls mit vier bereits mit Baugruppen bestückten Zonen **A, M, L** und **SG,** wobei die Peripheriekopplungs-Unterbaugruppen-Zone **SG** (hier als vierte Zone) hier fünf mit Peripheriekopplungs-Unterbaugruppen **PUG** bestückte Teilzonen **SG1.1, SG1.2, SG2.1, SG2.2** und **SG2.3** in zwei Reihen aufweist. Die für die Peripheriekopplungs-Unterbaugruppen **PUG** verwendeten Teilzonen **SG1.1, SG1.2** einerseits und **SG2.1** und **SG2.2** sowie **SG2.3** andererseits sind unterschiedlich komplex und daher auch unterschiedlich lang, wodurch sie einmal in der ersten Reihe fünf Rasterplätze **RP** und zum anderenmal in der zweiten Reihe zweimal vier Rasterplätze **RP** und einmal sogar nur drei Rasterplätze **RP** einnehmen.

Fig. **10** zeigt ein schematisches Diagramm betreffend die Funktionsweise jeweilig bevorzugter Ausführungsformen des
- erfindungsgemäßen computergestützten Verfahrens zur modularen Erstellung eines Leiterbahnen-Layouts **LAY** einer herzustellenden erfindungsgemäßen intelligenten Peripheriekopplungsbaugruppe **IP,**
- erfindungsgemäßen computergestützten Verfahrens zur Erstellung eines Bauteil-Bestückungsplans **BOM** einer herzustellenden erfindungsgemäßen intelligenten Peripheriekopplungsbaugruppe **IP,**
- erfindungsgemäßen computergestützten Verfahrens zur Erstellung eines Schaltplans S einer herzustellenden erfindungsgemäßen intelligenten Peripheriekopplungsbaugruppe **IP,**
- erfindungsgemäßen computergestützten Verfahrens zur Erstellung einer Logik-Programmierung **LO** für eine programmierbare Logik **PL** einer herzustellenden erfindungsgemäßen intelligenten Peripheriekopplungsbaugruppe **IP,**
- erfindungsgemäßen computergestützten Verfahrens zur Erstellung einer (Daten-) Struktur des Prozeßabbilds **PI** der herzustellenden erfindungsgemäßen intelligenten Peripheriekopplungsbaugruppe **IP** - vorliegend Intelligente-Peripheriekopplungsbaugruppe-Prozeßabbild-Struktur **IP-PIS** genannt -, und
- erfindungsgemäßen computergestützten Verfahrens zur Erstellung einer Microcontroller-Programmierung **MP** für eine Microcontroller-Unterbaugruppe **MUG** zum programmierten Betrieb einer erfindungsgemäßen herzustellenden intelligenten Peripheriekopplungsbaugruppe **IP**
vorzugsweise als jeweilige Teilschritte (Teilverfahren) zur erfindungsgemäßen Herstellung einer erfindungsgemäßen intelligenten Peripheriekopplungsbaugruppe sowie das vorzugsweise Zusammenwirken vorgenannter erfindungsgemäßer Verfahren.

Zunächst betrifft die Darstellung nach vorliegender Fig. 10 ein computergestütztes Verfahren **LAY** zur modularen Erstellung eines Leiterbahnen-Layouts **IP-L** für eine herzustellende intelligente Peripheriekopplungsbaugruppe **IP** gemäß der vorliegenden Erfindung.

Hierbei wird aus einer Computer-Datenbasis von vorerstellten Leiterbahnenlayout-Modulen **LM** - vorzugsweise aus einer Vielzahl zur Verfügung stehender und bereits fertig designter Grundtypen - ein Baugruppen-Leiterbahnenlayout **IP-B-L** mit einem zugehörigen Peripheriekopplungsbaugruppengrundtyp **IP-B** für die herzustellende intelligente Peripheriekopplungsbaugruppe **IP** ausgewählt und in einem Datenspeicher für das Leiterbahnen-Layout **IP-L-MEM** der herzustellenden intelligente Peripheriekopplungsbaugruppe **IP** abgelegt.

Ein Peripheriekopplungsbaugruppengrundtyp **IP-B** ist dabei ein, in seinen Grundkomponenten ausgelegter, aber noch nicht ganz fertig entworfener Bautyp für die herzustellende intelligente Peripheriekopplungsbaugruppe **IP,** für den schon der Grundentwurf, also

dessen Baugruppen-Leiterbahnenlayout **IP-B-L** mit
- vorzugsweise dem Leiterbahnenlayout für eine Netzwerkkopplungs-Unterbaugruppe **N** und/oder dem Leiterbahnenlayout für die Microcontroller-Unterbaugruppe **MUG** und/oder dem Leiterbahnenlayout für eine programmierbare Logik zur Anschaltung an eine oder mehrere Peripheriekopplungs-Unterbaugruppe(n) **PUG** und
- vorzugsweise dem Leiterbahnenlayout für eine Peripheriekopplungs-Unterbaugruppen-Zone **SG** mit der Zonen-Verbindung **VZC** zur Netzwerkkopplungs-Unterbaugruppe **N** und/oder zur Microcontroller-Unterbaugruppe **MUG** und/oder zur programmierbaren Logik **PL** und der Konnektorbauelement-Verbindung **VSC** zum Konnektorbauelement **I/O-C;** und

vorzugsweise dessen als Modul-Bauteil-Bestückungsplan **IP-B-L-BOM** vorliegender Bauteil-Bestückungsplan für den Peripheriekopplungsbaugruppengrundtyp **IP-B;** und vorzugsweise dessen als Schaltplan-Modul **IP-B-L-S** vorliegender Schaltplan für den Peripheriekopplungsbaugruppengrundtyp **IP-B;** und
vorzugsweise dessen als Logik-Programmierungs-Modul **IP-B-LOM** vorliegende (Grund-)Logik-Programmierung für eine programmierbare Logik **PL** für den Peripheriekopplungsbaugruppengrundtyp **IP-B;** sowie
vorzugsweise dessen als Microcontroller-Programmierungs-Modul **IP-B-MP** vorliegende (Grund-)Microcontroller-Programinierung für eine Microcontroller-Unterbaugruppe **MUG** zum programmierten Betrieb des Peripheriekopplungsbaugruppengrundtyps **IP-B;**

- vorzugsweise in einer Computer-Datenbasis **LM, BM, SDM, LOM, MPD** - bereits als zu diesem Peripheriekopplungsbaugruppengrundtyp zugehörig vorliegt oder vorliegen.

In der vorliegenden Fig. 10 ist dies dadurch dargestellt, daß um
- das jeweils zu dem Peripheriekopplungsbaugruppengrundtyp **IP-B** vorzugsweise zugehörigen Baugruppen-Leiterbahnenlayout **IP-B-L,**
- den jeweils zu dem Peripheriekopplungsbaugruppengrundtyp **IP-B** vorzugsweise zugehörigen Modul-Bauteil-Bestückungsplan **IP-B-L-BOM,**
- das jeweils zu dem Peripheriekopplungsbaugruppengrundtyp **IP-B** vorzugsweise zugehörige Schaltplan-Modul **IP-B-L-S,**
- das jeweils zu dem Peripheriekopplungsbaugruppengrundtyp **IP-B** vorzugsweise zugehörige Logik-Programmierungs-Modul **IP-B-LOM,**das jeweils zu dem Peripheriekopplungsbaugruppengrundtyp **IP-B** vorzugsweise zugehörige Microcontroller-Programmierungs-Modul **IP-B-MP**
eine in gestrichelter Linie ausgeführte Umrandung zu sehen ist, die jeweils mit dem Bezugszeichen des Peripheriekopplungsbaugruppengrundtyps **IP-B** versehen ist.

Der Peripheriekopplungsbaugruppengrundtyp **IP-B** ist also durch alle vorgenannten, ihm jeweils zugehörigen Elemente **IP-B-L, IP-B-L-BOM, IP-B-L-S, IP-B-LOM, IP-B-MP** charakterisiert, wobei nicht unbedingt alle diese Elemente für einen bestimmten Peripheriekopplungsbaugruppengrundtyp **IP-B** auch vorliegen müssen.

Das ausgewählte Baugruppen-Leiterbahnenlayout **IP-B-L** für die herzustellende intelligente Peripheriekopplungsbaugruppe **IP** weist dabei bereits
ein Netzwerkkopplungs-Unterbaugruppen-Leiterbahnenlayout für die Netzwerkkopplungs-Unterbaugruppe **N,** und/oder
ein Microcontroller-Unterbaugruppen-Leiterbahnenlayout für die Mikrocontroller-Unterbaugruppe **MUG,** und
ein Peripheriekopplungs-Unterbaugruppen-Zonen-Leiterbahnenlayout für die Peripheriekopplungs-Unterbaugruppen-Zone **SG,** sowie
ein Zonen-Verbindungs-Leiterbahnenlayout für eine Zonen-Verbindung **VZC** von der Peripheriekopplungs-Unterbaugruppen-Zone **SG** zur programmierbaren Logik **PL** und/oder zur Microcontroller-Unterbaugruppe **MUG** und/oder zur Netzwerkkopplungs-Unterbaugruppe **N,** sowie
ein Konnektorbaulement-Verbindungs-Leiterbahnenlayout für eine Konnektorbaulement-Verbindung **VSC** von der Peripheriekopplungs-Unterbaugruppen-Zone (**SG**) zum Konnektorbauelement **I/O-C** auf.

Ferner wird jeweils ein Peripheriekopplungs-Unterbaugruppen-Leiterbahnenlayout **PUG-L** für jede Peripheriekopplungs-Unterbaugruppe **PUG,** die Bestandteil der herzustellenden intelligenten Peripheriekopplungsbaugruppe **IP** wird, aus der Computer-Datenbasis der vorerstellten Leiterbahnenlayout-Module **LM** ausgewählt und ebenfalls in dem Datenspeicher für das Leiterbahnen-Layouts **IP-L-MEM** der herzustellenden intelligente Peripheriekopplungsbaugruppe **IP** abgelegt.

Es wird bzw. werden ferner für jede Peripheriekopplungs-Unterbaugruppe **PUG,** die Bestandteil der herzustellenden intelligenten Peripheriekopplungsbaugruppe **IP** wird, der Rasterplatz **RP** oder die Rasterplätze **RP** in dem Raster **R** der Peripheriekopplungs-Unterbaugruppen-Zone **SG** gewählt, den oder die die jeweilige Peripheriekopplungs-Unterbaugruppe **PUG** einnimmt oder einnehmen. Eine solche Wahl des Rasterplatzes **RP** oder der Rasterplätze **RP** kann vorzugsweise automatisch - etwa durch eine Vergabe der Rasterplätze an die Peripheriekopplungs-Unterbaugruppen **PUG** der Reihe nach' (etwa beginnend von einem bestimmten Rasterplatz **RP** an) oder nach bestimmten Platzbelegungskriterien oder auch nach den dem Fachmann wohlbekannten Methoden aus dem Stand der Technik (vgl. etwa Lienig, Jens; Layoutsynthese elektronischer Schaltungen; Berlin Heidelberg 2006; S. 91ff. mit weiteren Nachweisen) - erfolgen, wobei zu beachten ist, daß durch den vorliegenden erfindungsgemäßen Aufbau der intelligenten Peripheriekopplungsbaugruppe **IP** - insbesondere in der Peripheriekopplungs-Unterbaugruppen-Zone **SG** (siehe unten) - auch die Platzierung der Peripheriekopplungs-Unterbaugruppen **PUG** in der Peripheriekopplungs-Unterbaugruppen-Zone **SG** aufgrund der Standardisierung der vorerstellten Leiterplattenlayouts und ihrer Verbindung untereinander gegenüber dem Stand der Technik erheblich vereinfacht ist.

Das in dem Datenspeicher für das Leiterbahnen-Layout **IP-L-MEM** der herzustellenden intelligenten Peripheriekopplungsbaugruppe **IP** abgelegte Baugruppen-Leiterbahnenlayout **IP-B-L** für die herzustellende intelligente Peripheriekopplungsbaugruppe **IP** ist nämlich nach der vorliegenden Erfindung so ausgestaltet, daß
- (zumindest) einem gewählten Rasterplatz **RP** in dem Raster **R** der Peripheriekopplungs-Unterbaugruppen-Zone **SG,** den oder die die jeweilige Peripheriekopplungs-Unterbaugruppe **PUG** ganz oder teilweise einnimmt, in zumindest einer hierfür vorbestimmten Leiterbahnschicht **LO, L1, L2, L3, L4** der herzustellenden intelligenten Peripheriekopplungsbaugruppe **IP** eine oder mehrere Leitung(en) der Zonen-Verbindung **VZC** zur programmierbaren Logik **PL** und/oder zur Microcontroller-Unterbaugruppe **MUG** und/oder zur Netzwerkkopplungs-Unterbaugruppe **N** zugeordnet ist oder sind, mit der die jeweilige Peripheriekopplungs-Unterbaugruppe **PUG** über eine oder mehrere Kontaktierung(en) **ZK** elektrisch verbunden werden kann, und
- (zumindest) einem gewählten Rasterplatz **RP** in dem Raster **R** der Peripheriekopplungs-Unterbaugruppen-Zone **SG,** den oder die die jeweilige Peripheriekopplungs-Unterbaugruppe **PUG** ganz oder teilweise einnimmt, in zumindest einer hierfür vorbestimmten Leiterbahnschicht **LO, L1, L2, L3, L4** der herzustellenden intelligenten Peripheriekopplungsbaugruppe **IP** eine oder mehrere Leitung(en) der Konnektorbaulement-Verbindung **VSC** zum Konnektorbauelement **I/O-C** zugeordnet ist oder sind, mit der die jeweilige Peripheriekopplungs-Unterbaugruppe **PUG** über eine oder mehrere Kontaktierung(en) **CK** elektrisch verbunden werden kann.

Bei den herzustellenden intelligenten Peripheriekopplungsbaugruppen **IP** ist somit ein Raster **R** mit Rasterplätzen **RP** vorgesehen, die die Peripheriekopplungs-Unterbaugruppen **PUG** ganz oder teilweise einnehmen können und an denen jeweils einerseits eine oder mehrere Leitung(en), die als Zonen-Verbindung **VZC** zur programmierbaren Logik **PL** und/oder zum Microcontroller **MUG** und/oder zur Netzwerkkopplungs-Unterbaugruppe **N** hin dienen und andererseits eine oder mehrere Leitungen, die als Konnektorbaulement-Verbindung **VSC** mit einem oder mehreren Pin(s) des Konnektorbauelements **I/O-C** fungieren, wobei diese Leitungen **VZC, VSC** in einer bestimmten Leiterplattenebene (auch Leiterplattenschicht genannt) **LO, L1, L2, L3, L4** der erfindungsgemäßen intelligenten Peripheriekopplungsbaugruppe **IP** liegen.

Auf dieser erfindungsgemäßen Ausgestaltung ist es daher möglich, die Integration der nach wie vor gänzlich individuell ausgestaltbaren Peripheriekopplungs-Unterbaugruppen **PUG** in die intelligente Peripheriekopplungsbaugruppe **IP** hinsichtlich ihrer Ansteuerung von Seiten der Microcontroller-Unterbaugruppe **MUG** und/oder der programmierbaren Logik **PL** und/oder der Netzwerkkopplungs-Unterbaugruppe **N** her wie auch der Verbindung zum Konnektorbauelement **I/O-C,** also zur Seite der Peripheriegeräte hin, zu standardisieren.

Es kann oder können so nämlich für jede Peripheriekopplungs-Unterbaugruppe **PUG,** die Bestandteil der herzustellenden intelligenten Peripheriekopplungsbaugruppe **IP** wird, an dem Rasterplatz **RP** oder den Rasterplätzen **RP,** den oder die die jeweilige Peripheriekopplungs-Unterbaugruppe **PUG** ganz oder teilweise einnimmt, die von der jeweiligen Peripheriekopplungs-Unterbaugruppe **PUG** benötigte(n) elektrische(n) Verbindung(en) **VZC** zur programmierbaren Logik **PL** und/oder zur Microcontroller-Unterbaugruppe **MUG** und/oder zur Netzwerckopplungs-Unterbaugruppe **N** sowie die von der jeweiligen Peripheriekopplungs-Unterbaugruppe **PUG** benötigte(n) elektrische(n) Verbindung(en) **VSC** zum Konnektorbauelement **I/O-C** in das ausgewählte Baugruppen-Leiterbahnenlayout **IP-L** der herzustellenden intelligenten Peripheriekopplungsbaugruppe **IP** und das jeweilig ausgewählte Peripheriekopplungs-Unterbaugruppen-Leiterbahnenlayout **PUG-L** der jeweiligen Peripheriekopplungs-Unterbaugruppe **PUG,** die in dem Datenspeicher für das Leiterbahnen-Layout **IP-L-MEM** der herzustellenden intelligenten Peripheriekopplungsbaugruppe (**IP**) abgelegt sind, eingefügt werden.

Aus der so erfolgten Zusammenfügung des aus der Computer-Datenbasis vorerstellter Leiterbahnenlayout-Module **LM** für die Erstellung des Leiterbahnen-Layouts **IP-L** für die herzustellende intelligente Peripheriekopplungsbaugruppe **IP** ausgewählten und in dem Datenspeicher für das Leiterbahnen-Layout **IP-L-MEM** der herzustellenden intelligenten Peripheriekopplungsbaugruppe **IP** abgelegten Baugruppen-Leiterbahnenlayouts **IP-B-L** und des für jede Peripheriekopplungs-Unterbaugruppe **PUG,** die Bestandteil der herzustellenden intelligenten Peripheriekopplungsbaugruppe **IP** wird, jeweilig aus der Computer-Datenbasis vorerstellter Leiterbahnenlayout-Module **LM** ausgewählten und ebenfalls in dem Datenspeicher für das Leiterbahnen-Layout **IP-L-MEM** der herzustellenden intelligenten Peripheriekopplungsbaugruppe **IP** abgelegten Peripheriekopplungs-Unterbaugruppen-Leiterbahnenlayouts **PUG-L,** sowie der vorgenommenen Einfügungen von elektrischen Verbindungen **CK, ZK** in das Baugruppen-Leiterbahnenlayout **IP-B-L** der herzustellenden intelligenten Peripheriekopplungsbaugruppe **IP** und in das Peripheriekopplungs-Unterbaugruppen-Leiterbahnenlayout **PUG-L** jeder Peripheriekopplungs-Unterbaugruppe **PUG**, die Bestandteil der herzustellenden intelligenten Peripheriekopplungsbaugruppe **IP** wird, in dem Datenspeicher für das Leiterbahnen-Layout **IP-L-MEM** der herzustellenden intelligenten Peripheriekopplungsbaugruppe **IP** wird dann das Leiterbahnen-Layout **IP-L** für die herzustellende intelligente Peripheriekopplungsbaugruppe **IP** erstellt.

Auf diese erfindungsgemäße Weise kann der Leiterplattendesignaufwand für die erfindungsgemäße intelligente Peripheriekopplungsbaugruppe **IP** auch bei Verwendung höchst individueller Peripheriekopplungs-Unterbaugruppen **PUG** ganz erheblich gesenkt werden, indem diese jeweiligen Unterbaugruppen **PUG** - abgesehen einerseits von ihren jeweiligen Schnittstellenverbindungen zum Microcontroller **MUG** und/oder zur programmierbaren Logik **PL** und/oder zur Netzwerkkopplungs-Unterbaugruppe **N** und andererseits von ihren jeweiligen Verbindungen zum Konnektorbauelement **I/O-C** (also letztlich zum Peripheriegerät **PG**) hin - isoliert von allen anderen Peripheriekopplungs-Unterbaugruppen **PUG** nur für sich entworfen und - gegebenenfalls in verschiedenen Leiterplattenebenen **LO, L1, L2, L3, L4,** geroutet (also die jeweiligen zugehörigen Bauteile oder Bauteilplätze durch Leitungsverbindungen [auch Leiterbahnen genannt] miteinander verbunden) werden.

Lediglich die Schnittstellenverbindungen **ZK, CK** der jeweiligen Unterbaugruppen **PUG** zu den (drei) Verbindungsbaugruppen, also Microcontroller **MUG** und/oder programmierbare Logik **PL** und/oder die Netzwerkkopplungs-Unterbaugruppe **N** einerseits und Konnektorbauelement **I/O-C** (mit etwaigem Peripheriegerät **PG** damit verbunden) andererseits müssen in Abhängigkeit zu der erfindungsgemäßen intelligenten Peripheriekopplungsbaugruppe **IP** hergestellt werden, was vorzugsweise einfach dadurch geschieht, daß die betreffende Verbindung **ZK, CK** so hergestellt wird, daß eine Kontaktierung (gegebenenfalls eine Durchkontaktierung, auch VIAS genannt) von dem entsprechenden Kontakt - vorzugsweise einer Kontaktfläche **ZK'** - des Bauteileingangs oder -ausgangs der Peripheriekopplungs-Unterbaugruppe **PUG** zu dem entsprechenden Kontakt **ZK"** in der hierfür bestimmten Leiterplattenebene **LO, L1, L2, L3, L4** an dem jeweiligen Rasterplatz **RP,** den die Peripheriekopplungs-Unterbaugruppe **PUG** ganz oder teilweise einnimmt, im Leiterplattenlayout **IP-L** erstellt wird (vgl. hierzu etwa auch Fig. 4 und 5.).

Auf diese Weise kann das einmal erstellte Leiterplattendesign (auch Leiterplattenlayout genannt) in seinen standardisierten Teilen, also für den Microcontroller **MUG** und/oder die programmierbare Logik **PL** und/oder die Netzwerkkopplungs-Unterbaugruppe **N,** sowie hinsichtlich des Konnektorbauelements **I/O-C** zum Anschluß an die Peripheriegeräte **PG** immer wieder unverändert genutzt werden.

Das gleiche gilt für bereits fertig entworfene Peripheriekopplungs-Unterbaugruppen **PUG,** die nur noch platziert zu werden brauchen, was leicht anhand des vorgesehenen Rasters **R** geschehen kann.

Ein neues Routing der Leiterbahnen ist auch hier nicht erforderlich. Die jeweilige Unterbaugruppe **PUG** muß nur an einen oder mehrere Rasterplätze **RP** so ausgerichtet werden, daß die entsprechenden Schnittstellen dort zur Verfügung stehen und eine entsprechende Verbindung **ZK, CK** zur jeweiligen Unterbaugruppe **PUG** etwa vermittels (Durch-)Kontaktierung hergestellt werden kann, wobei die jeweilige Peripheriekopplungs-Unterbaugruppe(n) **PUG** in der Peripheriekopplungs-Unterbaugruppen-Zone **SG** vorzugsweise einen solchen Rasterplatz **RP** oder mehrere solche Rasterplätze **RP** in dem Raster **R** der Peripheriekopplungs-Unterbaugruppen-Zone **SG** ganz oder teilweise einnimmt oder einnehmen.

Bei dem Verfahren zur modularen Erstellung eines Leiterbahnen-Layouts **IP-L** nach der vorliegenden Erfindung wird aus der Computer-Datenbasis der vorerstellten Leiterbahnenlayout-Module **LM** vorzugsweise ein solches Baugruppen-Leiterbahnenlayout **IP-B-L** für die herzustellende intelligente Peripheriekopplungsbaugruppe **IP** ausgewählt, das auch bereits ein Programmierbare-Logik-Leiterbahnenlayout **PL-L** für die Programmierbare Logik **PL** aufweist, soweit diese vorgesehen ist.

Auch kann für jede Peripheriekopplungs-Unterbaugruppe **PUG,** die Bestandteil der herzustellenden intelligenten Peripheriekopplungsbaugruppe **IP** wird, ein zu der jeweiligen Peripheriekopplungs-Unterbaugruppe **PUG** gehöriges Programmierbare-Logik-Teil-Leiterbahnenlayout **PL-TL** für den Teil der programmierbaren Logik **PL,** der für das jeweilige Peripheriekopplungs-Unterbaugruppe(n) **PUG** benötigt wird, aus der Computer-Datenbasis der vorerstellten Leiterbahnenlayout-Module **LM** ausgewählt und in das ausgewählte und in dem Datenspeicher für das Leiterbahnen-Layout **IP-PL-MEM** der herzustellenden intelligenten Peripheriekopplungsbaugruppe **IP** abgelegte Baugruppen-Leiterbahnenlayout **IP-B-L** der herzustellenden intelligenten Peripheriekopplungsbaugruppe **IP** eingefügt werden.

Diese vorzugsweise vorgesehene Verfahrensweise ermöglicht es so, daß durch Einfügung der Programmierbare-Logik-Teil-Leiterbahnenlayouts **PL-TL** in das Leiterbahnen-Layout **IP-L** für die herzustellende intelligente Peripheriekopplungsbaugruppe **IP** auch ein Programmierbare-Logik-Leiterbahnenlayout **PL-L** für die Programmierbare Logik **PL** erstellt wird. Dies ermöglicht es, das Leiterbahnenlayout der Programmierbaren Logik **PL** (soweit eine solche vorgesehen ist) individuell an jeweilig vorgesehene Peripheriekopplungs-Unterbaugruppen **PUG** anzupassen, wobei durchaus auch in diesem Falle bereits ein (Grund-)Leiterbahnenlayout für die Programmierbare Logik **PL** vorgesehen sein kann, das bereits dem Programmierbare-Logik-Leiterbahnenlayout **PL-L** zugeordnet ist, und das durch die den Peripheriekopplungs-Unterbaugruppen **PUG** zugehörigen weiter hinzu tretenden Programmierbare-Logik-Teil-Leiterbahnenlayouts **PL-TL** angepaßt wird.

Auch zeigt die vorliegende Darstellung die Funktionsweise des erfindungsgemäßen computergestützten Verfahrens **BOM** zur Erstellung eines Bauteil-Bestückungsplans **IP-BOM,** der - neben dem Leiterbahnenlayout - ebenfalls zur Herstellung der erfindungsgemäßen intelligenten Peripheriekopplungsbaugruppe **IP** benötigt wird und das von dem vorstehend bereits beschriebenen Verfahren **LAY** zur Erstellung eines Leiterbahnen-Layout **IP-L** nach der vorliegenden Erfindun Gebrauch macht, was in der hier vorliegenden Darstellung durch eine senkrechte zwischen den das jeweilige Verfahren **LAY, BOM** darstellenden Symbolen verlaufende Linie repräsentiert wird, die von dem Symbol zur Darstellung des Bestückungsplanerstellungsverfahrens **BOM** ausgeht und oberhalb an dem Symbol zur Darstellung des Layoutverfahrens **LAY** in einer dortigen länglichen Verdickung der Linie endet, womit zum Ausdruck gebracht wird, daß das eine Verfahren **BOM** das andere Verfahren **LAY** verwendet. In diesem Sinne sind auch die übrigen derartigen Verbindungslinien in vorliegender Darstellung zu verstehen, womit also das Verfahren zur Schaltplanerstellung S, das Verfahren zur Erstellung einer Logik-Programmierung **LO** und das Verfahren zur Erstellung eine Prozeßabbildes für die jeweilige herzustellende intelligente Peripheriekopplungsbaugruppe **IP** alle Gerbrauch von dem Layoutverfahren **LAY** machen und dessen Ergebnis, also das erstellte Layout **IP-L** für ihre weiteren Ergebnisse nutzen.

So wird der Bauteil-Bestückungsplan **IP-BOM** anhand des Leiterbahnen-Layouts **IP-L** und der bei der Erstellung des Leiterbahnen-Layouts **IP-L** ausgewählten Leiterbahnenlayout-Module **IP-B-L, PUG-L** und anhand einer Bauteil-Bestückungsplan-Computer-Datenbasis **BM** die zu dem jeweiligen Leiterbahnenlayout-Modul **IP-B-L, PUG-L** aus der Computer-Datenbasis vorerstellter Leiterbahnenlayout-Module **LM** einen zugehörigen Modul-Bauteil-Bestückungsplan **IP-B-L-BOM, PUG-L-BOM** mit in dem jeweiligen Leiterbahnenlayout-Modul **IP-B-L, PUG-L** verwendeten Bauteil(en) und der Position des jeweiligen Bauteils in dem jeweiligen Leiterbahnenlayout-Modul **IP-B-L, PUG-L** aufweist, erstellt.

Das für die intelligente Peripheriekopplungsbaugruppe **IP** insgesamt erstellte Leiterbahnenlayout **IP-L,** das ja die einzelnen Leiterbahnenlayout-Module **IP-B-L, PUG-L** und deren - etwa durch die bereits vorstehend dargestellte Wahl der Rasterplätze **RP** für die vorgesehenen Peripheriekopplungs-Unterbaugruppen **PUG** in der Peripheriekopplungs-Unterbaugruppen-Zone **SG** gegebene - Lage zueinander aufweist, dient dabei der Umrechnung der für die jeweiligen Leiterbahnenlayout-Module **IP-B-L, PUG-L** aus der Bauteil-Bestückungsplan-Computer-Datenbasis **BM** bekannten relativen Positionen der jeweiligen Bauteile in, für die Herstellung der intelligenten Peripheriekopplungsbaugruppe **IP** - vorzugsweise für einen Bestückungsautomaten -, notwendige absolute Positionsangaben für die zu bestückenden Bauteile. Darüber hinaus enthält die Bauteil-Bestückungsplan-Computer-Datenbasis **BM,** auch die technische Spezifikation, also vorzugsweise etwa den Typ und/oder etwa eine Bauteilnummer oder dergleichen, damit auch bekannt wird, was für ein Bauteil an der ermittelten Position zu bestücken ist.

Dabei werden vorzugsweise auch die Bauteile für das Programmierbare-Logik-Leiterbahnenlayout **PL-L** der Programmierbaren Logik **PL** mit in die Erstellung des Bauteil-Bestückungsplans **IP-BOM** einbezogen, falls eine solche Programmierbare Logik **PL** vorgesehen ist.

Auch das erfindungsgemäße computergestützte Verfahren S zur Erstellung eines Schaltplans **IP-**S für die herzustellende intelligente Peripheriekopplungsbaugruppe **IP** basiert so auf der Verwendung des erfindungsgemäßen Layoutverfahrens **LAY,** indem es anhand des Leiterbahnen-Layouts **IP-L** und der bei der Erstellung des Leiterbahnen-Layouts **IP-L** ausgewählten Leiterbahnenlayout-Module **IP-B-L, PUG-L,** sowie anhand einer Schaltplan-Computer-Datenbasis **SDM,** die zu dem jeweiligen Leiterbahnenlayout-Modul **IP-B-L, PUG-L** aus der Computer-Datenbasis vorerstellter Leiterbahnenlayout-Module **LM** ein zugehöriges Schaltplan-Modul **IP-B-L-S, PUG-L-S** aufweist, den Schaltplan **IP-S** für die herzustellende intelligente Peripheriekopplungsbaugruppe **IP** erstellt, wobei das für die herzustellende intelligente Peripheriekopplungsbaugruppe **IP** erstellte Leiterbahnen-Layout **IP-L** die Zusammensetzung der einzelnen Schaltplan-Modul **IP-B-L-S, PUG-L-S** zum gesamten Schaltplan **IP-S** ermöglicht.

Das erfindungsgemäße computergestützte Verfahren **LO** zur Erstellung einer Logik-Programmierung **IP-LO** einer - etwaig vorhandenen - programmierbaren Logik **PL** für eine herzustellende intelligente Peripheriekopplungsbaugruppe **IP** nach der vorliegenden Erfindung arbeitet in entsprechender Weise.

Es verwendet ebenfalls das erfindungsgemäße Layoutverfahren **LAY** zur Erstellung eines Leiterbahnen-Layout **IP-L.**

Anhand einer Logik-Programmierungs-Modul-Computer-Datenbasis **LOM,** die Logik-Programmierungs-Module **IP-B-LOM, PUG-LOM** enthält und dabei für den ausgewählten Peripheriekopplungsbaugruppengrundtyp **IP-B,** und/oder für jede Peripheriekopplungs-Unterbaugruppe **PUG,** die Bestandteil der herzustellenden intelligenten Peripheriekopplungsbaugruppe **IP** wird und für die die programmierbare Logik **PL** benötigt wird, jeweilig zumindest ein zugehöriges Logik-Programmierungs-Modul **IP-B-LOM, PUG-LOM** für den Teil der programmierbaren Logik **PL,** der für die jeweilige Peripheriekopplungs-Unterbaugruppe(n) (**PUG**) und/oder den ausgewählten Peripheriekopplungsbaugruppengrundtyp **IP-B** benötigt wird, aufweist, wird oder werden für den ausgewählten Peripheriekopplungsbaugruppengrundtyp **IP-B** und/oder für jede Peripheriekopplungs-Unterbaugruppe **PUG,** die Bestandteil der herzustellenden intelligenten Peripheriekopplungsbaugruppe **IP** wird und für die die programmierbare Logik **PL** benötigt wird, das oder die zu der jeweiligen Peripheriekopplungs-Unterbaugruppe **PUG** und/oder zu dem ausgewählten Peripheriekopplungsbaugruppengrundtyp **IP-B** gehörige(n) Logik-Programmierungs-Modul(e) **IP-B-LOM, PUG-LOM** aus der Logik-Programmierungs-Modul-Computer-Datenbasis **LOM** ausgewählt, und dem Inhalt eines Datenspeichers für die Logik-Programmierung **IP-LOM-MEM** der programmierbaren Logik **PL** für die herzustellende intelligente Peripheriekopplungsbaugruppe **IP** hinzugefügt.

Die in dem Datenspeicher für die Logik-Programmierung **IP-LOM-MEM** der programmierbaren Logik **PL** so durch Hinzufügung des jeweiligen Logik-Programmierungs-Moduls **IP-B-LOM, PUG-LOM** entstehende Logik-Programmierung **IP-LO** für die programmierbare Logik **PL** für die herzustellende intelligente Peripheriekopplungsbaugruppe **IP** wird ferner entsprechend dem erstellten Leiterbahnen-Layout **IP-L** für die herzustellende intelligente Peripheriekopplungsbaugruppe **IP** - vorzugsweise entsprechend dem Programmierbare-Logik-Leiterbahnenlayout **PL-L** für die Programmierbare Logik **PL** - angepaßt.

Dem Leiterbahnen-Layout **IP-L** kann dabei vorzugsweise entnommen werden, welche Signale von welcher jeweiligen Peripheriekopplungs-Unterbaugruppe **PUG** auf welcher Leitung der Zonen-Verbindung (**VZC**) zur programmierbaren Logik **PL** hin gehen was die entsprechende Zuordnung der Signale in der Logik-Programmierung **IP-LO** der intelligenten Peripheriekopplungsbaugruppe **IP** und damit deren vorgenannte Anpassung erlaubt.

Auf diese Weise wird die Logik-Programmierung **IP-LO** für die programmierbare Logik **PL** für die herzustellende intelligente Peripheriekopplungsbaugruppe **IP** in dem Datenspeicher für die Logik-Programmierung **IP-LO-MEM** erstellt.

Auch das erfindungsgemäße computergestützte Verfahren zur Erstellung einer Intelligente-Peripheriekopplungsbaugruppe-Prozeßabbild-Struktur **P-PIS** einer herzustellenden intelligenten Peripheriekopplungsbaugruppe **IP,** gemäß der vorliegenden Erfindung (also einer intelligenten Peripheriekopplungsbaugruppe **IP** die einer solchen erfindungsgemäßen intelligenten Peripheriekopplungsbaugruppe **IP** entspricht) verwendet wiederum das erfindungsgemäße Layoutverfahren **LAY** für die Erstellung eines Leiterbahnen-Layout **IP-L.**

Anhand einer Prozeßabbild-Struktur-Computer-Datenbasis **PISD,** die für jede Peripheriekopplungs-Unterbaugruppe **PUG,** die Bestandteil der herzustellenden intelligenten Peripheriekopplungsbaugruppe **IP** wird, eine Peripheriekopplungs-Unterbaugruppen-Prozeßabbild-Struktur **PUG-PI** enthält, mithin also eine Datenstruktur des Prozeßabbilds (vorzugsweise das ([Daten-]Speicher-)Abbild aller schreib- und lesbaren Daten, die dem jeweiligen Zustand der Unterbaugruppe **PUG** entsprechen) der jeweiligen Unterbaugruppe **PUG**, wird für jede Peripheriekopplungs-Unterbaugruppe **PUG,** die Bestandteil der herzustellenden intelligenten Peripheriekopplungsbaugruppe **IP** wird, aus der Prozeßabbild-Struktur-Computer-Datenbasis **PISD** die zugehörige Peripheriekopplungs-Unterbaugruppen-Prozeßabbild-Struktur **PUG-PI** der intelligenten Peripheriekopplungsbaugruppe **IP** ausgewählt und dem Inhalt eines Datenspeichers für die Prozeßabbild-Struktur **IP-PIS-MEM** mit der Intelligente-Peripheriekopplungsbaugruppe-Prozeßabbild-Struktur **IP-PIS** für die herzustellende intelligente Peripheriekopplungsbaugruppe **IP** hinzugefügt.

Anhand des für die herzustellende intelligente Peripheriekopplungsbaugruppe (**IP**) erstellten Leiterbahnen-Layouts **IP-L** erfolgt in der Intelligente-Peripheriekopplungsbaugruppe-Prozeßabbild-Struktur **IP-PIS** eine Datenzuordnung, die die zu jeder Peripheriekopplunge-Unterbaugruppe **PUG** der herzustellenden intelligenten Peripheriekopplungsbaugruppe **IP** zugehörige Peripheriekopplungs-Unterbaugruppen-Prozeßabbild-Struktur **PUG-PI** einem Datenbereich der Intelligente-Peripheriekopplungsbaugruppe-Prozeßabbild-Struktur **IP-PIS** der herzustellenden intelligente Peripheriekopplungsbaugruppe **IP** zuordnet.

Dies ist möglich, weil dem Leiterbahnen-Layout **IP-L** entnommen werden kann, welche Signale von welcher jeweiligen Peripheriekopplungs-Unterbaugruppe **PUG** auf welcher Leitung der Zonen-Verbindung **VZC** zur programmierbaren Logik **PL** hin gehen, was die entsprechende Zuordnung der Signale in der Peripheriekopplungsbaugruppe-Prozeßabbild-Struktur **IP-PIS** der intelligenten Peripheriekopplungsbaugruppe **IP** erlaubt.

So wird die Intelligente-Peripheriekopplungsbaugruppe-Prozeßabbild-Struktur **IP-PIS** der herzustellenden intelligente Peripheriekopplungsbaugruppe **IP** im Datenspeicher für die Prozeßabbild-Struktur **IP-PIS-MEM** erstellt, welche desweiteren vorzugsweise für das erfindungsgemäße computergestützte Verfahren zur Erstellung einer Microcontroller-Programmierung **IP-MP** für eine Microcontroller-Unterbaugruppe **MUG** zum programmierten Betrieb einer herzustellenden intelligenten Peripheriekopplungsbaugruppe **IP** gemäß der vorliegenden Erfindung dient.

Die jeweilige Peripheriekopplungs-Unterbaugruppen-Prozeßabbild-Struktur **PUG-PI** enthält vorzugsweise Einträge über die Austauschrichtung der Daten der jeweiligen Peripheriekopplungs-Unterbaugruppe **PUG,** also besonders bevorzugterweise
Einträge darüber, ob
   - das jeweilige Datum an die Peripheriekopplungs-Unterbaugruppe **PUG** gerichtet ist - vorzugsweise als Output-Datum bezeichnet -, oder ob
   - das jeweilige Datum von der Peripheriekopplungs-Unterbaugruppe **PUG** her kommt - vorzugsweise als Input-Datum bezeichnet-, oder ob
   - das jeweilige Datum sowohl an die Peripheriekopplungs-Unterbaugruppe **PUG** gerichtet ist, als auch von der Peripheriekopplungs-Unterbaugruppe **PUG** her kommt - vorzugsweise als Input/Output-Datum bezeichnet -, und/oder
Einträge über die physikalische Bedeutung der jeweiligen Daten der jeweiligen Peripheriekopplungs-Unterbaugruppe **PUG** - vorzugsweise für das Datum zulässige Wertebereiche und/oder verwendete physikalische Meßeinheiten, wie etwa Volt oder Ampere oder Hertz, und/oder
Einträge über die technische Bedeutung der jeweiligen Daten der jeweiligen Peripheriekopplungs-Unterbaugruppe **PUG** für das mithilfe der jeweiligen Peripheriekopplungs-Unterbaugruppe **PUG** gesteuerte und/oder geregelte und/oder überwachte Peripheriegerät **PG** - vorzugsweise für das jeweilige Datum zulässige Wertebereiche und/oder am Peripheriegerät **PG** verwendete technische Einheiten, wie etwa Öldruck in Pascal oder bar oder etwa auch die Hubhöhe in mm oder cm oder etwa auch in m -.

Die zur jeweiligen Peripheriekopplungs-Unterbaugruppe **PUG** der intelligenten Peripheriekopplungsbaugruppe **IP** gehörige Peripheriekopplungs-Unterbaugruppen-Prozeßabbild-Struktur **PUG-PI** wird vorzugsweise auch mit diesen Einträgen mit in die in dem Datenspeicher für die Prozeßabbild-Struktur **IP-PIS-MEM** hinterlegte Intelligente-Peripheriekopplungsbaugruppe-Prozeßabbild-Struktur **IP-PIS** der herzustellenden intelligenten Peripheriekopplungsbaugruppe **IP** aufgenommen.

Auch ist das erfindungsgemäße computergestütztes Verfahren **MP** zur Erstellung einer Microcontroller-Programmierung **IP-MP** für eine Microcontroller-Unterbaugruppe **MUG** zum programmierten Betrieb einer herzustellenden intelligenten Peripheriekopplungsbaugruppe **IP** gemäß der vorliegenden Erfindung hier schematisch dargestellt.

Hierbei wird das erfindungsgemäße Verfahren zur Erstellung einer Intelligente-Peripheriekopplungsbaugruppe-Prozeßabbild-Struktur **IP-PIS** für die herzustellende intelligente Peripheriekopplungsbaugruppe **IP** verwendet, was vorliegend wiederum durch eine entsprechende Linie vom **MP** nach **PI** zum Ausdruck kommt.

Vermittels einer Microcontroller-Programmierungs-Modul-Computer-Datenbasis **MPD**, die Microcontroller-Programmierungs-Module **IP-B-MP**, **PUG-MP** enthält und dabei für den ausgewählten Peripheriekopplungsbaugruppengrundtyp **IP-B** und/oder für jede Peripheriekopplungs-Unterbaugruppe **PUG,** die Bestandteil der herzustellenden intelligenten Peripheriekopplungsbaugruppe **IP** wird, jeweilig ein zugehöriges Microcontroller-Programmierungs-Modul **IP-B-MP**, **PUG-MP**, das zum programmierten Betrieb der jeweiligen Peripheriekopplungs-Unterbaugruppe(n) (**PUG**) durch die Microcontroller-Unterbaugruppe **MUG** und/oder des ausgewählten Peripheriekopplungsbaugruppengrundtyp **IP-B** benötigt wird, aufweist, wird für den ausgewählten Peripheriekopplungsbaugruppengrundtyp **IP-B** und/oder für jede Peripheriekopplungs-Unterbaugruppe **PUG,** die Bestandteil der herzustellenden intelligenten Peripheriekopplungsbaugruppe **IP** wird, das oder die zu der jeweiligen Peripheriekopplungs-Unterbaugruppe **PUG** und/oder zu dem ausgewählten Peripheriekopplungsbaugruppengrundtyp **IP-B** gehörige(n) Microcontroller-Programmierungs-Modul(e) **IP-B-MP**, **PUG-MP** aus der Microcontroller-Programmierungs-Modul-Computer-Datenbasis **MPD** ausgewählt und dem Inhalt eines Datenspeichers für die Microcontroller-Programmierung **IP-MP-MEM** der herzustellenden intelligenten Peripheriekopplungsbaugruppe **IP** hinzugefügt.

Die in dem Datenspeicher für die Microcontroller-Programmierung **IP-MP-MEM** so durch Hinzufügung des jeweiligen Microcontroller-Programmierungs-Moduls **IP-B-MP**, **PUG-MP** entstehende Microcontroller-Programmierung **IP-MP** für die herzustellende intelligente Peripheriekopplungsbaugruppe **IP** wird entsprechend der Datenzuordnung aus der Peripheriekopplungsbaugruppe-Prozeßabbild-Struktur **IP-PIS** für die herzustellende intelligente Peripheriekopplungsbaugruppe **IP** so angepaßt, daß das der jeweiligen Peripheriekopplungs-Unterbaugruppe **PUG** zugehörige Microcontroller-Programmierungs-Modul **PUG-MP** auf dem jeweiligen Datenbereich des Prozeßabbilds der herzustellenden intelligenten Peripheriekopplungsbaugruppe **IP** operiert (also auf diesem Datenbereich arbeitet, mithin also die Daten in diesem Datenbereich verarbeitet), der die Daten der jeweiligen Peripheriekopplungs-Unterbaugruppe **PUG** aufweist.

Auf diese Weise wird die Microcontroller-Programmierung **IP-MP** zum programmierten Betrieb der herzustellenden intelligenten Peripheriekopplungsbaugruppe **IP** in dem Datenspeicher für die Microcontroller-Programmierung **IP-MP-MEM** erstellt.

Es sei darauf hingewiesen, daß die hier erwähnten jeweiligen Computer-Datenbasen **LM**, **BM**, **SDM**, **LOM**, **PISD** und **MPD** als jedwede Art einer von einem Computer aus automatisch zugreifbare (vorzugsweise beschreibbare und/oder lesbare) Datenbasis, also etwa als Datenbank, als Datei(en) oder dergleichen - vorzugsweise auf einem Massenspeicher wie einer Magnetplatte oder einer optischen Platte oder einer sogenannten SSD (Solid State Disk), aber auch in einem ausreichend großen Arbeitsspeicher eines Computers abgelegt - realisiert sein können. Auch können sie in einem Speicher des Computers selbst oder auch abgesetzt von diesem in einem über ein Netzwerk zugreifbaren Speicher, etwa in einer sogenannten Cloud (Datenwolke) hinterlegt sein.

Die Datenbasen **LM**, **BM**, **SDM**, **LOM**, **PISD** und **MPD** können voneinander logisch oder physikalisch getrennt vorliegen, aber vorzugsweise auch gemeinsam als eine Datenbasis vorliegen, was in vorliegender Darstellung durch eine die (logischen) Datenbasen **LM, BM, SDM, LOM, PISD** und **MPD** erfassende gestrichelte Umfassung U angedeutet wird. Auch können Teile der Datenbasen **LM, BM, SDM, LOM, PISD** und **MPD** als eine Datenbasis vorliegen. Für die vorliegende Erfindung kommt es lediglich darauf an, daß die für das jeweilige erfindungsgemäße Verfahren **LAY, BOM, S, LO, PI** oder **MP** jeweilig benötigte Datenbasis **LM, BM, SDM, LOM, PISD** und **MPD** mit ihren für die Durchführung des jeweiligen Verfahrens **LAY, BOM, S, LO, PI** oder **MP** benötigten Dateninhalten **IP-B-L, PL-L, PUG-L, PL-TL, IP-B-L-BOM, PUG-L-BOM, IP-B-L-S, PUG-L-S, IP-B-LOM, PUG-LOM, PUG-PI, IP-B-MP, PUG-MP** zur automatischen Verarbeitung zur Verfügung steht.

Auch können die vorgenannten erfindungsgemäßen Verfahren desweiteren zur Vorbereitung der computergestützten Ermittlung des sogenannten MTBF-Wertes (Mean Time Between Failure, also der mittleren Zeit zwischen zwei Fehlerereignissen für reparable Baugruppen) oder des sogenannten MTTF-Wertes (Mean Time To Failure, also der mittleren Zeitspanne bis zum Fehlerereignis für nicht reparable Baugruppen) oder auch zur computergestützten Ermittlung der sogenannten EMV (Elektromagnetischen Verträglichkeit) dienen.

Fig. **11** zeigt ein schematisches Diagramm betreffend die Funktionsweise jeweilig bevorzugter Ausführungsformen des computergestützten Verfahren **MAN** nach der vorliegenden Erfindung zur Herstellung einer erfindungsgemäßen intelligenten Peripheriekopplungsbaugruppe **IP.**

Das erfindungsgemäße computergestützte Verfahren zur Herstellung **MAN** einer intelligenten Peripheriekopplungsbaugruppe **IP** gemäß der vorliegenden Erfindung verwendet
- das erfindungsgemäße Verfahren **LAY** zur Erstellung eines Leiterbahnen-Layout **IP-L** und
- das erfindungsgemäße Verfahren **BOM** zur Erstellung eines Bauteil-Bestückungsplans **IP-BOM,**
wobei sodann vermittels des für die herzustellende intelligente Peripheriekopplungsbaugruppe **IP** erstellten Leiterbahnen-Layouts **IP-L** und des für die herzustellende intelligente Peripheriekopplungsbaugruppe **IP** erstellten Bauteil-Bestückungsplans **IP-BOM** die intelligente Peripheriekopplungsbaugruppe **IP** hergestellt wird, was vorzugsweise durch ein (teil-) automatisiertes Verfahren **M** zur (physischen)Leiterplattenherstellung und Leiterplattenbestückung, etwa mithilfe eines Bestückungsautomaten geschieht.

Weist die herzustellende intelligente Peripheriekopplungsbaugruppe **IP** eine programmierbare Logik **PL** auf, so umfaßt das erfindungsgemäße Herstellungsverfahren **MAN** vorzugsweise auch die Verwendung des Verfahrens **LO** zur erfindungsgemäßen Erstellung einer Logik-Programmierung **IP-LO,** die auf der intelligenten Peripheriekopplungsbaugruppe **IP** befindliche programmierbare Logik **PL** mittels der in dem Datenspeicher **IP-LOM-MEM** für die programmierbare Logik **PL** erstellten Programmierung **IP-LOM** programmiert wird.

Ist eine Microcontroller-Unterbaugruppe **MUG** zum programmierten Betrieb der herzustellenden intelligenten Peripheriekopplungsbaugruppe **IP** vorgesehen, so wird vorzugsweise mittels des - bereits beschriebenen ( vgl. etwa Fig. 10) - erfindungsgemäßen Verfahrens **MP** auch eine Microcontroller-Programmierung **IP-MP** zum programmierten Betrieb der herzustellenden intelligenten Peripheriekopplungsbaugruppe **IP** in dem Datenspeicher für die Microcontroller-Programmierung **IP-MP-MEM** erstellt, vermittels derer die Microcontroller-Unterbaugruppe **MUG** programmiert wird.

Nicht unerwähnt soll in diesem Zusammenhang bleiben, daß das erfindungsgemäße Verfahren **MP** auch die Verwendung des Verfahrens **PI** zur erfindungsgemäßen Erstellung einer hinterlegten Intelligente-Peripheriekopplungsbaugruppe-Prozeßabbild-Struktur **IP-PIS** erfordert, wie bereits ebenfalls zu Fig. 10 erläutert.

In diesem Zusammenhang ist wiederum zu erwähnen, daß die Microcontroller-Unterbaugruppe **MUG** auch innerhalb der programmierbaren Logik **PL** vorliegen kann, etwa dann, wenn als programmierbare Logik **PL** ein sogenanntes PLD (sogenannte Programmable Logic Device), etwa ein CPLD (sogenanntes Complex Programmable Logic Device), oder ein FPGA (sogenanntes Field Programmable Gate Array) vorliegt, die es jeweils erlauben, einen Microcontroller auch als Logik-Programmierung **IP-LO** innerhalb der programierbaren Logik zu realisieren. Insbesondere für FPGAs sind solche als Logik-Programmierung **IP-LO** realisierte Microcontroller bereits heute vielfältig verfügbar. In einem solchen Fall ist dann eine Microcontroller-Unterbaugruppe **MUG** vorhanden, alledings ohne, daß sie - abgesehen von der programmierbaren Logik **PL** - eigenständiger Hardare bedürfte. Auch ist in diesem Fall selbstverständlich keine eigene Zone für die Microcontroller-Unterbaugruppe **MUG** auf der intelligenten Peripheriekopplungsbaugruppe **IP** erforderlich. Vielmehr liegt die Microcontroller-Unterbaugruppe **MUG** dann in der durch die programmierbare Logik **PL** belegten Zone der intelligenten Peripheriekopplungsbaugruppe **IP.**

Fig. **12** zeigt ein schematisches Diagramm betreffend die Funktionsweise einer bevorzugten Ausführungsform des computergestützten Verfahren nach der vorliegenden Erfindung zur Konfiguration **CONFIG** eines datennetzwerkbasierten Systems **CONSYS** zur Steuerung und/oder Regelung und/oder Überwachung von drei Peripheriegeräten **PG** durch ein - vorzugsweise zentrales - Steuergerät **CON** mittels Datenübertragung zwischen Teilnehmern **CON, IP** eines Datennetzwerks **DN** , bei dem zwei erfindungsgemäße intelligente Peripheriekopplungsbaugruppen **IP** als Teilnehmer mit dem Datennetzwerk **DN** verbunden sind und der Steuerung und/oder Regelung und/oder Überwachung von frei Peripheriegeräten **PG** - vorzugsweise Landmaschinen oder Baumaschinen - dienen.

Das Steuergerät **CON,** das als Teilnehmer mit dem Datennetzwerk **DN** verbunden ist, weist eine Steuergerät-Netzwerkkopplungs-Unterbaugruppe zur Kopplung des Steuergeräts an das Datennetzwerk **DN**, zumindest einen Prozessor und mindestens einen Speicher auf. Vorzugsweise ist es als (Master-)Steuergerät aussgeführt, das wiederum ein Bedienterminal aufweisen kann, welches etwa über einen ISOBUS (vgl. ISO 11783) zur Steuerung und/oder Regelung und/oder Überwachung (etwa auch Visualisierung) der Prozesse (etwa der Peripheriegeräte) verbunden ist. Für ein solches Steuergerät steht dabei vorzugsweise eine Entwicklungsumgebung (etwa eine Programmierungsumgebung) mit einem Personal Computer **PC** zur Verfügung. auf dem auch das vorliegende erfindungsgemäße Konfigurationsverfahren **CONFIG** ausgeführt werden kann. Das Steuergerät steuert und/oder regelt und/oder überwacht das mit der jeweiligen Peripheriekopplungs-Unterbaugruppe **PUG** gekoppelte Peripheriegerät **PG** mit einem zu der jeweiligen Peripheriekopplungs-Unterbaugruppe **PUG** gehörigen in dem Speicher des Steuergeräts hinterlegten jeweiligen Softwaresteuer-Modul **PUG-SSM** vermittels der Übertragung eines Prozeßabbildes über das Datennetzwerk **DN,** wobei das Prozeßabbild in einem der jeweiligen intelligenten Peripheriekopplungsbaugruppe **IP** zugehörigen Datenbereich einer ebenfalls im Speicher des Steuergeräts **CON** hinterlegten Intelligente-Peripheriekopplungsbaugruppe-Prozeßabbild-Struktur **IP-PIS** entspricht, die zu der intelligenten Peripheriekopplungsbaugruppe **IP** gehört, die die jeweilige zur Steuerung und/oder zur Regelung und/oder zur Überwachung des Peripheriegeräts **PG** dienende Peripheriekopplungs-Unterbaugruppe **PUG** aufweist.

Anhand einer Peripheriekopplungs-Unterbaugruppen-Computer-Datenbasis **PUGDB,** die zu der jeweiligen Peripheriekopplungs-Unterbaugruppe **PUG** eine technische Peripheriekopplungs-Unterbaugruppen-Spezifikation **PUG-TS** bereitstellt, die zumindest die Größe der jeweiligen Peripheriekopplungs-Unterbaugruppe **PUG** in benötigten Rasterplätzen **RP** in dem Raster der Peripheriekopplungs-Unterbaugruppen-Zone **SG** der jeweiligen intelligenten Peripheriekopplungsbaugruppe **IP** aufweist, wurden hier drei Peripheriekopplungs-Unterbaugruppen **PUG** ausgewählt, die Bestandteil des zu konfigurierenden intelligenten datennetzwerkbasierten Systems **CONSYS** zur Steuerung und/oder Regelung und/oder Überwachung wurden.

Anhand einer Computer-Datenbasis intelligenter Peripheriekopplungsbaugruppen **IPDB,** der eine Peripheriekopplungsbaugruppen-Spezifikation **IP-SPEC** zu entnehmen ist, die zumindest angibt, welche Peripheriekopplungs-Unterbaugruppen **PUG** die jeweilige Peripheriekopplungsbaugruppe **IP** in der Peripheriekopplungs-Unterbaugruppen-Zone **SG** mit dem Raster **R** mit den mehreren Rasterplätzen **RP** aufzunehmen in der Lage ist, wurden hier die drei ausgewählten Peripheriekopplungs-Unterbaugruppen **PUG** auf zwei intelligente Peripheriekopplungsbaugruppen **IP** zur Aufnahme verteilt **D,** und für beide der so zur Aufnahme der drei Peripheriekopplungs-Unterbaugruppen **PUG** vorgesehenen intelligenten Peripheriekopplungsbaugruppen **IP** je eine Intelligente-Peripheriekopplungsbaugruppe-Prozeßabbild-Struktur **IP-PIS** nach dem bereits vorstehend erläuterten erfindungsgemäßen Verfahren ermittelt und vorzugsweise in einer Datei **PIS-D** des Personal Computers **PC** der Entwicklungsumgebung abgespeichert.

Anhand einer Peripheriekopplungs-Unterbaugruppen-Softwaremodul-Computer-Datenbasis **SSMDB,** die zu Peripheriekopplungs-Unterbaugruppen **PUG** gehörige Softwaresteuer-Module **PUG-SSM** aufweist, wurde für jede Peripheriekopplungs-Unterbaugruppe **PUG,** die Bestandteil des zu konfigurierenden intelligenten datennetzwerkbasierten Systems **CONSYS** zur Steuerung und/oder Regelung und/oder Überwachung wird, das zur jeweiligen Peripheriekopplungs-Unterbaugruppe **PUG** gehörige Softwaresteuer-Modul **PUG-SSM** ausgewählt.

In dem Speicher des Steuergerätes **CON** wurden die beiden ermittelten Intelligente-Peripheriekopplungsbaugruppe-Prozeßabbild-Strukturen **IP-PIS** der beiden zur Aufnahme von Peripheriekopplungs-Unterbaugruppen **PUG** vorgesehenen intelligenten Peripheriekopplungsbaugruppe **IP** und die ausgewählten, zu drei Peripheriekopplungs-Unterbaugruppen **PUG** zugehörigen Softwaresteuer-Module **PUG-SSM** hinterlegt, die hier vorliegend Bestandteil des zu konfigurierenden intelligenten datennetzwerkbasierten Systems **CONSYS** zur Steuerung und/oder Regelung und/oder Überwachung wurden. Die Hinterlegung kann etwa dadurch geschehen, das die Softwaresteuer-Module **PUG-SSM** und/oder die jeweiligen Intelligente-Peripheriekopplungsbaugruppe-Prozeßabbild-Strukturen **IP-PIS** der an das Datennetzwerk **DN** als Teilnehmer angekoppelten intelligenten Peripheriekopplungsbaugruppen **IP** von dem Personal Computer **PC** der Entwicklungsumgebung in den Speicher des Steuergerätes **CON** geladen werden, der vorzugsweise als sogenannter Flash-Speicher, also als ladbarer nicht-flüchtiger Speicher ausgestaltet ist.

Die verwendeten beiden intelligenten Peripheriekopplungsbaugruppen **IP** können ebenfalls mit der vorliegenden Erfindung hergestellt werden, so daß hier ein Beispiel eines durchgängig modular erstellten bzw. konfigurierten Steuer-/Regel-Überwachungssystems **CONSYS** zu sehen ist.

Für die hier zu sehenden Computer-Datenbasen **PUGDB, IPDB, SSMDB** gilt das für die Datenbasen in der Besprechung von Fig. 10 bereits Gesagte in entsprechender Weise, was auch hier durch die Umfassung U angedeutet ist.

## Patentansprüche

1. Intelligente Peripheriekopplungsbaugruppe (**IP**), die auf einer Platine mit zumindest einer Leiterbahnenschicht Unterbaugruppen aufweist, wobei
eine Netzwerkkopplungs-Unterbaugruppe (**N**) zur Kopplung der Peripheriekopplungsbaugruppe (**IP**) an zumindest ein - vorzugsweise zentrales - Steuergerät (**CON**) über ein Datennetzwerk (**DN**), sowie
in einer Peripheriekopplungs-Unterbaugruppen-Zone (**SG**) der Platine ein Bereich für eine oder mehrere Peripheriekopplungs-Unterbaugruppe(n) (**PUG**) zur Kopplung mit zumindest dem einen zu steuernden und/oder zu regelnden und/oder zu überwachenden Peripheriegerät (**PG**) und
zumindest ein Konnektorbauelement (**I/O-C**) zur elektrischen oder optischen oder drahtlosen Verbindung der Peripheriekopplungs-Unterbaugruppe(n) (**PUG**) mit dem oder den Peripheriegerät(en) (**PG**)
vorgesehen ist, wobei
die Netzwerkkopplungs-Unterbaugruppe (**N**) eine Zonen-Verbindung (**VZC**) als elektrische Verbindung über eine oder mehrere Leitung(en) mit der oder den Peripheriekopplungs-Unterbaugruppe(n) (**PUG**) in der Peripheriekopplungs-Unterbaugruppen-Zone (**SG**) aufweist, die der Ansteuerung der Peripheriekopplungs-Unterbaugruppe(n) (**PUG**) dient und
die Peripheriekopplungs-Unterbaugruppe(n) (**PUG**) in der Peripheriekopplungs-Unterbaugruppen-Zone (**SG**) jeweils eine Konnektorbaulement-Verbindung (**VSC**) zur elektrischen Verbindung über eine oder mehrere Leitung(en) mit einem oder mehreren Pin(s) (**P**) des Konnektorbauelements (**I/O-C**) aufweist,
**dadurch gekennzeichnet, daß**
die Peripheriekopplungs-Unterbaugruppe(n) (**PUG**) in der Peripheriekopplungs-Unterbaugruppen-Zone (**SG**) an einem Raster (**R**) mit mehreren Rasterplätzen (**RP**) ausgerichtet ist oder sind, wobei
zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine eine oder mehrere Leitung(en) der Zonen-Verbindung (**VZC**) zugeordnet ist oder sind, mit der die jeweilige Peripheriekopplungs-Unterbaugruppe (**PUG**) über eine oder mehrere Kontaktierung(en) (**ZK**) elektrisch verbunden werden kann, und
zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine eine oder mehrere Leitung(en) der Konnektorbaulement-Verbindung (**VSC**) zugeordnet ist oder sind, mit der die jeweilige Peripheriekopplungs-Unterbaugruppe (**PUG**) über eine oder mehrere Kontaktierung(en) (**CK**) elektrisch verbunden werden kann.

2. Intelligente Peripheriekopplungsbaugruppe (**IP**) nach Anspruch 1, **dadurch gekennzeichnet, daß** die Netzwerkkopplungs-Unterbaugruppe (**N**) eine anwendungsspezifische integrierte Schaltung mit digitalen Ein- und/oder Ausgängen aufweist, die in Abhängigkeit der über das Datennetzwerk (**DN**) zum - vorzugsweise zentralen - Steuergerät (**CON**) hin empfangenen und/oder gesendeten Daten gesetzt oder eingelesen werden können.

3. Intelligente Peripheriekopplungsbaugruppe (**IP**), die auf einer Platine mit zumindest einer Leiterbahnenschicht Unterbaugruppen aufweist, wobei
eine Microcontroller-Unterbaugruppe (**MUG**) zum programmierten Betrieb der Peripheriekopplungsbaugruppe (**IP**), sowie
in einer Peripheriekopplungs-Unterbaugruppen-Zone (**SG**) der Platine ein Bereich für eine oder mehrere Peripheriekopplungs-Unterbaugruppe(n) (**PUG**) zur Kopplung mit zumindest dem einen zu steuernden und/oder zu regelnden und/oder zu überwachenden Peripheriegerät (**PG**) und
zumindest ein Konnektorbauelement (**I/O-C**) zur elektrischen oder optischen oder drahtlosen Verbindung der Peripheriekopplungs-Unterbaugruppe(n) (**PUG**) mit dem oder den Peripheriegerät(en) (**PG**)
vorgesehen ist, wobei
die Microcontroller-Unterbaugruppe (**MUG**) eine Zonen-Verbindung (**VZC**) als elektrische Verbindung über eine oder mehrere Leitung(en) mit der oder den Peripheriekopplungs-Unterbaugruppe(n) (**PUG**) in der Peripheriekopplungs-Unterbaugruppen-Zone (**SG**) aufweist, die der Ansteuerung der Peripheriekopplungs-Unterbaugruppe(n) (**PUG**) dient und
die Peripheriekopplungs-Unterbaugruppe(n) (**PUG**) in der Peripheriekopplungs-Unterbaugruppen-Zone (**SG**) jeweils eine Konnektorbaulement-Verbindung (**VSC**) zur elektrischen Verbindung über eine oder mehrere Leitung(en) mit einem oder mehreren Pin(s) (**P**) des Konnektorbauelements (**I/O-C**) aufweist,
**dadurch gekennzeichnet, daß**
die Peripheriekopplungs-Unterbaugruppe(n) (**PUG**) in der Peripheriekopplungs-Unterbaugruppen-Zone (**SG**) an einem Raster (**R**) mit mehreren Rasterplätzen (**RP**) ausgerichtet ist oder sind, wobei
zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine eine oder mehrere Leitung(en) der Zonen-Verbindung (**VZC**) zugeordnet ist oder sind, mit der die jeweilige Peripheriekopplungs-Unterbaugruppe (**PUG**) über eine oder mehrere Kontaktierung(en) (**ZK**) elektrisch verbunden werden kann, und
zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine eine oder mehrere Leitung(en) der Konnektorbaulement-Verbindung (**VSC**) zugeordnet ist oder sind, mit der die jeweilige Peripheriekopplungs-Unterbaugruppe (**PUG**) über eine oder mehrere Kontaktierung(en) (**CK**) elektrisch verbunden werden kann.

4. Intelligente Peripheriekopplungsbaugruppe (**IP**), die auf einer Platine mit zumindest einer Leiterbahnenschicht Unterbaugruppen aufweist, wobei
eine programmierbare Logik (**PL**) zur Anschaltung an eine oder mehrere Peripheriekopplungs-Unterbaugruppe(n) (**PUG**), die der Kopplung mit zumindest einem zu steuernden und/oder zu regelnden und/oder zu überwachenden Peripheriegerät (**PG**) dienen, sowie
in einer Peripheriekopplungs-Unterbaugruppen-Zone (**SG**) der Platine ein Bereich für die Peripheriekopplungs-Unterbaugruppe(n) (**PUG**) zur Kopplung mit zumindest dem einen zu steuernden und/oder zu regelnden und/oder zu überwachenden Peripheriegerät (**PG**) und zumindest ein Konnektorbauelement (**I/O-C**) zur elektrischen oder optischen oder drahtlosen Verbindung der Peripheriekopplungs-Unterbaugruppe(n) (**PUG**) mit dem oder den Peripheriegerät(en) (**PG**)
vorgesehen ist, wobei
die programmierbare Logik (**PL**) eine Zonen-Verbindung (**VZC**) als elektrische Verbindung über eine oder mehrere Leitung(en) mit der oder den Peripheriekopplungs-Unterbaugruppe(n) (**PUG**) in der Peripheriekopplungs-Unterbaugruppen-Zone (**SG**) aufweist, die der Ansteuerung der Peripheriekopplungs-Unterbaugruppe(n) (**PUG**) dient und
die Peripheriekopplungs-Unterbaugruppe(n) (**PUG**) in der Peripheriekopplungs-Unterbaugruppen-Zone (**SG**) jeweils eine Konnektorbaulement-Verbindung (**VSC**) zur elektrischen Verbindung über eine oder mehrere Leitung(en) mit einem oder mehreren Pin(s) (**P**) des Konnektorbauelements (**I/O-C**) aufweist,
**dadurch gekennzeichnet, daß**
die Peripheriekopplungs-Unterbaugruppe(n) (**PUG**) in der Peripheriekopplungs-Unterbaugruppen-Zone (**SG**) an einem Raster (**R**) mit mehreren Rasterplätzen (**RP**) ausgerichtet ist oder sind, wobei
zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine eine oder mehrere Leitung(en) der Zonen-Verbindung (**VZC**) zugeordnet ist oder sind, mit der die jeweilige Peripheriekopplungs-Unterbaugruppe (**PUG**) über eine oder mehrere Kontaktierung(en) (**ZK**) elektrisch verbunden werden kann, und
zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine eine oder mehrere Leitung(en) der Konnektorbaulement-Verbindung (**VSC**) zugeordnet ist oder sind, mit der die jeweilige Peripheriekopplungs-Unterbaugruppe (**PUG**) über eine oder mehrere Kontaktierung(en) (**CK**) elektrisch verbunden werden kann.

5. Intelligente Peripheriekopplungsbaugruppe (**IP**) aufweisend
eine intelligente Peripheriekopplungsbaugruppe nach Anpruch 1 oder 2,
und/oder eine intelligente Peripheriekopplungsbaugruppe nach Anpruch 3,
und/oder eine intelligente Peripheriekopplungsbaugruppe nach Anpruch 4,
**dadurch gekennzeichnet, daß** auf der Platine verschiedene für die Unterbaugruppen vorgesehene Zonen (**A**, **M**, **L**) angeordnet sind, wobei
die Netzwerkkopplungs-Unterbaugruppe (**N**) in einer ersten Zone (**A**) der Platine,
die Microcontroller-Unterbaugruppe (**MUG**) in einer zweiten Zone (**M**) der Platine, und
die programmierbare Logik (**PL**) in einer dritten Zone (**L**) der Platine
vorgesehen ist.

6. Intelligente Peripheriekopplungsbaugruppe (**IP**) nach Anspruch 5, **dadurch gekennzeichnet, daß** zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine alle Leitungen der Zonen-Verbindung (**VZC**) zugeordnet sind, mit der die jeweilige Peripheriekopplungs-Unterbaugruppe (**PUG**) über eine oder mehrere Kontaktierung(en) (**ZK**) elektrisch verbunden werden kann.

7. Intelligente Peripheriekopplungsbaugruppe (**IP**) nach einem der Ansprüche 5 oder 6, **dadurch gekennzeichnet, daß** zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine alle Leitungen der Konnektorbaulement-Verbindung (**VSC**) zugeordnet sind, mit der die jeweilige Peripheriekopplungs-Unterbaugruppe (**PUG**) über eine oder mehrere Kontaktierung(en) (**CK**) elektrisch verbunden werden kann.

8. Intelligente Peripheriekopplungsbaugruppe (**IP**) nach einem der Ansprüche 5 bis 7, **dadurch gekennzeichnet, daß** zumindest ein Rasterplatz (**RP**) in dem Raster (**R**) der Peripheriekopplungs-Unterbaugruppen-Zone (**SG**) vorgesehen ist, den eine Peripheriekopplungs-Unterbaugruppe (**PUG**) ganz oder teilweise einnehmen kann, dem in zumindest einer hierfür vorbestimmten Leiterbahnschicht (**LO**, **L1**, **L2**, **L3**, **L4**) der Platine genau eine einzige Leitung der Konnektorbauelement-Verbindung (**VSC**) zugeordnet ist, mit der die jeweilige Peripheriekopplungs-Unterbaugruppe (**PUG**) über eine einzige Kontaktierung (**CK**) elektrisch verbunden werden kann.

9. Intelligente Peripheriekopplungsbaugruppe (**IP**) nach einem der Ansprüche 5 bis 8, **dadurch gekennzeichnet, daß** die Peripheriekopplungs-Unterbaugruppe(n) (**PUG**) in der Peripheriekopplungs-Unterbaugruppen-Zone (**SG**) einen Rasterplatz (**RP**) oder mehrere Rasterplätze (**RP**) in dem Raster (**R**) der Peripheriekopplungs-Unterbaugruppen-Zone (**SG**) ganz oder teilweise einnimmt oder einnehmen.

10. Intelligente Peripheriekopplungsbaugruppe (**IP**) nach einem der Ansprüche 5 bis 9, **dadurch gekennzeichnet, daß** das Raster (**R**) der Peripheriekopplungs-Unterbaugruppen-Zone (**SG**) so aufgebaut ist, daß die Rasterplätze (**RP**) schachbrettartig angeordnet sind.

11. Intelligente Peripheriekopplungsbaugruppe (**IP**) nach einem der Ansprüche 5 bis 10, **dadurch gekennzeichnet, daß** die Leitung(en) der Zonen-Verbindung (**VZC**), die die programmierbare Logik (**PL**) und/oder die Microcontroller-Unterbaugruppe (**MUG**) und/oder die Netzwerckopplungs-Unterbaugruppe (**N**) mit der oder den Peripheriekopplungs-Unterbaugruppe(n) (**PUG**) in der Peripheriekopplungs-Unterbaugruppen-Zone (**SG**) verbindet oder verbinden in maximal zwei Leiterbahnenschichten der Platine angeordnet sind.

12. Intelligente Peripheriekopplungsbaugruppe (**IP**) nach einem der Ansprüche 5 bis 11, **dadurch gekennzeichnet, daß** die Leitung(en) der Konnektorbaulement-Verbindung (**VSC**), die die Peripheriekopplungs-Unterbaugruppe(n) (**PUG**) in der Peripheriekopplungs-Unterbaugruppen-Zone (**SG**) mit einem oder mehreren Pin(s) (**P**) des Konnektorbauelements (**I/O-C**) verbindet oder verbinden in maximal zwei Leiterbahnenschichten der Platine angeordnet sind.

13. Intelligente Peripheriekopplungsbaugruppe (**IP**) nach Anspruch 11 und 12, **dadurch gekennzeichnet, daß** die Leitung(en) der Zonen-Verbindung (**VZC**) und die Leitung(en) der Konnektorbaulement-Verbindung (**VSC**) in derselben oder denselben beiden Leiterbahnenschichten der Platine angeordnet sind.

14. Intelligente Peripheriekopplungsbaugruppe (**IP**) nach einem der Ansprüche 5 bis 13, **dadurch gekennzeichnet, daß** als Datennetzwerk (**DN**) ein - vorzugsweise echtzeitfähiger - Feldbus, vorzugsweise ein sogenanntes Industrial Ethernet, vorgesehen ist.

15. Computergestütztes Verfahren zur modularen Erstellung eines Leiterbahnen-Layouts (**IP-L**) für eine herzustellende intelligente Peripheriekopplungsbaugruppe (**IP**) gemäß einem der Ansprüche 5 bis 14, bei dem
aus einer Computer-Datenbasis von vorerstellten Leiterbahnenlayout-Modulen (**LM**) ein Baugruppen-Leiterbahnenlayout (**IP-B-L**) mit einem zugehörigen Peripheriekopplungsbaugruppengrundtyp (**IP-B**) für die herzustellende intelligente Peripheriekopplungsbaugruppe (**IP**) ausgewählt und in einem Datenspeicher für das Leiterbahnen-Layout (**IP-L-MEM**) der herzustellenden intelligente Peripheriekopplungsbaugruppe (**IP**) abgelegt wird, wobei das ausgewählte Baugruppen-Leiterbahnenlayout (**IP-B-L**) für die herzustellende intelligente Peripheriekopplungsbaugruppe (**IP**)
ein Netzwerkkopplungs-Unterbaugruppen-Leiterbahnenlayout für die Netzwerkkopplungs-Unterbaugruppe (**N**), und/oder
ein Microcontroller-Unterbaugruppen-Leiterbahnenlayout für die Mikrocontroller-Unterbaugruppe (**MUG**), und
ein Peripheriekopplungs-Unterbaugruppen-Zonen-Leiterbahnenlayout für die Peripheriekopplungs-Unterbaugruppen-Zone (**SG**), und
ein Zonen-Verbindungs-Leiterbahnenlayout für eine Zonen-Verbindung (**VZC**) von der Peripheriekopplungs-Unterbaugruppen-Zone (**SG**) zur programmierbaren Logik (**PL**) und/oder zur Microcontroller-Unterbaugruppe (**MUG**) und/oder zur Netzwerkkopplungs-Unterbaugruppe (**N**), sowie
ein Konnektorbaulement-Verbindungs-Leiterbahnenlayout für eine Konnektorbaulement-Verbindung (**VSC**) von der Peripheriekopplungs-Unterbaugruppen-Zone (**SG**) zum Konnektorbauelement (**I/O-C**) aufweist,
und bei dem jeweils ein Peripheriekopplungs-Unterbaugruppen-Leiterbahnenlayout (**PUG-L**) für jede Peripheriekopplungs-Unterbaugruppe (**PUG**), die Bestandteil der herzustellenden intelligenten Peripheriekopplungsbaugruppe (**IP**) wird, aus der Computer-Datenbasis der vorerstellten Leiterbahnenlayout-Module (**LM**) ausgewählt und ebenfalls in dem Datenspeicher für das Leiterbahnen-Layout (**IP-L-MEM**) der herzustellenden intelligenten Peripheriekopplungsbaugruppe (**IP**) abgelegt wird,
**dadurch gekennzeichnet, daß**
für jede Peripheriekopplungs-Unterbaugruppe (**PUG**), die Bestandteil der herzustellenden intelligenten Peripheriekopplungsbaugruppe (**IP**) wird, der Rasterplatz (**RP**) oder die Rasterplätze (**RP**) in dem Raster (**R**) der Peripheriekopplungs-Unterbaugruppen-Zone (**SG**) gewählt wird oder werden, den oder die die jeweilige Peripheriekopplungs-Unterbaugruppe (**PUG**) einnimmt oder einnehmen, wobei
das in dem Datenspeicher für das Leiterbahnen-Layout (**IP-L-MEM**) der herzustellenden intelligenten Peripheriekopplungsbaugruppe (**IP**) abgelegte Baugruppen-Leiterbahnenlayout (**IP-B-L**) für die herzustellende intelligente Peripheriekopplungsbaugruppe (**IP**) so ausgestaltet ist, daß
jeweils zumindest einem so gewählten Rasterplatz (**RP**) in dem Raster (**R**) der Peripheriekopplungs-Unterbaugruppen-Zone (**SG**), den oder die die jeweilige Peripheriekopplungs-Unterbaugruppe (**PUG**) ganz oder teilweise einnimmt, in zumindest einer hierfür vorbestimmten Leiterbahnschicht (**LO**, **L1**, **L2**, **L3**, **L4**) der herzustellenden intelligenten Peripheriekopplungsbaugruppe (**IP**) eine oder mehrere Leitung(en) der Zonen-Verbindung (**VZC**) zur programmierbaren Logik (**PL**) und/oder zur Microcontroller-Unterbaugruppe (**MUG**) und/oder zur Netzwerkkopplungs-Unterbaugruppe (**N**) zugeordnet ist oder sind, mit der die jeweilige Peripheriekopplungs-Unterbaugruppe (**PUG**) über eine oder mehrere Kontaktierung(en) (**ZK**) elektrisch verbunden werden kann, und
jeweils zumindest einem so gewählten Rasterplatz (**RP**) in dem Raster (**R**) der Peripheriekopplungs-Unterbaugruppen-Zone (**SG**), den oder die die jeweilige Peripheriekopplungs-Unterbaugruppe (**PUG**) ganz oder teilweise einnimmt, in zumindest einer hierfür vorbestimmten Leiterbahnschicht (**LO**, **L1**, **L2**, **L3**, **L4**) der herzustellenden intelligenten Peripheriekopplungsbaugruppe (**IP**) eine oder mehrere Leitung(en) der Konnektorbaulement-Verbindung (**VSC**) zum Konnektorbauelement (**I/O-C**) zugeordnet ist oder sind, mit der die jeweilige Peripheriekopplungs-Unterbaugruppe (**PUG**) über eine oder mehrere Kontaktierung(en) (**CK**) elektrisch verbunden werden kann,
und für jede Peripheriekopplungs-Unterbaugruppe (**PUG**), die Bestandteil der herzustellenden intelligenten Peripheriekopplungsbaugruppe (**IP**) wird, an dem Rasterplatz (**RP**) oder den Rasterplätzen (**RP**), den oder die die jeweilige Peripheriekopplungs-Unterbaugruppe (**PUG**) ganz oder teilweise einnimmt, die von der jeweiligen Peripheriekopplungs-Unterbaugruppe (**PUG**) benötigte(n) elektrische(n) Verbindung(en) (**VZC**) zur programmierbaren Logik (**PL**) und/oder zur Microcontroller-Unterbaugruppe (**MUG**) und/oder zur Netzwerkkopplungs-Unterbaugruppe (**N**) sowie die von der jeweiligen Peripheriekopplungs-Unterbaugruppe (**PUG**) benötigte(n) elektrische(n) Verbindung(en) (**VSC**) zum Konnektorbauelements (**I/O-C**) in das ausgewählte Baugruppen-Leiterbahnenlayout (**IP-L**) der herzustellenden intelligenten Peripheriekopplungsbaugruppe (**IP**) und das jeweilig ausgewählte Peripheriekopplungs-Unterbaugruppen-Leiterbahnenlayout (**PUG-L**) der jeweiligen Peripheriekopplungs-Unterbaugruppe (**PUG**), die in dem Datenspeicher für das Leiterbahnen-Layout (**IP-L-MEM**) der herzustellenden intelligenten Peripheriekopplungsbaugruppe (**IP**) abgelegt sind, eingefügt werden,
und so aus der Zusammenfügung
des aus der Computer-Datenbasis vorerstellter Leiterbahnenlayout-Module (**LM**) für die Erstellung des Leiterbahnen-Layouts (**IP-L**) für die herzustellende intelligente Peripheriekopplungsbaugruppe (**IP**) ausgewählten und in dem Datenspeicher für das Leiterbahnen-Layout (**IP-L-MEM**) der herzustellenden intelligenten Peripheriekopplungsbaugruppe (**IP**) abgelegten Baugruppen-Leiterbahnenlayouts (**IP-B-L**) und des
für jede Peripheriekopplungs-Unterbaugruppe (**PUG**), die Bestandteil der herzustellenden intelligenten Peripheriekopplungsbaugruppe (**IP**) wird, jeweilig aus der Computer-Datenbasis vorerstellter Leiterbahnenlayout-Module (**LM**) ausgewählten und ebenfalls in dem Datenspeicher für das Leiterbahnen-Layout (**IP-L-MEM**) der herzustellenden intelligenten Peripheriekopplungsbaugruppe (**IP**) abgelegten Peripheriekopplungs-Unterbaugruppen-Leiterbahnenlayouts (**PUG-L**), sowie
der vorgenommenen Einfügungen von elektrischen Verbindungen (**CK**, **ZK**) in das Baugruppen-Leiterbahnenlayout (**IP-B-L**) der herzustellenden intelligenten Peripheriekopplungsbaugruppe (**IP**) und in das Peripheriekopplungs-Unterbaugruppen-Leiterbahnenlayout (**PUG-L**) jeder Peripheriekopplungs-Unterbaugruppe (**PUG**), die Bestandteil der herzustellenden intelligenten Peripheriekopplungsbaugruppe (**IP**) wird, in dem Datenspeicher für das Leiterbahnen-Layout (**IP-L-MEM**) der herzustellenden intelligenten Peripheriekopplungsbaugruppe (**IP**)
das Leiterbahnen-Layout (**IP-L**) für die herzustellende intelligente Peripheriekopplungsbaugruppe (**IP**) erstellt wird.

16. Computergestütztes Verfahren zur modularen Erstellung eines Leiterbahnen-Layouts (**IP-L**) nach Anspruch 15, **dadurch gekennzeichnet, daß** die von jeder Peripheriekopplungs-Unterbaugruppe (**PUG**), die Bestandteil der herzustellenden intelligenten Peripheriekopplungsbaugruppe (**IP**) wird, jeweils benötigte(n) elektrische(n) Verbindung(en) (**VZC**) zur programmierbaren Logik (**PL**) und/oder zur Microcontroller-Unterbaugruppe (**MUG**) und/oder zur Netzwerkkopplungs-Unterbaugruppe (**N**) sowie jeweils benötigte(n) elektrische(n) Verbindung(en) (**VSC**) zum Konnektorbauelement (**I/O-C**) in das ausgewählte Baugruppen-Leiterbahnenlayout (**IP-B-L**) der intelligenten Peripheriekopplungsbaugruppe (**IP**) und das jeweilig ausgewählte Peripheriekopplungs-Unterbaugruppen-Leiterbahnenlayout (**PUG-L**) der jeweiligen Peripheriekopplungs-Unterbaugruppe (**PUG**), die in dem Datenspeicher für das Leiterbahnen-Layout (**IP-L-MEM**) der herzustellenden intelligenten Peripheriekopplungsbaugruppe (**IP**) abgelegt sind, als Leiterbahnen-Durchkontaktierung (**CK**, **ZK**) zwischen einer hierfür jeweilig vorgesehenen Leiterbahn in einer der Leiterbahnschichten (**LO**, **L1**, **L2**, **L3**, **L4**) der Peripheriekopplungs-Unterbaugruppe (**PUG**) und der hierfür jeweilig vorgesehenen Leiterbahn in der hierfür vorgesehenen Leiterbahnschicht (**LO**, **L1**, **L2**, **L3**, **L4**) der herzustellenden intelligenten Peripheriekopplungsbaugruppe (**IP**) eingefügt wird.

17. Computergestütztes Verfahren zur modularen Erstellung eines Leiterbahnen-Layouts (**IP-L**) nach Anspruch 15 oder 16, **dadurch gekennzeichnet, daß** aus der Computer-Datenbasis der vorerstellten Leiterbahnenlayout-Module (**LM**) ein Baugruppen-Leiterbahnenlayout (**IP-B-L**) für die herzustellende intelligente Peripheriekopplungsbaugruppe (**IP**) ausgewählt wird, das auch bereits ein Programmierbare-Logik-Leiterbahnenlayout (**PL-L**) für die Programmierbare Logik (**PL**) aufweist.

18. Computergestütztes Verfahren zur modularen Erstellung eines Leiterbahnen-Layouts (**IP-L**) nach Anspruch 15, 16 oder 17, **dadurch gekennzeichnet, daß** für jede Peripheriekopplungs-Unterbaugruppe (**PUG**), die Bestandteil der herzustellenden intelligenten Peripheriekopplungsbaugruppe (**IP**) wird, auch ein zu der jeweiligen Peripheriekopplungs-Unterbaugruppe (**PUG**) gehöriges Programmierbare-Logik-Teil-Leiterbahnenlayout (**PL-TL**) für den Teil der programmierbaren Logik (**PL**), der für die jeweilige Peripheriekopplungs-Unterbaugruppe(n) (**PUG**) benötigt wird, aus der Computer-Datenbasis der vorerstellten Leiterbahnenlayout-Module (**LM**) ausgewählt und in das ausgewählte und in dem Datenspeicher für das Leiterbahnen-Layout (**IP-PL-MEM**) der herzustellenden intelligenten Peripheriekopplungsbaugruppe (**IP**) abgelegte Baugruppen-Leiterbahnenlayout (**IP-B-L**) der herzustellenden intelligenten Peripheriekopplungsbaugruppe (**IP**) eingefügt wird und so durch Einfügung der Programmierbare-Logik-Teil-Leiterbahnenlayouts (**PL-TL**) das Leiterbahnen-Layout (**IP-L**) für die herzustellende intelligente Peripheriekopplungsbaugruppe (**IP**) auch ein Programmierbare-Logik-Leiterbahnenlayout (**PL-L**) für die Programmierbare Logik (**PL**) erstellt wird.

19. Computergestütztes Verfahren zur Erstellung eines Bauteil-Bestückungsplans (**IP-BOM**) für eine herzustellende intelligente Peripheriekopplungsbaugruppe (**IP**) gemäß einem der Ansprüche 5 bis 14, **dadurch gekennzeichnet, daß**
für die herzustellende intelligente Peripheriekopplungsbaugruppe (**IP**) ein Leiterbahnen-Layout (**IP-L**) nach dem Verfahren nach einem der Ansprüche 15 bis 18 erstellt wird und
anhand des Leiterbahnen-Layouts (**IP-L**) und der bei der Erstellung des Leiterbahnen-Layouts (**IP-L**) ausgewählten Leiterbahnenlayout-Module (**IP-B-L**, **PUG-L**), sowie
anhand einer Bauteil-Bestückungsplan-Computer-Datenbasis (**BM**), die zu dem jeweiligen Leiterbahnenlayout-Modul (**IP-B-L**, **PUG-L**) aus der Computer-Datenbasis vorerstellter Leiterbahnenlayout-Module (**LM**) einen zugehörigen Modul-Bauteil-Bestückungsplan (**IP-B-L-BOM**, **PUG-L-BOM**) mit in dem jeweiligen Leiterbahnenlayout-Modul (**IP-B-L**, **PUG-L**) verwendeten Bauteil(en) und der Position des jeweiligen Bauteils in dem jeweiligen Leiterbahnenlayout-Modul (**IP-B-L**, **PUG-L**) aufweist,
der Bauteil-Bestückungsplan (**IP-BOM**) für die herzustellende intelligente Peripheriekopplungsbaugruppe (**IP**) erstellt wird.

20. Computergestütztes Verfahren zur Erstellung eines Schaltplans (**IP-S**) für eine herzustellende intelligente Peripheriekopplungsbaugruppe (**IP**) gemäß einem der Ansprüche 5 bis 14, **dadurch gekennzeichnet, daß**
für die herzustellende intelligente Peripheriekopplungsbaugruppe (**IP**) ein Leiterbahnen-Layout (**IP-L**) nach dem Verfahren nach einem der Ansprüche 15 bis 18 erstellt wird und
anhand des Leiterbahnen-Layouts (**IP-L**) und der bei der Erstellung des Leiterbahnen-Layouts (**IP-L**) ausgewählten Leiterbahnenlayout-Module (**IP-B-L**, **PUG-L**), sowie
anhand einer Schaltplan-Computer-Datenbasis (**SDM**), die zu dem jeweiligen Leiterbahnenlayout-Modul (**IP-B-L**, **PUG-L**) aus der Computer-Datenbasis vorerstellter Leiterbahnenlayout-Module (**LM**) ein zugehöriges Schaltplan-Modul (**IP-B-L-S, PUG-L-S**) aufweist,
der Schaltplan (**IP-S**) für die herzustellende intelligente Peripheriekopplungsbaugruppe (**IP**) erstellt wird.

21. Computergestütztes Verfahren zur Erstellung einer Logik-Programmierung (**IP-LO**) einer programmierbaren Logik (**PL**) für eine herzustellende intelligente Peripheriekopplungsbaugruppe (**IP**) gemäß einem der Ansprüche 5 bis 14, **dadurch gekennzeichnet, daß**
für die herzustellende intelligente Peripheriekopplungsbaugruppe (**IP**) ein Leiterbahnen-Layout (**IP-L**) nach dem Verfahren nach Anspruch 17 oder 18 erstellt wird und
anhand einer Logik-Programmierungs-Modul-Computer-Datenbasis (**LOM**), die Logik-Programmierungs-Module (**IP-B-LOM, PUG-LOM**) enthält und dabei
für den ausgewählten Peripheriekopplungsbaugruppengrundtyp (**IP-B**), und/oder
für jede Peripheriekopplungs-Unterbaugruppe (**PUG**), die Bestandteil der herzustellenden intelligenten Peripheriekopplungsbaugruppe (**IP**) wird und für die die programmierbare Logik (**PL**) benötigt wird,
jeweilig zumindest ein zugehöriges Logik-Programmierungs-Modul (**IP-B-LOM, PUG-LOM**) für den Teil der programmierbaren Logik (**PL**), der für die jeweilige Peripheriekopplungs-Unterbaugruppe(n) (**PUG**) und/oder den ausgewählten Peripheriekopplungsbaugruppengrundtyp (**IP-B**) benötigt wird, aufweist,
für den ausgewählten Peripheriekopplungsbaugruppengrundtyp (**IP-B**) und/oder
für jede Peripheriekopplungs-Unterbaugruppe (**PUG**), die Bestandteil der herzustellenden intelligenten Peripheriekopplungsbaugruppe (**IP**) wird und für die die programmierbare Logik (**PL**) benötigt wird,
das oder die zu der jeweiligen Peripheriekopplungs-Unterbaugruppe (**PUG**) und/oder zu dem ausgewählten Peripheriekopplungsbaugruppengrundtyp (**IP-B**) gehörige(n) Logik-Programmierungs-Modul(e) (**IP-B-LOM, PUG-LOM**) aus der Logik-Programmierungs-Modul-Computer-Datenbasis (**LOM**) ausgewählt, und dem Inhalt eines Datenspeichers für die Logik-Programmierung (**IP-LOM-MEM**) der programmierbaren Logik (**PL**) für die herzustellende intelligente Peripheriekopplungsbaugruppe (**IP**) hinzugefügt wird oder werden, und
die in dem Datenspeicher für die Logik-Programmierung (**IP-LOM-MEM**) der programmierbaren Logik (**PL**) so durch Hinzufügung des jeweiligen Logik-Programmierungs-Moduls **(IP-B-LOM, PUG-LOM**) entstehende Logik-Programmierung **(IP-LO)** für die programmierbare Logik (**PL**) für die herzustellende intelligente Peripheriekopplungsbaugruppe (**IP**) entsprechend dem erstellten Leiterbahnen-Layout (**IP-L**) für die herzustellende intelligente Peripheriekopplungsbaugruppe (**IP**) - vorzugsweise entsprechend dem Programmierbare-Logik-Leiterbahnenlayout (**PL-L**) für die Programmierbare Logik (**PL**) - angepaßt wird,
und so die Logik-Programmierung (**IP-LO**) für die programmierbare Logik (**PL**) für die herzustellende intelligente Peripheriekopplungsbaugruppe (**IP**) in dem Datenspeicher für die Logik-Programmierung (**IP-LO-MEM**) erstellt wird.

22. Computergestütztes Verfahren zur Erstellung einer Intelligente-Peripheriekopplungsbaugruppe-Prozeßabbild-Struktur **(IP-PIS)** einer herzustellenden intelligenten Peripheriekopplungsbaugruppe (**IP**) gemäß einem der Ansprüche 5 bis 14, **dadurch gekennzeichnet, daß**
für die herzustellende intelligente Peripheriekopplungsbaugruppe (**IP**) ein Leiterbahnen-Layout (**IP-L**) nach dem Verfahren nach einem der Ansprüche 15 bis 18 erstellt wird, und
anhand einer Prozeßabbild-Struktur-Computer-Datenbasis (**PISD**), die für jede Peripheriekopplungs-Unterbaugruppe (**PUG**), die Bestandteil der herzustellenden intelligenten Peripheriekopplungsbaugruppe (**IP**) wird, eine Peripheriekopplungs-Unterbaugruppen-Prozeßabbild-Struktur (**PUG-PI**) enthält,
für jede Peripheriekopplungs-Unterbaugruppe (**PUG**), die Bestandteil der herzustellenden intelligenten Peripheriekopplungsbaugruppe (**IP**) wird, aus der Prozeßabbild-Struktur-Computer-Datenbasis (**PISD**) die zugehörige Peripheriekopplungs-Unterbaugruppen-Prozeßabbild-Struktur (**PUG-PI**) der intelligenten Peripheriekopplungsbaugruppe (**IP**) ausgewählt und dem Inhalt eines Datenspeichers für die Prozeßabbild-Struktur (**IP-PIS-MEM**) mit der Intelligente-Peripheriekopplungsbaugruppe-Prozeßabbild-Struktur **(IP-PIS)** für die herzustellende intelligente Peripheriekopplungsbaugruppe (**IP**) hinzugefügt wird, und
anhand des für die herzustellende intelligente Peripheriekopplungsbaugruppe (**IP**) erstellten Leiterbahnen-Layouts (**IP-L**) in der Intelligente-Peripheriekopplungsbaugruppe-Prozeßabbild-Struktur **(IP-PIS)** eine Datenzuordnung erfolgt, die die zu jeder Peripheriekopplunge-Unterbaugruppe (**PUG**) der herzustellenden intelligenten Peripheriekopplungsbaugruppe (**IP**) zugehörige Peripheriekopplungs-Unterbaugruppen-Prozeßabbild-Struktur (**PUG-PI**) einem Datenbereich der Intelligente-Peripheriekopplungsbaugruppe-Prozeßabbild-Struktur (**IP-PIS**) der herzustellenden intelligente Peripheriekopplungsbaugruppe (**IP**) zuordnet
und so die Intelligente-Peripheriekopplungsbaugruppe-Prozeßabbild-Struktur (**IP-PIS**) der herzustellenden intelligenten Peripheriekopplungsbaugruppe (**IP**) im Datenspeicher für die Prozeßabbild-Struktur (**IP-PIS-MEM**) erstellt wird.

23. Computergestütztes Verfahren zur Erstellung einer Microcontroller-Programmierung (**IP-MP**) für eine Microcontroller-Unterbaugruppe (**MUG**) zum programmierten Betrieb einer herzustellenden intelligenten Peripheriekopplungsbaugruppe (**IP**) gemäß einem der Ansprüche 5 bis 14, **dadurch gekennzeichnet, daß**
für die herzustellende intelligente Peripheriekopplungsbaugruppe (**IP**) eine Intelligente-Peripheriekopplungsbaugruppe-Prozeßabbild-Struktur (**IP-PIS**) nach dem Verfahren nach Anspruch 22 erstellt wird und
anhand einer Microcontroller-Programmierungs-Modul-Computer-Datenbasis (**MPD**), die Microcontroller-Programmierungs-Module (**IP-B-MP**, **PUG-MP**) enthält und dabei
für den ausgewählten Peripheriekopplungsbaugruppengrundtyp (**IP-B**), und/oder
für jede Peripheriekopplungs-Unterbaugruppe (**PUG**), die Bestandteil der herzustellenden intelligenten Peripheriekopplungsbaugruppe (**IP**) wird,
jeweilig ein zugehöriges Microcontroller-Programmierungs-Modul (**IP-B-MP**, **PUG-MP**), das zum programmierten Betrieb der jeweiligen Peripheriekopplungs-Unterbaugruppe(n) (**PUG**) durch die Microcontroller-Unterbaugruppe (**MUG**) und/oder des ausgewählten Peripheriekopplungsbaugruppengrundtyps (**IP-B**) benötigt wird, aufweist,
für den ausgewählten Peripheriekopplungsbaugruppengrundtyp (**IP-B**) und/oder
für jede Peripheriekopplungs-Unterbaugruppe (**PUG**), die Bestandteil der herzustellenden intelligenten Peripheriekopplungsbaugruppe (**IP**) wird,
das oder die zu der jeweiligen Peripheriekopplungs-Unterbaugruppe (**PUG**) und/oder zu dem ausgewählten Peripheriekopplungsbaugruppengrundtyp (**IP-B**) gehörige(n) Microcontroller-Programmierungs-Modul(e) (**IP-B-MP**, **PUG-MP**) aus der Microcontroller-Programmierungs-Modul-Computer-Datenbasis (**MPD**) ausgewählt, und dem Inhalt eines Datenspeichers für die Microcontroller-Programmierung (**IP-MP-MEM**) der herzustellenden intelligenten Peripheriekopplungsbaugruppe (**IP**) hinzugefügt wird oder werden, und
die in dem Datenspeicher für die Microcontroller-Programmierung (**IP-MP-MEM**) so durch Hinzufügung des jeweiligen Microcontroller-Programmierungs-Moduls (**IP-B-MP**, **PUG-MP**) entstehende Microcontroller-Programmierung (**IP-MP**) für die herzustellende intelligente Peripheriekopplungsbaugruppe (**IP**) entsprechend der Datenzuordnung aus der Peripheriekopplungsbaugruppe-Prozeßabbild-Struktur (**IP-PIS**) für die herzustellende intelligente Peripheriekopplungsbaugruppe (**IP**) so angepaßt wird, daß das der jeweiligen Peripheriekopplungs-Unterbaugruppe (**PUG**) zugehörige Microcontroller-Programmierungs-Modul (**PUG-MP**) auf dem jeweiligen Datenbereich des Prozeßabbilds der herzustellenden intelligenten Peripheriekopplungsbaugruppe (**IP**) operiert, der die Daten der jeweiligen Peripheriekopplungs-Unterbaugruppe (**PUG**) aufweist
und so die Microcontroller-Programmierung (**IP-MP**) zum programmierten Betrieb der herzustellenden intelligenten Peripheriekopplungsbaugruppe (**IP**) in dem Datenspeicher für die Microcontroller-Programmierung (**IP-MP-MEM**) erstellt wird.

24. Computergestütztes Verfahren zur Herstellung einer intelligenten Peripheriekopplungsbaugruppe (**IP**) gemäß einem der Ansprüche 5 bis 14, **dadurch gekennzeichnet, daß** für die herzustellende intelligente Peripheriekopplungsbaugruppe (**IP**)
- ein Leiterbahnen-Layout (**IP-L**) nach dem Verfahren nach einem der Ansprüche 15 bis 18 erstellt wird und
- ein Bauteil-Bestückungsplan (**IP-BOM**) nach dem Verfahren nach Anspruch 19 erstellt wird und
vermittels des für die herzustellende intelligente Peripheriekopplungsbaugruppe (**IP**) erstellten Leiterbahnen-Layout (**IP-L**) und des für die herzustellende intelligente Peripheriekopplungsbaugruppe (**IP**) erstellten Bauteil-Bestückungsplans (**IP-BOM**) die intelligente Peripheriekopplungsbaugruppe (**IP**) hergestellt wird.

25. Computergestütztes Verfahren zur Herstellung einer intelligenten Peripheriekopplungsbaugruppe (**IP**) nach Anspruch 24, **dadurch gekennzeichnet, daß** für die herzustellende intelligente Peripheriekopplungsbaugruppe (**IP**)
- ein Leiterbahnen-Layout (**IP-L**) nach dem Verfahren nach Anspruch 17 oder 18 erstellt wird und
- eine Logik-Programmierung (**IP-LO**) einer programmierbaren Logik (**PL**) für die herzustellende intelligente Peripheriekopplungsbaugruppe (**IP**) nach dem Verfahren des Anspruch 21 erstellt wird und
die intelligente Peripheriekopplungsbaugruppe (**IP**) auch vermittels der erstellten Logik-Programmierung (**IP-LO**) hergestellt wird, indem die auf der intelligenten Peripheriekopplungsbaugruppe (**IP**) befindliche programmierbare Logik (**PL**) mittels der in dem Datenspeicher für die programmierbare Logik (**IP-LOM-MEM**) erstellten Logik-Programmierung (**IP-LO**) programmiert wird.

26. Computergestütztes Verfahren zur Herstellung einer intelligenten Peripheriekopplungsbaugruppe (**IP**) nach Anspruch 24 oder 25, **dadurch gekennzeichnet, daß** für die herzustellende intelligente Perippheriekopplungsbaugruppe (**IP**) eine Microcontroller-Programmierung (**IP-MP**) einer Microcontroller-Unterbaugruppe (**MUG**) zum programmierten Betrieb der herzustellenden intelligenten Peripheriekopplungsbaugruppe (**IP**) nach dem Verfahren nach Anspruch 23 erstellt wird und die intelligente Peripheriekopplungsbaugruppe (**IP**) auch vermittels der erstellten Microcontroller-Programmierung (**IP-MP**) hergestellt wird, indem die auf der intelligenten Peripheriekopplungsbaugruppe (**IP**) befindliche Microcontroller-Unterbaugruppe (**MUG**) mittels der in dem Datenspeicher für die Microcontroller-Programmierung (**IP-MP-MEM**) erstellten Microcontroller-Programmierung (**IP-MP**) programmiert wird.

27. Computergestütztes Verfahren zur Konfiguration eines datennetzwerkbasierten Systems zur Steuerung und/oder Regelung und/oder Überwachung von zumindest einem Peripheriegerät (**PG**) durch ein - vorzugsweise zentrales -Steuergerät (**CON**) mittels Datenübertragung zwischen Teilnehmern eines Datennetzwerks (**DN**), bei dem
zumindest eine intelligente Peripheriekopplungsbaugruppe (**IP**) gemäß einem der Ansprüche 5 bis 14 als Teilnehmer mit dem Datennetzwerk (**DN**) verbunden ist, und
das Steuergerät (**CON**) ebenfalls als Teilnehmer mit dem Datennetzwerk (**DN**) verbunden ist, wobei das Steuergerät (**CON**) aufweist
eine Steuergerät-Netzwerkkopplungs-Unterbaugruppe zur Kopplung des Steuergeräts an das Datennetzwerk (**DN**),
zumindest einen Prozessor und mindestens einen Speicher und
das Steuergerät (**CON**) das mit der jeweiligen Peripheriekopplungs-Unterbaugruppe (**PUG**) gekoppelte Peripheriegerät (**PG**) mit einem zu der jeweiligen Peripheriekopplungs-Unterbaugruppe (**PUG**) gehörigen, in dem Speicher des Steuergeräts hinterlegten jeweiligen Softwaresteuer-Modul (**PUG-SSM**) vermittels der Übertragung eines Prozeßabbildes über das Datennetzwerk (**DN**) steuert und/oder regelt und/oder überwacht, wobei das Prozeßabbild in einem der jeweiligen intelligenten Peripheriekopplungsbaugruppe (**IP**) zugehörigen Datenbereich einer ebenfalls im Speicher des Steuergeräts (**CON**) hinterlegten Intelligente-Peripheriekopplungsbaugruppe-Prozeßabbild-Struktur (**IP-PIS**) entspricht, die zu der intelligenten Peripheriekopplungsbaugruppe (**IP**) gehört, die die jeweilige zur Steuerung und/oder zur Regelung und/oder zur Überwachung des Peripheriegeräts (**PG**) dienende Peripheriekopplungs-Unterbaugruppe (**PUG**) aufweist
**dadurch gekennzeichnet, daß**
anhand einer Peripheriekopplungs-Unterbaugruppen-Computer-Datenbasis (**PUGDB**), die zu der jeweiligen Peripheriekopplungs-Unterbaugruppe (**PUG**) eine technische Peripheriekopplungs-Unterbaugruppen-Spezifikation (**PUG-TS**) bereitstellt, die zumindest die Größe der jeweiligen Peripheriekopplungs-Unterbaugruppe (**PUG**) in benötigten Rasterplätzen (**RP**) in dem Raster der Peripheriekopplungs-Unterbaugruppen-Zone (**SG**) der jeweiligen intelligenten Peripheriekopplungsbaugruppe (**IP**) aufweist,
Peripheriekopplungs-Unterbaugruppen (**PUG**) ausgewählt werden, die Bestandteil des zu konfigurierenden intelligenten datennetzwerkbasierten Systems zur Steuerung und/oder Regelung und/oder Überwachung werden,
anhand einer Computer-Datenbasis intelligenter Peripheriekopplungsbaugruppen (**IPDB**), der eine Peripheriekopplungsbaugruppen-Spezifikation (**IP-SPEC**) zu entnehmen ist, die zumindest angibt, welche Peripheriekopplungs-Unterbaugruppen (**PUG**) die jeweilige Peripheriekopplungsbaugruppe (**IP**) in der Peripheriekopplungs-Unterbaugruppen-Zone (**SG**) mit dem Raster (**R**) mit den mehreren Rasterplätzen (**RP**) aufzunehmen in der Lage ist,
die ausgewählten Peripheriekopplungs-Unterbaugruppen (**PUG**) auf zumindest eine intelligente Peripheriekopplungsbaugruppe (**IP**) zur Aufnahme verteilt (**D**) werden, und
für jede der so zur Aufnahme von Peripheriekopplungs-Unterbaugruppen (**PUG**) vorgesehene intelligente Peripheriekopplungsbaugruppe (**IP**) eine Intelligente-Peripheriekopplungsbaugruppe-Prozeßabbild-Struktur (**IP-PIS**) nach dem Verfahren nach Anspruch 22 ermittelt wird, und
anhand einer Peripheriekopplungs-Unterbaugruppen-Softwaremodul-Computer-Datenbasis (**SSMDB**), die zu Peripheriekopplungs-Unterbaugruppen (**PUG**) gehörige Softwaresteuer-Module (**PUG-SSM**) aufweist,
für jede Peripheriekopplungs-Unterbaugruppe (**PUG**), die Bestandteil des zu konfigurierenden intelligenten datennetzwerkbasierten Systems zur Steuerung und/oder Regelung und/oder Überwachung wird, das zur jeweiligen Peripheriekkopplungs-Unterbaugruppe (**PUG**) gehörige Softwaresteuer-Modul (**PUG-SSM**) ausgewählt wird, und
in dem Speicher des Steuergerätes (**CON**) die ermittelte Intelligente-Peripheriekopplungsbaugruppe-Prozeßabbild-Struktur (**IP-PIS**) jeder zur Aufnahme von Peripheriekopplungs-Unterbaugruppen (**PUG**) vorgesehenen intelligenten Peripheriekopplungsbaugruppe (**IP**) und die ausgewählten zu den Peripheriekopplungs-Unterbaugruppen (**PUG**) zugehörigen Softwaresteuer-Module (**PUG-SSM**) hinterlegt werden, die Bestandteil des zu konfigurierenden intelligenten datennetzwerkbasierten Systems zur Steuerung und/oder Regelung und/oder Überwachung werden.

28. Computergestütztes Verfahren zur Konfiguration eines datennetzwerkbasierten Systems zur Steuerung und/oder Regelung und/oder Überwachung von zumindest einem Peripheriegerät (**PG**) durch ein Steuergerät (**CON**) mittels Datenübertragung zwischen Teilnehmern (**CON**, **IP**) eines Datennetzwerks (**DN**) nach Anspruch 27, **dadurch gekennzeichnet, daß** als Datennetzwerk (**DN**) ein - vorzugsweise echtzeitfähiger - Feldbus, vorzugsweise ein Industrial Ethernet, Verwendung findet.

29. Computergestütztes Verfahren zur Konfiguration eines datennetzwerkbasierten Systems zur Steuerung und/oder Regelung und/oder Überwachung von zumindest einem Peripheriegerät (**PG**) durch ein Steuergerät (**CON**) mittels Datenübertragung zwischen Teilnehmern (**CON**, **IP**) eines Datennetzwerks (**DN**) nach Anspruch 27, **dadurch gekennzeichnet, daß**
bei der Übertragung des Prozeßabbilds oder der Prozeßabbilder zwischen den Teilnehmern (**CON**, **IP**) des Datennetzwerks (**DN**) ein Datentelegramm von Teilnehmer (**CON**, **IP**) zu Teilnehmer (**CON**, **IP**) weiter übertragen wird, und
für jeden Teilnehmer (**CON**, **IP**) ein Datenbereich in dem Datentelegramm vorgesehen ist, der für Daten von oder für diesen Teilnehmer (**CON**, **IP**) vorgesehen ist, und wo der jeweilige Teilnehmer (**CON**, **IP**) Daten in den Bereich des Datentelegramms schreiben kann, der für Daten von diesem Teilnehmer (**CON**, **IP**) vorgesehen ist, oder wo der jeweilige Teilnehmer (**CON**, **IP**) Daten aus dem Bereich des Datentelegramms auslesen kann, der für Daten für diesen Teilnehmer (**CON**, **IP**) vorgesehen ist, und
das Datentelegramm von dem Steuergerät (**CON**) aus startet und nach Empfang durch den letzten Teilnehmer (**IP**) des Datennetzwerks (**DN**) wieder an das Steuergerät (**CON**) zurückübertragen wird, und in dem Speicher des Steuergeräts (**CON**) auch Einträge über den Aufbau des Datentelegramms dahingehend hinterlegt werden, welcher jeweilige Datenbereich des Datentelegramms für das Prozeßabbild welcher intelligenten Peripheriekopplungsbaugruppe (**IP**) als Teilnehmer des Datennetzwerks (**DN**) vorgesehen ist.

## Claims

1. An intelligent peripheral coupling board (**IP**) comprising subassemblies on a printed circuit board with at least one layer of circuit traces, wherein
a network coupling subassembly (**N**) for coupling the peripheral coupling subassembly (**IP**) to at least one - preferably central - control unit (**CON**) via a data network (**DN**), and
in a peripheral coupling subassembly zone (**SG**) of the board, an area for one or more peripheral coupling subassembly(s) (**PUG**) for coupling to at least the one peripheral device (**PG**) to be controlled and/or regulated and/or monitored, and
at least one connector component (**I/O-C**) for electrically or optically or wirelessly connecting the peripheral coupling subassembly(s) (**PUG**) to the peripheral device(s) (**PG**)
is provided, wherein
the network coupling subassembly (**N**) comprising a zone connection (**VZC**) as an electrical connection via one or more line(s) to the peripheral coupling subassembly(s) (**PUG**) in the peripheral coupling subassembly zone (**SG**), which serves to control the peripheral coupling subassembly(s) (**PUG**), and
the peripheral coupling subassembly(s) (**PUG**) in the peripheral coupling subassembly zone (**SG**) each comprises a connector component connection (**VSC**) for electrical connection via one or more line(s) to one or more pin(s) (**P**) of the connector component (**I/O-C**),
**characterized in that**
the peripheral coupling subassembly(s) (**PUG**) in the peripheral coupling subassembly zone (**SG**) is/are aligned on a grid (**R**) having a plurality of grid locations (**RP**), wherein
at least one grid location (**RP**) is provided in the grid (**R**) of the peripheral coupling subassembly zone (**SG**) which can be wholly or partially occupied by a peripheral coupling subassembly (**PUG**) to which one or more lines of the zone connection (**VZC**) is or are assigned in at least one conductor track layer (**LO**, **L1**, **L2**, **L3**, **L4**) of the board which is predetermined for this purpose and to which the respective peripheral coupling subassembly (**PUG**) can be electrically connected via one or more contact(s) (**ZK**), and
at least one grid location (**RP**) is provided in the grid (**R**) of the peripheral coupling subassembly zone (**SG**) which can be wholly or partially occupied by a peripheral coupling subassembly (**PUG**) to which one or more lines of the connector component connection (**VSC**) is or are are assigned in at least one conductor track layer (**LO**, **L1**, **L2**, **L3**, **L4**) of the board which is predetermined for this purpose and to which the respective peripheral coupling subassembly (**PUG**) can be electrically connected via one or more contact(s) (**CK**).

2. Intelligent peripheral coupling board (**IP**) according to claim 1, **characterized in that** the network coupling subassembly (**N**) comprises an application-specific integrated circuit with digital inputs and/or outputs which can be set or read in dependence on the data received and/or transmitted via the data network (**DN**) towards the - preferably central - control unit (**CON**).

3. An intelligent peripheral coupling board (**IP**) comprising subassemblies on a printed circuit board with at least one layer of circuit traces, wherein
a microcontroller subassembly (**MUG**) for the programmed operation of the peripheral coupling board (**IP**), and
in a peripheral coupling subassembly zone (**SG**) of the board, an area for one or more peripheral coupling subassembly(s) (**PUG**) for coupling to at least the one peripheral device (**PG**) to be controlled and/or regulated and/or monitored, and
at least one connector component (**I/O-C**) for electrically or optically or wirelessly connecting the peripheral coupling subassembly(s) (**PUG**) to the peripheral device(s) (**PG**)
is provided, wherein
the microcontroller subassembly (**MUG**) comprises a zone connection (**VZC**) as an electrical connection via one or more line(s) to the peripheral coupling subassembly(s) (**PUG**) in the peripheral coupling subassembly zone (**SG**), which serves to control the peripheral coupling subassembly(s) (**PUG**), and
the peripheral coupling subassembly(s) (**PUG**) in the peripheral coupling subassembly zone (**SG**) each has a connector component connection (**VSC**) for electrical connection via one or more line(s) to one or more pin(s) (**P**) **of** the connector component (**I/O-C**),
**characterized in that**
the peripheral coupling subassembly(s) (**PUG**) in the peripheral coupling subassembly zone (**SG**) is or are aligned on a grid (**R**) having a plurality of grid locations (**RP**), wherein
at least one grid location (**RP**) is provided in the grid (**R**) of the peripheral coupling subassembly zone (**SG**) which can be wholly or partially occupied by a peripheral coupling subassembly (**PUG**) to which one or more lines of the zone connection (**VZC**) is or are assigned in at least one conductor track layer (**LO, L1, L2, L3, L4**) of the board which is predetermined for this purpose and to which the respective peripheral coupling subassembly (**PUG**) can be electrically connected via one or more contacting(s) (**ZK**), and
at least one grid location (**RP**) is provided in the grid (**R**) of the peripheral coupling subassembly zone (**SG**) which can be wholly or partially occupied by a peripheral coupling subassembly (**PUG**) to which one or more lines of the connector component connection (**VSC**) is or are assigned in at least one conductor track layer (**LO**, **L1**, **L2**, **L3**, **L4**) of the board which is predetermined for this purpose and to which the respective peripheral coupling subassembly (**PUG**) can be electrically connected via one or more contact(s) (**CK**).

4. An intelligent peripheral coupling board (**IP**) comprising subassemblies on a circuit board with at least one layer of circuit traces, wherein
a programmable logic (**PL**) for connection to one or more peripheral coupling subassembly(s) (**PUG**), which are used for coupling to at least one peripheral device (**PG**) to be controlled and/or regulated and/or monitored, as well as
in a peripheral coupling subassembly zone (**SG**) of the board, an area for the peripheral coupling subassembly(s) (**PUG**) for coupling to at least the one peripheral device (**PG**) to be controlled and/or regulated and/or monitored, and
at least one connector component (**I/O-C**) for electrically or optically or wirelessly connecting the peripheral coupling subassembly(s) (**PUG**) to the peripheral device(s) (**PG**)
is provided, wherein
the programmable logic (**PL**) has a zone connection (**VZC**) as an electrical connection via one or more line(s) to the peripheral coupling subassembly(s) (**PUG**) in the peripheral coupling subassembly zone (**SG**), which serves to control the peripheral coupling subassembly(s) (**PUG**), and
the peripheral coupling subassembly(s) (**PUG**) in the peripheral coupling subassembly zone (**SG**) each has a connector component connection (**VSC**) for electrical connection via one or more line(s) to one or more pin(s) (**P**) of the connector component (**I/O-C**),
**characterized in that**
the peripheral coupling subassembly(s) (**PUG**) in the peripheral coupling subassembly zone (**SG**) is or are aligned on a grid (**R**) having a plurality of grid locations (**RP**), wherein
at least one grid location (**RP**) is provided in the grid (**R**) of the peripheral coupling subassembly zone (**SG**) which can be wholly or partially occupied by a peripheral coupling subassembly (**PUG**) to which one or more lines of the zone connection (**VZC**) is or are assigned in at least one conductor track layer (**LO**, **L1**, **L2**, **L3**, **L4**) of the board which is predetermined for this purpose and to which the respective peripheral coupling subassembly (**PUG**) can be electrically connected via one or more contacting(s) (**ZK**), and
at least one grid location (**RP**) is provided in the grid (**R**) of the peripheral coupling subassembly zone (**SG**) which can be wholly or partially occupied by a peripheral coupling subassembly (**PUG**) to which one or more lines of the connector component connection (**VSC**) is or are assigned in at least one conductor track layer (**LO**, **L1**, **L2**, **L3**, **L4**) of the board which is predetermined for this purpose and to which the respective peripheral coupling subassembly (**PUG**) can be electrically connected via one or more contact(s) (**CK**).

5. Intelligent peripheral coupling board (**IP**) comprising
an intelligent peripheral coupling board according to claim 1 or 2,
and/or an intelligent peripheral coupling board according to claim 3,
and/or an intelligent peripheral coupling board according to claim 4,
**characterized in that** different zones (**A**, **M**, **L**) provided for the subassemblies are arranged on the board, wherein
the network coupling subassembly (**N**) is provided in a first zone (**A**) of the board,
the microcontroller subassembly (**MUG**) is provided in a second zone (**M**) of the board, and
the programmable logic (**PL**) is provided in a third zone (**L**) of the board.

6. An intelligent peripheral coupling board (**IP**) according to claim 5, **characterized in that** at least one grid location (**RP**) is provided in the grid (**R**) of the peripheral coupling subassembly zone (**SG**) which can be wholly or partially occupied by a peripheral coupling subassembly (**PUG**), to which all the lines of the zone connection (**VZC**), to which the respective peripheral coupling subassembly (**PUG**) can be electrically connected via one or more contact(s) (**ZK**), are assigned in at least one conductor track layer (**LO**, **L1**, **L2, L3**, **L4**) of the board which is predetermined for this purpose.

7. Intelligent peripheral coupling board (**IP**) according to one of claims 5 or 6, **characterized in that** at least one grid location (**RP**) is provided in the grid (**R**) of the peripheral coupling subassembly zone (**SG**), which can be wholly or partially occupied by a peripheral coupling subassembly (**PUG**), to which all the lines of the connector component connection (**VSC**), to which the respective peripheral coupling subassembly (**PUG**) can be electrically connected via one or more contact(s) (**CK**), assigned in at least one conductor track layer (**LO**, **L1**, **L2, L3**, **L4**) of the board which is predetermined for this purpose.

8. Intelligent peripheral coupling board (**IP**) according to one of claims 5 to 7, **characterized in that** at least one grid location (**RP**) is provided in the grid (**R**) of the peripheral coupling subassembly zone (**SG**), which can be wholly or partially occupied by a peripheral coupling subassembly (**PUG**), to which, in at least one conductor track layer (**LO**, **L1**, **L2**, **L3**, **L4**) of the board predetermined for this purpose, exactly one single line of the connector component connection (**VSC**) is assigned, to which the respective peripheral coupling subassembly (**PUG**) can be electrically connected via a single contact (**CK**).

9. An intelligent peripheral coupling board (**IP**) according to any one of claims 5 to 8, **characterized in that** the peripheral coupling subassembly(s) (**PUG**) in the peripheral coupling subassembly zone (**SG**) occupy(s) all or part of one or more grid locations (**RP**) in the grid (**R**) of the peripheral coupling subassembly zone (**SG**).

10. An intelligent peripheral coupling board (**IP**) according to any one of claims 5 to 9, **characterized in that** the grid (**R**) of the peripheral coupling subassembly zone (**SG**) is designed such that the grid locations (**RP**) are arranged in a checkerboard manner.

11. Intelligent peripheral coupling board (**IP**) according to any one of claims 5 to 10, **characterized in that** the line(s) of the zone connection (**VZC**) connecting the programmable logic (**PL**) and/or the microcontroller subassembly (**MUG**) and/or the network coupling subassembly (**N**) to the peripheral coupling subassembly(s) (**PUG**) in the peripheral coupling subassembly zone (**SG**) are arranged in at most two conductor track layers of the board.

12. Intelligent peripheral coupling board (**IP**) according to any one of claims 5 to 11, **characterized in that** the line(s) of the connector component connection (**VSC**) connecting the peripheral coupling subassembly(s) (**PUG**) in the peripheral coupling subassembly zone (**SG**) to one or more pin(s) (**P**) of the connector component (**I/O-C**) are arranged in at most two conductor track layers of the board.

13. The intelligent peripheral coupling board (**IP**) according to claims 11 and 12, **characterized in that** the zone connection line(s) (**VZC**) and the connector component connection (**VSC**) line(s) are located in the same or the same two conductor track layers of the board.

14. Intelligent peripheral coupling board (**IP**) according to one of claims 5 to 13, **characterized in that** a - preferably real-time capable - field bus, preferably a so-called Industrial Ethernet, is provided as data network (**DN**).

15. A computer-aided method for modular creation of a trace layout (**IP-L**) for an intelligent peripheral coupling board (**IP**) to be manufactured according to any one of claims 5 to 14, wherein
selecting, from a computer database of pre-created trace layout modules (**LM**), a board trace layout (**IP-B-L**) with an associated peripheral coupling board basic type (**IP-B**) for the intelligent peripheral coupling board (**IP**) to be manufactured and storing it in a data memory for the trace layout (**IP-L-MEM**) of the intelligent peripheral coupling board (**IP**) to be manufactured, wherein the selected board trace layout (**IP-B-L**) for the the intelligent peripheral coupling board (**IP**) to be manufactured is
a network coupling subassembly trace layout for the network coupling subassembly (**N**), and/or
a microcontroller subassembly trace layout for the microcontroller subassembly (**MUG**), and
a peripheral coupling subassembly zone trace layout for the peripheral coupling subassembly zone (**SG**), and
a zone connection trace layout for a zone connection (**VZC**) from the peripheral coupling subassembly zone (**SG**) to the programmable logic (**PL**) and/or to the microcontroller subassembly (**MUG**) and/or to the network coupling subassembly (**N**); and
comprising a connector component connection trace layout for a connector component connection (**VSC**) from the peripheral coupling subassembly zone (**SG**) to the connector component (**I/O-C**),
and in which a respective peripheral coupling subassembly trace layout (**PUG-L**) for each peripheral coupling subassembly (**PUG**) which becomes part of the intelligent peripheral coupling assembly (**IP**) to be manufactured is selected from the computer database of pre-created trace layout modules (**LM**) and is also stored in the trace layout data memory (**IP-L-MEM**) of the intelligent peripheral coupling assembly (**IP**) to be manufactured,
**characterized in that**
for each peripheral coupling subassembly (**PUG**) which becomes part of the intelligent peripheral coupling board (**IP**) to be manufactured, the grid location (**RP**) or grid locations (**RP**) in the grid (**R**) of the peripheral coupling subassembly zone (**SG**) occupied by the respective peripheral coupling subassembly (**PUG**) is or are selected, wherein
the board trace layout (**IP-B-L**) stored in the data memory for the trace layout (**IP-L-MEM**) of the intelligent peripheral coupling board (**IP**) to be manufactured is designed for the intelligent peripheral coupling Board (**IP**) to be manufactured such that
in each case at least one grid location (**RP**) thus selected in the grid (**R**) of the peripheral coupling subassembly zone (**SG**) which the respective peripheral coupling subassembly (**PUG**) occupies in whole or in part, in at least one conductor track layer (**LO**, **L1**, **L2**, **L3**, **L4**) of the intelligent peripheral coupling board (**IP**) to be manufactured, one or more lines of the zone connection (**VZC**) is or are assigned to the programmable logic (**PL**) and/or to the microcontroller subassembly (**MUG**) and/or to the network coupling subassembly (**N**) to which the respective peripheral coupling subassembly (**PUG**) can be electrically connected via one or more contacting(s) (**ZK**), and
in each case at least one grid location (**RP**) thus selected in the grid (**R**) of the peripheral coupling subassembly zone (**SG**) which the respective peripheral coupling subassembly (**PUG**) occupies in whole or in part, in at least one conductor track layer (**LO**, **L1**, **L2**, **L3**, **L4**) of the intelligent peripheral coupling board (**IP**) to be produced, one or more line(s) of the connector component connection (**VSC**) to the connector component (**I/O-C**) is/are assigned, to which the respective peripheral coupling subassembly (**PUG**) can be electrically connected via one or more contact(s) (**CK**),
and for each peripheral coupling subassembly (**PUG**) that becomes part of the intelligent peripheral coupling board (**IP**) to be manufactured, at the grid location (**RP**) or grid locations (**RP**) that the respective peripheral coupling subassembly (**PUG**) occupies in whole or in part, the electrical connection(s) (**VZC**) required by the respective peripheral coupling subassembly (**PUG**) to the programmable logic (**PL**) and/or to the microcontroller subassembly (**MUG**) and/or to the network coupling subassembly (**N**), and the electrical connection(s) required by the respective peripheral coupling subassembly (**PUG**) are inserted into the selected trace layout (**IP-L**) of the intelligent peripheral coupling board (**IP**) to be manufactured and the respective selected peripheral coupling subassembly trace layout (**PUG-L**) of the respective peripheral coupling subassembly (**PUG**), which are stored in the data memory for the trace layout (**IP-L-MEM**) of the intelligent peripheral coupling board (**IP**) to be manufactured,
and so from the assembly
of the board trace layout (**IP-B-L**) selected from the computer database of pre-created trace layout modules (**LM**) for the creation of the trace layout (**IP-L**) for the intelligent peripheral coupling board (**IP**) to be manufactured and stored in the data memory for the trace layout (**IP-L-MEM**) of the intelligent peripheral coupling board (**IP**) to be manufactured, and the for each peripheral coupling subassembly (**PUG**) that becomes part of the intelligent peripheral coupling board (**IP**) to be manufactured, respective peripheral coupling subassembly trace layouts (**PUG-L**) selected from the computer database of pre-created trace layout modules (**LM**) and also stored in the trace layout data memory (**IP-L-MEM**) of the intelligent peripheral coupling board (**IP**) to be manufactured, and
the insertions of electrical connections (**CK**, **ZK**) made in the board trace layout (**IP-B-L**) of the intelligent peripheral coupling board (**IP**) to be manufactured and in the peripheral coupling subassembly trace layout (**PUG-L**) of each peripheral coupling subassembly (**PUG**), which becomes part of the intelligent peripheral coupling board (**IP**) to be manufactured,
in the data memory for the trace layout (**IP-L-MEM**) of the intelligent peripheral coupling assembly (**IP**) to be manufactured
the trace layout (**IP-L**) is created for the intelligent peripheral coupling board (**IP**) to be manufactured.

16. Computer-aided method for modular creation of a trace layout (**IP-L**) according to claim 15, **characterized in that** the electrical connection(s) (**VZC**) required by each peripheral coupling subassembly (**PUG**) which becomes part of the intelligent peripheral coupling board (**IP**) to be manufactured, respectively required electrical connection(s) (**VZC**) to the programmable logic (**PL**) and/or to the microcontroller subassembly (**MUG**) and/or to the network coupling subassembly (**N**), and respectively required electrical connection(s) (**VSC**) to the connector component (**I/O-C**) are inserted into the selected board trace layout (**IP-B-L**) of the intelligent peripheral coupling board (**IP**) and the respective selected peripheral coupling subassembly trace layout (**PUG-L**) of the respective peripheral coupling subassembly (**PUG**), which are stored in the data memory for the trace layout (**IP-L-MEM**) of the intelligent peripheral coupling board (**IP**) to be manufactured, as a conductor track through-plating (**CK**, **ZK**) between a conductor track respectively provided for this purpose in one of the conductor track layers (**LO**, **L1**, **L2**, **L3**, **L4**) of the peripheral coupling subassembly (**PUG**) and the respective conductor track provided therefore in the conductor track layer (**LO**, **L1**, **L2**, **L3**, **L4**) provided therefore of the intelligent peripheral coupling board (**IP**) to be manufactured.

17. Computer-aided method for modular creation of a trace layout (**IP-L)** according to claim 15 or 16, **characterized in that** a board trace layout (**IP-B-L**) for the intelligent peripheral coupling board (**IP**) to be manufactured is selected from the computer database of pre-created trace lay-out modules (**LM**), which also already has a programmable logic trace layout (**PL-L**) for the programmable logic (**PL**).

18. Computer-aided method for modular creation of a trace layout (**IP-L**) according to claim 15, 16 or 17, **characterized in that** for each peripheral coupling subassembly (**PUG**) which becomes part of the intelligent peripheral coupling assembly (**IP**) to be manufactured, also a programmable logic part trace layout (**PL-TL**) belonging to the respective peripheral coupling subassembly (**PUG**) for the programmable logic part (**PL**) required for the respective peripheral coupling subassembly(s) (**PUG**), is selected from the computer database of created trace layout modules (**LM**) and inserted to the selected board trace layout (**IP-B-L**) of the intelligent peripheral coupling board (**IP**) to be manufactured and thus by inserting the programmable logic part trace layouts (**PL-TL**) also a programmable logic trace layout (**PL-L**) for the programmable logic (**PL**) is created for the trace layout (**IP-L**) for the intelligent peripheral coupling board (**IP**) to be manufactured.

19. Computer-aided method for generating a component placement plan (**IP-BOM**) for an intelligent peripheral coupling board (**IP**) to be manufactured according to any one of claims 5 to 14, **characterized in that**
for the intelligent peripheral coupling board (**IP**) to be manufactured, a trace layout (**IP-L**) is created by the method according to any one of claims 15 to 18, and
using the trace layout (**IP-L**) and the trace layout modules (**IP-B-L**, **PUG-L**) selected when creating the trace layout (**IP-L**), and
on the basis of a component placement plan computer database (**BM**) comprising an associated module-component placement plan (**IP-B-L-BOM, PUG-L-BOM**) with component(s) used in the respective trace layout module (**IP-B-L, PUG-L**) and the position of the respective component in the respective trace layout module (**IP-B-L, PUG-L**) for the respective trace layout module (**IP-B-L**, **PUG-L**) from the computer database of pre-created trace layout modules (**LM**),
the component placement plan (**IP-BOM**) is created for the intelligent peripheral coupling board (**IP**) to be manufactured.

20. Computer-aided method for generating a circuit diagram (**IP-S**) for an intelligent peripheral coupling board (**IP**) to be manufactured according to any one of claims 5 to 14, **characterized in that**
for the intelligent peripheral coupling board (**IP**) to be manufactured, a trace layout (**IP-L**) is created by the method according to any one of claims 15 to 18, and
using the trace layout (**IP-L**) and the trace layout modules (**IP-B-L**, **PUG-L**) selected when creating the trace layout (**IP-L**), and
by means of a circuit diagram computer database (**SDM**) which has an associated circuit diagram module (**IP-B-L-S**, **PUG-L-S**) for the respective trace layout module (**IP-B-L**, **PUG-L**) from the computer database of pre-created trace layout modules (**LM**),
the circuit diagram (**IP-S**) for the intelligent peripheral coupling board (**IP**) to be manufactured is created.

21. Computer-aided method for creating logic programming (**IP-LO**) of a programmable logic (**PL**) for an intelligent peripheral coupling board (**IP**) to be manufactured according to any one of claims 5 to 14, **characterized in that**
for the intelligent peripheral coupling board (**IP**) to be manufactured, a printed circuit board layout (**IP-L**) is created according to the method of claim 17 or 18, and
using a logic programming module computer database (**LOM**) containing logic programming modules (**IP-B-LOM**, **PUG-LOM**) and thereby
for the selected peripheral coupling board basic type (**IP-B**), and/or
for each peripheral coupling subassembly (**PUG**) that becomes part of the intelligent peripheral coupling board (**IP**) to be manufactured and for which the programmable logic (**PL**) is required,
respectively comprising at least one associated logic programming module (**IP-B-LOM**, **PUG-LOM**) for the portion of the programmable logic (**PL**) required for the respective peripheral coupling subassembly(s) (**PUG**) and/or the selected peripheral coupling board basic type (**IP-B**),
for the selected peripheral coupling board basic type (**IP-B**) and/or
for each peripheral coupling subassembly (**PUG**) that becomes part of the intelligent peripheral coupling board (**IP**) to be manufactured and for which the programmable logic (**PL**) is required,
the logic programming module or modules (**IP-B-LOM**, **PUG-LOM**) associated with the respective peripheral coupling subassembly (**PUG**) and/or with the selected peripheral coupling board basic type (**IP-B**) is or are selected from the logic programming module computer database (**LOM**) and added to the contents of a logic programming data memory (**IP-LOM-MEM**) of the programmable logic (**PL**) for the intelligent peripheral coupling board (**IP**) to be manufactured, and
the logic programming (**IP-LO**) for the programmable logic (**PL**) thus created in the logic programming data memory (**IP-LOM-MEM**) by adding the respective logic programming module (**IP-B-LOM**, **PUG-LOM**) is adapted for the programmable logic (**PL**) for the intelligent peripheral coupling board (**IP**) to be manufactured in accordance with the created track layout (**IP-L**) for the intelligent peripheral coupling board (**IP**) to be manufactured - preferably corresponding with the programmable logic trace layout (**PL-L**) for the programmable logic (**PL**) -,
and so the logic programming (**IP-LO**) for the programmable logic (**PL**) for the intelligent peripheral coupling board (**IP**) to be manufactured is created in the logic programming data memory (**IP-LO-MEM**).

22. Computer-aided method for creating an intelligent peripheral coupling board process image structure (**IP-PIS**) of an intelligent peripheral coupling board (**IP**) to be manufactured according to any one of claims 5 to 14, **characterized in that**
for the intelligent peripheral coupling board (**IP**) to be manufactured, a trace layout (**IP-L**) is created by the method according to any one of claims 15 to 18, and
using a process image structure computer database (**PISD**) that contains a peripheral coupling subassembly process image structure (**PUG-PI**) for each peripheral coupling subassembly (**PUG**) that becomes part of the intelligent peripheral coupling board (**IP**) to be manufactured,
for each peripheral coupling subassembly (**PUG**) that becomes part of the intelligent peripheral coupling board (**IP**) to be manufactured, selecting from the process image structure computer database (**PISD**) the associated peripheral coupling subassembly process image structure (**PUG-PI**) of the intelligent peripheral coupling board (**IP**) and adding it to the contents of a process image structure data memory (**IP-PIS-MEM**) having the intelligent peripheral coupling board process image structure (**IP-PIS**) for the intelligent peripheral coupling assembly (**IP**) to be manufactured, and
a data arrangement is made in the intelligent peripheral coupling board process image structure (**IP-PIS**) on the basis of the trace layout (**IP-L**) created for the intelligent peripheral coupling board (**IP**) to be manufactured, which assigns the peripheral coupling subassembly process image structure (**PUG-PI**) of each peripheral coupling subassembly (**PUG**) of the intelligent peripheral coupling board (**IP**) to be manufactured to a data area of the intelligent peripheral coupling board process image structure (**IP-PIS**) of the intelligent peripheral coupling board (**IP**) to be manufactured,
and so the intelligent peripheral coupling board process image structure (**IP-PIS**) of the intelligent peripheral coupling board (**IP**) to be manufactured is created in the a process image structure data memory (**IP-PIS-MEM**).

23. Computer-aided method for creating microcontroller programming (**IP-MP**) for a microcontroller subassembly (**MUG**) for programmed operation of an intelligent peripheral coupling board (**IP**) to be manufactured according to any one of claims 5 to 14, **characterized in that**
for the intelligent peripheral coupling board (**IP**) to be manufactured, an intelligent peripheral coupling board process image structure (**IP-PIS**) is created according to the method of claim 22, and
using a microcontroller programming module computer database (**MPD**) containing microcontroller programming modules (**IP-B-MP**, **PUG-MP**) and thereby
for the selected peripheral coupling board basic type (**IP-B**), and/or
for each peripheral coupling subassembly (**PUG**) that becomes part of the intelligent peripheral coupling board (**IP**) to be manufactured,
respectively comprising an associated microcontroller programming module (**IP-B-MP**, **PUG-MP**) required for programmed operation of the respective peripheral coupling subassembly(s) (**PUG**) by the microcontroller subassembly (**MUG**) and/or the selected peripheral coupling board basic type (**IP-B**),
for the selected peripheral coupling board basic type (**IP-B**) and/or
for each peripheral coupling subassembly (**PUG**) that becomes part of the intelligent peripheral coupling board (**IP**) to be manufactured,
the microcontroller programming module or modules (**IP-B-MP**, **PUG-MP**) associated with the respective peripheral coupling subassembly (**PUG**) and/or with the selected peripheral coupling subassembly basic type (**IP-B**) is or are selected from the microcontroller programming module computer database (**MPD**) and added to the contents of a microcontroller programming data memory (**IP-MP-MEM**) of the intelligent peripheral coupling board (**IP**) to be manufactured, and
the microcontroller programming (**IP-MP**) thus created in the microcontroller programming data memory (**IP-MP-MEM**) by adding the respective microcontroller programming module (**IP-B-MP**, **PUG-MP**) is adapted for the intelligent peripheral coupling board (**IP**) to be manufactured in accordance with the data allocation from the peripheral coupling board process image structure (**IP-PIS**) for the intelligent peripheral coupling board (**IP**) to be manufactured, that the microcontroller programming module (**PUG-MP**) associated with the respective peripheral coupling subassembly (**PUG**) operates on the respective data area of the process image of the intelligent peripheral coupling board (**IP**) to be manufactured comprising the data of the respective peripheral coupling subassembly (**PUG**)
and so the microcontroller programming (**IP-MP**) for programmed operation of the intelligent peripheral coupling board (**IP**) to be manufactured is created in the microcontroller programming data memory (**IP-MP-MEM**).

24. Computer-aided method for manufacturing an intelligent peripheral coupling board (**IP**) according to any one of claims 5 to 14, **characterized in that** for the intelligent peripheral coupling board (**IP**) to be manufactured
- a trace layout (**IP-L**) is created by the method of any one of claims 15 to 18, and
- a component placement plan (**IP-BOM**) is created according to the method according to claim 19, and
the intelligent peripheral coupling board (**IP**) is manufactured by means of the trace layout (**IP-L**) created for the intelligent peripheral coupling board (**IP**) to be manufactured and the component placement plan (**IP-BOM**) created for the intelligent peripheral coupling board (**IP**) to be manufactured.

25. Computer-aided method for manufacturing an intelligent peripheral coupling board (**IP**) according to claim 24, **characterized in that** for the intelligent peripheral coupling board (**IP**) to be manufactured.
- a trace layout (**IP-L**) is created by the method of claim 17 or 18, and
- a logic programming (**IP-LO**) of a programmable logic (**PL**) for the intelligent peripheral coupling board (**IP**) to be manufactured is created according to the method of claim 21, and
the intelligent peripheral coupling board (**IP**) is also produced by means of the created logic programming (**IP-LO**) by programming the programmable logic (**PL**) located on the intelligent peripheral coupling board (**IP**) by means of the logic programming (**IP-LO**) created in the logic programming data memory (**IP-LOM-MEM**).

26. Computer-aided method for manufacturing an intelligent peripheral coupling board (**IP**) according to claim 24 or 25, **characterized in, that** for the intelligent peripheral coupling board (**IP**) to be manufactured, a microcontroller programming (**IP-MP**) of a microcontroller subassembly (**MUG**) for the programmed operation of the intelligent peripheral coupling board (**IP**) to be manufactured is created according to the method of claim 23, and the intelligent peripheral coupling board (**IP**) is also manufactured by means of the created microcontroller programming (**IP-MP**), by programming the microcontroller subassembly (**MUG**) located on the intelligent peripheral coupling board (**IP**) by means of the microcontroller programming (**IP-MP**) created in the microcontroller programming data memory (**IP-MP-MEM**).

27. Computer-aided method for configuring a data network-based system for controlling and/or regulating and/or monitoring at least one peripheral device (**PG**) by a - preferably central - control unit (**CON**) by means of data transmission between participants of a data network (**DN**), wherein
at least one intelligent peripheral coupling board (**IP**) according to any one of claims 5 to 14 is connected as a participant to the data network (**DN**), and
the control unit (**CON**) is also connected to the data network (**DN**) as a participant, wherein the control unit (**CON**) comprises
an control unit network coupling subassembly for coupling the control unit to the data network (**DN**),
at least one processor and at least one memory and
the control unit (**CON**) controls and/or regulates and/or monitors the peripheral device (**PG**) coupled to the respective peripheral coupling subassembly (**PUG**) by means of a respective software control module (**PUG-SSM**) belonging to the respective peripheral coupling subassembly (**PUG**) and stored in the memory of the control device by means of the transmission of a process image via the data network (**DN**), wherein the process image in a data area associated with the respective intelligent peripheral coupling board (**IP**) corresponds to an intelligent peripheral coupling board process image structure (**IP-PIS**), also stored in the memory of the control unit (**CON**), which belongs to the intelligent peripheral coupling board (**IP**) comprising the respective peripheral coupling subassembly (**PUG**) serving for controlling and/or regulating and/or monitoring the peripheral device (**PG**),
**characterized in that**
by means of a peripheral coupling subassembly computer database (**PUGDB**), which provides a technical peripheral coupling subassembly specification (**PUG-TS**) for the respective peripheral coupling subassembly (**PUG**), which at least comprises the size of the respective peripheral coupling subassembly (**PUG**) in required grid locations (**RP**) in the grid of the peripheral coupling subassembly zone (**SG**) of the respective intelligent peripheral coupling board (**IP**),
Peripheral Coupling Subassemblies (**PUG**) are selected to become part of the intelligent data network-based system to be configured for control and/or regulation and/or monitoring,
using a computer database of intelligent peripheral coupling assemblies (**IPDB**) from which a peripheral coupling assembly specification (**IP-SPEC**) is to be taken which at least specifies which peripheral coupling subassemblies (**PUG**) the respective peripheral coupling board (**IP**) is capable to place in the peripheral coupling subassembly zone (**SG**) comprising the grid (**R**) with the plurality of grid locations (**RP**),
the selected peripheral coupling subassemblies (**PUG**) are distributed (**D**) to at least one intelligent peripheral coupling board (**IP**) for placement, and
for each of the intelligent peripheral coupling boards (**IP**) thus provided for receiving peripheral coupling subassemblies (**PUGs**), an intelligent peripheral coupling board process image structure (**IP-PIS**) is determined according to the method of claim 22, and
using a peripheral coupling subassembly software module computer database (**SSMDB**) comprising software control modules (**PUG-SSM**) associated with peripheral coupling subassemblies (**PUG**),
for each peripheral coupling subassembly (**PUG**) which becomes part of the intelligent data network-based system to be configured for control and/or regulation and/or monitoring, the software control module (**PUG-SSM**) associated with the respective peripheral coupling subassembly (**PUG**) is selected, and
in the memory of the control unit (**CON**), the determined intelligent peripheral coupling board process image structure (**IP-PIS**) of each intelligent peripheral coupling board (**IP**) provided for placing peripheral coupling subassemblies (**PUG**) and the selected software control modules (**PUG-SSM**) associated with the peripheral coupling subassemblies (**PUG**) are stored, which become part of the intelligent data network-based system to be configured for control and/or regulation and/or monitoring.

28. Computer-aided method for configuring a data network-based system for controlling and/or regulating and/or monitoring at least one peripheral device (**PG**) by a control unit (**CON**) by means of data transmission between participants (**CON**, **IP**) of a data network (**DN**) according to claim 27, **characterized in that** a - preferably real-time capable - field bus, preferably an industrial Ethernet, is used as the data network (**DN**).

29. Computer-aided method for configuring a data network-based system for controlling and/or regulating and/or monitoring at least one peripheral device (**PG**) by a control unit (**CON**) by means of data transmission between participants (**CON**, **IP**) of a data network (**DN**) according to claim 27, **characterized in that**
during the transmission of the process image or process images between the participants (**CON**, **IP**) of the data network (**DN**), a data telegram is further transmitted from participant (**CON**, **IP**) to participant (**CON**, **IP**), and
for each participant (**CON**, **IP**), a data area is provided in the data telegram which is intended for data from or for this participant (**CON**, **IP**), and where the respective participant (**CON**, **IP**) can write data into the area of the data telegram which is intended for data from this participant (**CON**, **IP**), or where the respective participant (**CON**, **IP**) can read data from the area of the data telegram which is intended for data for this participant (**CON**, **IP**), and
the data telegram starts from the control unit (**CON**) and, after reception by the last participant (**IP**) of the data network (**DN**), is transmitted back to the control unit (**CON**), and entries about the structure of the data telegram are also stored in the memory of the control unit (**CON**) to the effect that which respective data area of the data telegram is provided for the process image of which intelligent peripheral coupling board (**IP**) as participant of the data network (**DN**).

## Revendications

1. Ensemble de couplage périphérique intelligent (**IP**) comprenant, sur une carte de circuit imprimé comportant au moins une couche de pistes conductrices, des sous-ensembles, dans lequel
un sous-ensemble de couplage au réseau (**N**) pour coupler le sous-ensemble de couplage périphérique (**IP**) à au moins un appareil de commande (**CON**) - de préférence central - via un réseau de données (**DN**), ainsi que
dans une zone de sous-ensembles de couplage de périphériques (**SG**) de la carte, une zone pour un ou plusieurs sous-ensembles de couplage de périphériques (**PUG**) pour le couplage avec au moins un appareil périphérique (**PG**) à commander et/ou à régler et/ou à surveiller, et
au moins un composant connecteur (**I/O-C**) pour la connexion électrique ou optique ou sans fil du ou des sous-ensembles de couplage périphérique (**PUG**) avec le ou les dispositifs périphériques (**PG**)
est prévu, dans lequel
le sous-ensemble de couplage de réseau (**N**) comprend une connexion de zone (**VZC**) en tant que connexion électrique via une ou plusieurs lignes au(x) sous-ensemble(s) de couplage de périphérique (**PUG**) dans la zone de sous-ensemble de couplage de périphérique (**SG**), qui sert à commander le(s) sous-ensemble(s) de couplage de périphérique (**PUG**) et
le(s) sous-ensemble(s) de couplage périphérique (**PUG**) dans la zone de sous-ensemble de couplage périphérique (**SG**) comportent) chacun une connexion de dispositif de connexion (**VSC**) pour une connexion électrique via une ou plusieurs ligne(s) à une ou plusieurs broche(s) (**P**) du dispositif de connexion (**I/O-C**),
**caractérisé en ce que**
le(s) sous-ensemble(s) de couplage périphérique (**PUG**) est/sont aligné(s) dans la zone de sous-ensemble de couplage périphérique (**SG**) sur une grille (**R**) ayant plusieurs emplacements de grille (**RP**), dans lequel
il est prévu au moins un emplacement de grille (**RP**) dans la grille (**R**) de la zone de sous-ensembles de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, une ou plusieurs ligne(s) de la connexion de zone (**VZC**) est/sont associée(s), à laquelle/auxquelles le sous-ensemble de couplage périphérique (**PUG**) respectif peut être connecté électriquement par l'intermédiaire d'un ou de plusieurs contact(s) (**ZK**), et
il est prévu au moins un emplacement de grille (**RP**) dans la grille (**R**) de la zone de sous-ensembles de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, une ou plusieurs ligne(s) de la connexion de composant de connexion (**VSC**) est ou sont associée(s), à laquelle ou auxquelles le sous-ensemble de couplage périphérique (**PUG**) respectif peut être connecté électriquement par l'intermédiaire d'un ou plusieurs contact(s) (**CK**).

2. Sous-ensemble de couplage périphérique intelligent (**IP**) selon la revendication 1, **caractérisé en ce que** le sous-ensemble de couplage réseau (**N**) présente un circuit intégré spécifique à l'application avec des entrées et/ou des sorties numériques qui peuvent être réglées ou lues en fonction des données reçues et/ou envoyées via le réseau de données (**DN**) vers l'appareil de commande - de préférence central - (**CON**).

3. Ensemble de couplage périphérique intelligent (**IP**) comprenant, sur une carte de circuit imprimé comportant au moins une couche de pistes conductrices, des sous-ensembles, dans lequel
un sous-ensemble microcontrôleur (**MUG**) pour le fonctionnement programmé du module de couplage périphérique (**IP**), ainsi que
dans une zone de sous-ensembles de couplage de périphériques (**SG**) de la carte, une zone pour un ou plusieurs sous-ensembles de couplage de périphériques (**PUG**) pour le couplage avec au moins un appareil périphérique (**PG**) à commander et/ou à régler et/ou à surveiller, et
au moins un composant connecteur (**I/O-C**) pour la connexion électrique ou optique ou sans fil du ou des sous-ensembles de couplage périphérique (**PUG**) avec le ou les dispositifs périphériques (**PG**)
est prévu, dans lequel
le sous-ensemble microcontrôleur (**MUG**) comprend une connexion de zone (**VZC**) en tant que connexion électrique via une ou plusieurs lignes avec le ou les sous-ensembles de couplage périphérique (**PUG**) dans la zone de sous-ensemble de couplage périphérique (**SG**), qui sert à commander le ou les sous-ensembles de couplage périphérique (**PUG**), et
le(s) sous-ensemble(s) de couplage périphérique (**PUG**) dans la zone de sous-ensemble de couplage périphérique (**SG**) comportent) chacun une connexion de dispositif de connexion (**VSC**) pour une connexion électrique via une ou plusieurs ligne(s) à une ou plusieurs broche(s) (**P**) du dispositif de connexion (**I/O-C**),
**caractérisé en ce que**
le(s) sous-ensemble(s) de couplage périphérique (**PUG**) est/sont aligné(s) dans la zone de sous-ensemble de couplage périphérique (**SG**) sur une grille (**R**) ayant plusieurs emplacements de grille (**RP**), dans lequel
il est prévu au moins un emplacement de grille (**RP**) dans la grille (**R**) de la zone de sous-ensembles de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, une ou plusieurs ligne(s) de la connexion de zone (**VZC**) est/sont associée(s), à laquelle/auxquelles le sous-ensemble de couplage périphérique (**PUG**) respectif peut être connecté électriquement par l'intermédiaire d'un ou de plusieurs contact(s) (**ZK**), et
Il est prévu au moins un emplacement de grille (**RP**) dans la grille (**R**) de la zone de sous-ensembles de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, une ou plusieurs ligne(s) de la connexion de composant de connexion (VS**C**) est ou sont associée(s), à laquelle ou auxquelles le sous-ensemble de couplage périphérique (**PUG**) respectif peut être connecté électriquement par l'intermédiaire d'un ou plusieurs contact(s) (**CK**).

4. Ensemble de couplage périphérique intelligent (**IP**) comprenant, sur une carte de circuit imprimé comportant au moins une couche de pistes conductrices, des sous-ensembles, dans lequel
une logique programmable (**PL**) pour le raccordement à un ou plusieurs sous-ensembles de couplage de périphériques (**PUG**), qui servent au couplage avec au moins un appareil périphérique (**PG**) à commander et/ou à régler et/ou à surveiller, ainsi que
dans une zone de sous-ensembles de couplage de périphériques (**SG**) de la carte, une zone pour le(s) sous-ensemble(s) de couplage de périphériques (**PUG**) pour le couplage avec au moins l'un des appareils périphériques (**PG**) à commander et/ou à régler et/ou à surveiller, et
au moins un composant connecteur (**I/O-C**) pour la connexion électrique ou optique ou sans fil du ou des sous-ensembles de couplage périphérique (**PUG**) avec le ou les dispositifs périphériques (**PG**)
est prévu, dans lequel
la logique programmable (**PL**) comprend une connexion de zone (**VZC**) en tant que connexion électrique via une ou plusieurs lignes au(x) sous-ensemble(s) de couplage périphérique (**PUG**) dans la zone de sous-ensemble de couplage périphérique (**SG**), qui sert à commander le(s) sous-ensemble(s) de couplage périphérique (**PUG**), et
le(s) sous-ensemble(s) de couplage périphérique (**PUG**) dans la zone de sous-ensemble de couplage périphérique (**SG**) comportent) chacun une connexion de dispositif de connexion (**VSC**) pour une connexion électrique via une ou plusieurs ligne(s) à une ou plusieurs broche(s) (**P**) du dispositif de connexion (**I/O-C**),
**caractérisé en ce que**
le(s) sous-ensemble(s) de couplage périphérique (**PUG**) est/sont aligné(s) dans la zone de sous-ensemble de couplage périphérique (**SG**) sur une grille (**R**) ayant plusieurs emplacements de grille (**RP**), dans lequel
il est prévu au moins un emplacement de grille (**RP**) dans la grille (**R**) de la zone de sous-ensembles de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, une ou plusieurs ligne(s) de la connexion de zone (**VZC**) est/sont associée(s), à laquelle/auxquelles le sous-ensemble de couplage périphérique (**PUG**) respectif peut être connecté électriquement par l'intermédiaire d'un ou de plusieurs contact(s) (**ZK**), et
Il est prévu au moins un emplacement de grille (**RP**) dans la grille (**R**) de la zone de sous-ensembles de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, une ou plusieurs ligne(s) de la connexion de composant de connexion (**VSC**) est ou sont associée(s), à laquelle ou auxquelles le sous-ensemble de couplage périphérique (**PUG**) respectif peut être connecté électriquement par l'intermédiaire d'un ou plusieurs contact(s) (**CK**).

5. Ensemble de couplage périphérique intelligent (**IP**) comprenant
un ensemble de couplage périphérique intelligent selon la revendication 1 ou 2,
et/ou un ensemble de couplage périphérique intelligent selon la revendication 3,
et/ou un ensemble de couplage périphérique intelligent selon la revendication 4,
**caractérisé en ce que** différentes zones (**A**, **M**, **L**) prévues pour les sous-ensembles sont disposées sur la platine, où
le sous-ensemble de couplage au réseau (**N**) dans une première zone (**A**) de la carte,
le sous-ensemble microcontrôleur (**MUG**) dans une deuxième zone (**M**) de la carte, et
la logique programmable (**PL**) dans une troisième zone (**L**) de la platine
est prévue.

6. Ensemble de couplage périphérique intelligent (**IP**) selon la revendication 5, **caractérisé en ce qu'**il est prévu au moins un emplacement de grille (**RP**) dans la grille (**R**) de la zone de sous-ensemble de couplage périphérique (**SG**), qu'un sous-ensemble de couplage périphérique (**PUG**) peut occuper entièrement ou partiellement, auquel sont associées, dans au moins une couche de pistes conductrices prédéterminée a cet effet (**LO**, **L1**, **L2**, **L3**, **L4**) de la platine, toutes les lignes de la liaison de zone (**VZC**) avec laquelle le sous-ensemble de couplage périphérique (**PUG**) respectif peut être relié électriquement par l'intermédiaire d'un ou de plusieurs contacts (**ZK**).

7. Ensemble de couplage périphérique intelligent (**IP**) selon l'une des revendications 5 ou 6, **caractérisé en ce qu'**il est prévu au moins un emplacement de grille (**RP**) dans la grille (**R**) de la zone de sous-ensemble de couplage périphérique (**SG**), qu'un sous-ensemble de couplage périphérique (**PUG**) peut occuper entièrement ou partiellement, auquel sont associées, dans au moins une couche de pistes conductrices prédéterminée a cet effet (**LO**, **L1**, **L2**, **L3**, **L4**) de la platine, toutes les lignes de la connexion de composant de connexion (**VSC**) avec laquelle le sous-ensemble de couplage périphérique (**PUG**) concerné peut être connecté électriquement par l'intermédiaire d'un ou de plusieurs contacts (**CK**).

8. Ensemble de couplage périphérique intelligent (**IP**) selon l'une des revendications 5 à 7, **caractérisé en ce qu'**il est prévu au moins un emplacement de grille (**RP**) dans la grille (**R**) de la zone de sous-ensemble de couplage périphérique (**SG**), qu'un sous-ensemble de couplage périphérique (**PUG**) peut occuper entièrement ou partiellement, auquel est associé, dans au moins une couche de pistes conductrices prédéterminée a cet effet (**LO**, **L1**, **L2**, **L3**, **L4**) de la platine, exactement une seule ligne de la connexion de composant de connexion (**VSC**), avec laquelle le sous-groupe de couplage périphérique (**PUG**) respectif peut être relié électriquement par l'intermédiaire d'un seul contact (**CK**).

9. Ensemble de couplage périphérique intelligent (**IP**) selon l'une quelconque des revendications 5 à 8, **caractérisé en ce que** le ou les sous-ensembles de couplage périphérique (**PUG**) occupent ou occupent dans la zone de sous-ensembles de couplage périphérique (**SG**) un emplacement de grille (**RP**) ou plusieurs emplacements de grille (**RP**) dans la grille (**R**) de la zone de sous-ensembles de couplage périphérique (**SG**), en totalité ou en partie.

10. Ensemble de couplage périphérique intelligent (**IP**) selon l'une quelconque des revendications 5 à 9, **caractérisé en ce que** le quadrillage (**R**) de la zone de sous-ensemble de couplage périphérique (**SG**) est construit de manière à ce que les emplacements de quadrillage (**RP**) soient disposés en damier.

11. Ensemble de couplage périphérique intelligent (**IP**) selon l'une des revendications 5 à 10, **caractérisé en ce que** la ou les lignes de la connexion de zone (**VZC**) reliant la logique programmable (**PL**) et/ou le sous-ensemble microcontrôleur (**MUG**) et/ou le sous-ensemble de couplage réseau (**N**) au(x) sous-ensemble(s) de couplage périphérique (**PUG**) dans la zone de sous-ensemble de couplage périphérique (**SG**) sont disposées dans deux couches de pistes conductrices au maximum de la carte.

12. Ensemble de couplage périphérique intelligent (**IP**) selon l'une des revendications 5 à 11, **caractérisé en ce que** la ou les lignes de la connexion de module de connexion (**VSC**) qui connectent le ou les sous-ensembles de couplage périphérique (**PUG**) dans la zone de sous-ensembles de couplage périphérique (**SG**) à une ou plusieurs broches (**P**) du module de connexion (**I/O-C**) sont disposées dans deux couches de pistes conductrices de la carte au maximum.

13. Ensemble de couplage périphérique intelligent (**IP**) selon les revendications 11 et 12, **caractérisé en ce que** le(s) conducteur(s) de la connexion de zone (**VZC**) et le(s) conducteur(s) de la connexion de composant de connecteur (**VSC**) sont disposés dans la même couche de pistes conductrices ou dans les deux mêmes couches de pistes conductrices de la carte.

14. Ensemble de couplage périphérique intelligent (**IP**) selon l'une des revendications 5 à 13, **caractérisé en ce qu'**il est prévu comme réseau de données (**DN**) un bus de terrain - de préférence apte à fonctionner en temps réel -, de préférence ce qu'on appelle un Ethernet industriel.

15. Procédé assisté par ordinateur pour la création modulaire d'un layout de pistes conductrices (**IP-L**) pour un esemble de couplage périphérique intelligent (**IP**) à fabriquer selon l'une des revendications 5 à 14, dans laquelle
à partir d'une base de données d'ordinateur de modules (**LM**) de disposition de pistes préétablis, on sélectionne une disposition de pistes de module (**IP-B-L**) avec un type de base de module de couplage périphérique (**IP-B**) associé pour le ensemble de couplage périphérique intelligent (**IP**) à fabriquer et on l'enregistre dans une mémoire de données pour la disposition de pistes (**IP-L-MEM**) du esemble de couplage périphérique intelligent (**IP**) à fabriquer, dans lequel le layout de circuit imprimé de module (**IP-B-L**) sélectionné pour le ensemble de couplage périphérique intelligent (**IP**) à produire comprend
un layout de pistes conductrices pour le sous-ensemble de couplage de réseau (**N**), et/ou
un layout de pistes conductrices pour le sous-ensemble de microcontrôleur (**MUG**), et
un layout de pistes conductrices pour la zone de sous-ensemble de couplage de périphérique (**SG**), et
un layout de pistes conductrices pour une connexion de zone (**VZC**) de la zone de sous-ensemble de couplage de périphérique (**SG**) à la logique programmable (**PL**) et/ou au sous-ensemble de microcontrôleur (**MUG**) et/ou au sous-ensemble de couplage de réseau (**N**), et
un layout de pistes conductrices pour une connexion de dispositif de connexion (**VSC**) de la zone de sous-ensemble de couplage périphérique (**SG**) au dispositif de connexion (**I/O-C**),
et dans lequel un layout de pistes conductrices de sous-ensemble de couplage de périphérique (**PUG-L**) respectif pour chaque sous-ensemble de couplage de périphérique (**PUG**) qui devient un composant du ensemble de couplage de périphérique intelligent (**IP**) à fabriquer est sélectionné à partir de la base de données d'ordinateur des modules de agencement de pistes conductrices (**LM**) préétablis et est également stocké dans la mémoire de données pour le layout de pistes conductrices (**IP-L-MEM**) du ensemble de couplage de périphérique intelligent (**IP**) à fabriquer,
**caractérisé en ce que**
pour chaque sous-ensemble de couplage périphérique (**PUG**) qui devient une partie intégrante du sous-ensemble de couplage périphérique intelligent (**IP**) à fabriquer, l'emplacement de grille (**RP**) ou les emplacements de grille (**RP**) dans la grille (**R**) de la zone de sous-ensemble de couplage périphérique (**SG**) que le sous-ensemble de couplage périphérique (**PUG**) respectif occupe ou occupe est/sont sélectionné(s), où
le layout des pistes conductrices du ensemble de couplage périphérique intelligent (**IP**) à fabriquer, enregistré dans la mémoire de données pour le layout des pistes conductrices du module (**IP-B-L**), est conçu pour le module de couplage périphérique intelligent (**IP**) à fabriquer de telle sorte que
au moins un emplacement de grille (**RP**) ainsi sélectionné dans la grille (**R**) de la zone de sous-ensemble de couplage périphérique (**SG**), que le sous-ensemble de couplage périphérique (**PUG**) respectif occupe entièrement ou partiellement, dans au moins une couche de piste conductrice prédéterminée a cet effet (**LO**, **L1**, **L2**, **L3**, **L4**) du module de couplage périphérique intelligent (**IP**) à fabriquer, une ou plusieurs ligne(s) de la connexion de zone (**VZC**) à la logique programmable (**PL**) et/ou au sous-ensemble de microcontrôleur (**MUG**) et/ou au sous-ensemble de couplage de réseau (**N**) est/sont associée(s), à laquelle/auxquelles le sous-ensemble de couplage périphérique (**PUG**) respectif peut être connecté électriquement par l'intermédiaire d'un ou de plusieurs contact(s) (**ZK**), et
au moins un emplacement de grille (**RP**) ainsi sélectionné dans la grille (**R**) de la zone de sous-ensemble de couplage périphérique (**SG**), que le sous-ensemble de couplage périphérique (**PUG**) respectif occupe entièrement ou partiellement, dans au moins une couche de piste conductrice prédéterminée a cet effet (**LO**, **L1**, **L2**, **L3**, **L4**) du module de couplage périphérique intelligent (**IP**) à fabriquer, une ou plusieurs ligne(s) de la liaison (**VSC**) du module de connexion au module de connexion (**I/O-C**) est/sont associée(s), à laquelle/auxquelles le sous-module de couplage périphérique (**PUG**) respectif peut être relié(s) électriquement par l'intermédiaire d'une ou de plusieurs prise(s) de contact (**CK**),
et pour chaque sous-ensemble de couplage périphérique (**PUG**) qui devient partie intégrante du module de couplage périphérique intelligent (**IP**) à fabriquer, à l'emplacement de grille (**RP**) ou aux emplacements de grille (**RP**) que le sous-ensemble de couplage périphérique (**PUG**) concerné occupe entièrement ou partiellement, la (les) connexion(s) électrique(s) (**VZC**) requise(s) par le sous-ensemble de couplage périphérique (**PUG**) respectif vers la logique programmable (**PL**) et/ou vers le sous-ensemble de microcontrôleur (**MUG**) et/ou vers le sous-ensemble de couplage réseau (**N**) ainsi que le (les) connexion(s) électrique(s) (**VSC**) au dispositif de connexion (**I/O-C**) dans la configuration de layout de pistes conductrices sélectionnée (**IP-L**) du module de couplage périphérique intelligent (**IP**) à fabriquer et la configuration de circuit imprimé de sous-ensemble de couplage périphérique sélectionnée respective (**PUG-L**) du sous-ensemble de couplage périphérique respectif (**PUG**), qui sont stockées dans la mémoire de données pour la disposition des pistes conductrices (**IP-L-MEM**) du module de couplage périphérique intelligent (**IP**) à fabriquer, être inséré
et donc à partir de l'assemblage des
pistes préétablis sélectionné à partir de la base de données informatique (**LM**) de modules de layout de pistes imprimé préétablis (**LM**) pour la création du layout de circuit imprimé (**IP-L**) pour le module de couplage périphérique intelligent (**IP**) à fabriquer et stocké dans la mémoire de données pour le lay-out de circuit imprimé (**IP-L-MEM**) du module de couplage périphérique intelligent (**IP**) à fabriquer et du lay-out de circuit imprimé de sous-ensemble (**IP-B-L**)
du layout des pistes de sous-ensembles de couplage périphérique (**PUG-L**) pour chaque sous-ensemble de couplage périphérique (**PUG**), sélectionné respectivement dans la base de données informatique de modules de schéma de circuit (**LM**) préétablis et également stocké dans la mémoire de données pour le layout de circuit imprimé (**IP-L-MEM**) du sous-ensemble de couplage périphérique intelligent (**IP**) à fabriquer, qui devient un composant du sous-ensemble de couplage périphérique intelligent (**IP**) à fabriquer, et
les insertions de connexions électriques (**CK**, **ZK**) dans le layout de circuit imprimé de sous-ensemble (**IP-B-L**) du module de couplage périphérique intelligent (**IP**) à fabriquer et dans le configuration de circuit imprimé de sous-ensemble de couplage périphérique (**PUG-L**) de chaque sous-ensemble de couplage périphérique (**PUG**), qui devient partie intégrante du module de couplage périphérique intelligent (**IP**) à fabriquer, dans la mémoire de données pour la disposition des pistes (**IP-L-MEM**) du module de couplage périphérique intelligent (**IP**) à fabriquer
le layout des pistes conductrices (**IP-L**) est créé pour le module de couplage périphérique intelligent (**IP**) à fabriquer.

16. Procédé assisté par ordinateur pour la création modulaire d'un layout de pistes conductrices (**IP-L**) selon la revendication 15, **caractérisé en ce que** le ou les éléments électriques requis par chaque sous-ensemble de couplage périphérique (**PUG**) qui devient une partie de l'ensemble de couplage périphérique intelligent (**IP**) à réaliser Connexion(s) (**VZC**) à la logique programmable (**PL**) et/ou au sous-ensemble microcontrôleur (**MUG**) et/ou au sous-ensemble de couplage réseau (**N**) ainsi que les connexions électriques requises (**VSC**) au composant de connecteur (**I/O-C**) dans la configuration de layout de circuit imprimé de sous-ensemble sélectionnée (**IP-B-L**) de l'ensemble de couplage périphérique intelligent (**IP**) et de layout des pistes de sous-ensembles de couplage périphérique respectivement sélectionnée (**PUG-L**) du couplage périphérique respectif sous-ensemble (**PUG**), qui est stocké dans la mémoire de données pour le layout de circuit imprimé (**IP-L-MEM**) de l'ensemble de couplage périphérique intelligent (**IP**) à fabriquer, est stocké sous forme de placage traversant de piste conductrice (**CK**, **ZK**) entre un piste conductrice prévue à cet effet dans l'une des couches de pistes conductrices (**LO**, **LI**, **L2**, **L3**, **L4**) du sous-ensemble de couplage périphérique (**PUG**) et la piste conductrice prévue à cet effet dans la couche de pistes conductrices prévue à cet effet (**LO**, **LI**, **L2**, **L3**, **L4**) de l'ensemble de couplage périphérique intelligent (**IP**) à réaliser est inséré.

17. Procédé assisté par ordinateur pour la création modulaire d'un layout de pistes conductrices (**IP-L**) selon la revendication 15 ou 16, **caractérisé en ce qu'**à partir de la base de données informatique des modules de layout de pistes conductrices (**LM**) préfabriqués, un layout de pistes conductrices (**IP-B-L**) pour le module de couplage intelligent (**IP**) est sélectionné, le dispose également déjà d'une disposition de carte de circuit logique programmable (PL-L) pour la logique programmable (**PL**).

18. Procédé assisté par ordinateur pour la création modulaire d'un layout de pistes conductrices (**IP-L**) selon la revendication 15, 16 ou 17, **caractérisé en ce que**, pour chaque sous-ensemble de couplage périphérique (**PUG**) qui fait partie du module de couplage périphérique intelligent (**IP**) à fabriquer, un layout de pistes conductrices de partie de logique programmable (**PL-TL**) appartenant au sous-ensemble de couplage périphérique (**PUG**) respectif pour la partie de logique programmable (**PL**) et stockée dans la mémoire de données de configuration de circuits imprimés (**IP-PL-MEM**) du module de couplage périphérique intelligent (**IP**) à fabriquer de la base de données informatique des modules de configuration de circuits imprimés (**LM**) préfabriqués est sélectionnés et est insérée dans la configuration de circuits imprimés d'assemblage (**IP-B-L**) du module de couplage périphérique intelligent (**IP**) à fabriquer et ainsi, en insérant les layout des pistes conductrices de circuit partiel de logique programmable (**PL-TL**), la layout de pistes conductrices (**IP-L**) est créée pour le module de couplage périphérique intelligent (**IP**) à fabriquer et également une layout de pistes conductrice de logique programmable (**PL-L**) pour la logique programmable (**PL**).

19. Procédé assisté par ordinateur pour l'élaboration d'un plan d'assemblage de composants (**IP-BOM**) pour un module de couplage périphérique intelligent (**IP**) à fabriquer selon l'une des revendications 5 à 14, **caractérisé en ce que**
pour le module de couplage périphérique intelligent (**IP**) à fabriquer, un layout de pistes conductrices (**IP-L**) est établi selon le procédé selon l'une des revendications 15 à 18 et
à l'aide du layout des pistes conductrices (**IP-L**) et des modules de layout des pistes (**IP-B-L**, **PUG-L**) sélectionnés lors de la création du layout des pistes (**IP-L**), ainsi que
à l'aide d'une base de données informatique (**BM**) de plan de montage de composants, qui comporte, pour le module respectif (**IP-B-L**, **PUG-L**) d'agencement de pistes conductrices, à partir de la base de données informatique de modules (**LM**) d'agencement de pistes conductrices préfabriqués, un plan de montage de composants de module associé (**IP-B-L-BOM**, **PUG-L-BOM**) avec le ou les composants utilisés dans le module respectif (**IP-B-L**, **PUG-L**) d'agencement de pistes conductrices et la position du composant respectif dans le module re**s**pectif (**IP-B-L**, **PUG-L**) d'agencement de pistes conductrices,
le plan d'assemblage des composants (**IP-BOM**) est établi pour le module de couplage périphérique intelligent (**IP**) à fabriquer.

20. Procédé assisté par ordinateur pour établir un schéma de câblage (**IP-S**) pour un ensemble de couplage périphérique intelligent (**IP**) à fabriquer, selon l'une quelconque des revendications 5 à 14, **caractérisé en ce que**
pour le module de couplage périphérique intelligent (**IP**) à fabriquer, un layout de pistes conductrices (**IP-L**) est établi selon le procédé selon l'une des revendications 15 à 18 et
à l'aide du layout des pistes conductrices (**IP-L**) et des modules de layout des pistes (**IP-B-L**, **PUG-L**) sélectionnés lors de la création du layout des pistes (**IP-L**), ainsi que
à l'aide d'une base de données informatique de schémas (SDM), qui comporte un module de schémas (**IP-B-L-S**, **PUG-L-S**) associé au module de disposition de pistes (**IP-B-L**, **PUG-L**) respectif à partir de la base de données informatique de modules de disposition de pistes (**LM**) préétablis,
le schéma de câblage (**IP-S**) pour le module de couplage périphérique intelligent (**IP**) à fabriquer est établi.

21. Procédé assisté par ordinateur pour établir une programmation logique (**IP-LO**) d'une logique programmable (**PL**) pour un module de couplage périphérique intelligent (**IP**) à fabriquer selon l'une des revendications 5 à 14, **caractérisé en ce que**
un layout de pistes conductrices (**IP-L**) est établi pour le module de couplage périphérique intelligent (**IP**) à fabriquer selon le procédé de la revendication 17 ou 18 et
à partir d'une base de données informatique de modules de programmation logique (**LOM**) contenant des modules de programmation logique (**IP-B-LOM**, **PUG-LOM**), en utilisant
pour le type de base de l'ensemble de couplage périphérique sélectionné (**IP-B**), et/ou
pour chaque sous-ensemble de couplage périphérique (**PUG**) qui devient partie intégrante du module de couplage périphérique intelligent (**IP**) à fabriquer et pour lequel la logique programmable (**PL**) est nécessaire,
comprend respectivement au moins un module de programmation logique associé (**IP-B-LOM, PUG-LOM**) pour la partie de la logique programmable (**PL**) requise pour le ou les sous-ensembles de couplage périphérique respectifs (**PUG**) et/ou le type de base d'ensemble de couplage périphérique sélectionné (**IP-B**),
pour le type de base de l'ensemble de couplage périphérique sélectionné (**IP-B**) et/ou
pour chaque sous-ensemble de couplage périphérique (**PUG**) qui devient partie intégrante du module de couplage périphérique intelligent (**IP**) à fabriquer et pour lequel la logique programmable (**PL**) est nécessaire,
le ou les modules de programmation logique (**IP-B-LOM**, **PUG-LOM**) associés au sous-ensemble de couplage périphérique respectif (**PUG**) et/ou au type de base de sous-ensemble de couplage périphérique sélectionné (**IP-B**) sont sélectionnés à partir de la base de données d'ordinateur de module de programmation logique (**LOM**), et sont ajoutés au contenu d'une mémoire de données de programmation logique (**IP-LOM-MEM**) de la logique programmable (**PL**) pour le sous-ensemble de couplage périphérique intelligent (**IP**) à produire, et
la programmation logique (**IP-LOM-MEM**) de la logique programmable (**PL**) ainsi créée dans la mémoire de données par l'ajout du module de programmation logique respectif (IP-B-LOM, **PUG-LOM**) est adaptée pour la logique programmable (**PL**) pour le module de couplage périphérique intelligent (**IP**) à fabriquer en fonction de la disposition des pistes conductrices (**IP-L**) créée pour le module de couplage périphérique intelligent (**IP**) à fabriquer - de préférence en fonction de la disposition des pistes conductrices de la logique programmable (**PL-L**) pour la logique programmable (**PL**),
et ainsi la programmation logique (**IP-LO**) pour la logique programmable (**PL**) pour le module de couplage périphérique intelligent (**IP**) à fabriquer est créée dans la mémoire de données pour la programmation logique (**IP-LO-MEM**).

22. Procédé assisté par ordinateur pour créer une structure d'image de processus d'ensemble de couplage périphérique intelligent (**IP-PIS**) d'un ensemble de couplage périphérique intelligent (**IP**) à fabriquer selon l'une quelconque des revendications 5 à 14, **caractérisé en ce que**
pour le module de couplage périphérique intelligent (**IP**) à fabriquer, on établit un layout de pistes conductrices (**IP-L**) selon le procédé selon l'une des revendications 15 à 18, et
à l'aide d'une base de données informatique de structure d'image de processus (**PISD**) contenant une structure d'image de processus de sous-ensemble de couplage périphérique (**PUG-PI**) pour chaque sous-ensemble de couplage périphérique (**PUG**) qui devient un élément du sous-ensemble de couplage périphérique intelligent (**IP**) à fabriquer,
pour chaque sous-ensemble de couplage périphérique (**PUG**) qui fait partie du module de couplage périphérique intelligent (**IP**) à fabriquer, à partir de la base de données d'ordinateur de structure d'image de processus (**PISD**), la structure d'image de processus de sous-ensemble de couplage de périphérique (**PUG-PI**) associée du module de couplage de périphérique intelligent (**IP**) est sélectionnée et ajoutée au contenu d'une mémoire de données de structure d'image de processus (**IP-PIS-MEM**) avec la structure d'image de processus de module de couplage de périphérique intelligent (**IP-PIS**) pour le module de couplage de périphérique intelligent (**IP**) à fabriquer, et
une affectation de données est effectuée à l'aide du layout des pistes conductrices (**IP-L**) créé pour le module de couplage périphérique intelligent (IP) à fabriquer dans la structure de représentation du processus du module de couplage périphérique intelligent (IP-PIS), qui associe la structure de mappage de processus de sous-ensembles de couplage de périphériques (**PUG**) associée à chaque sous-ensemble de couplage de périphériques (**PUG**) du module de couplage de périphériques intelligent (**IP**) à fabriquer à une zone de données de la structure de mappage de processus de modules de couplage de périphériques intelligents (**IP-PIS**) du module de couplage de périphériques intelligent (**IP**) à fabriquer
et ainsi la structure d'image de processus de module de couplage périphérique intelligent (**IP-PIS**) du module de couplage périphérique intelligent (**IP**) à fabriquer est créée dans la mémoire de données pour la structure d'image de processus (**IP-PIS-MEM**).

23. Procédé assisté par ordinateur pour établir une programmation de microcontrôleur (**IP-MP**) pour un sous-ensemble de microcontrôleur (**MUG**) pour le fonctionnement programmé d'un ensemble de couplage périphérique intelligent (**IP**) à fabriquer selon l'une des revendications 5 à 14, **caractérisé en ce que**
pour le module de couplage périphérique intelligent (**IP**) à fabriquer, une structure d'image de processus de module de couplage périphérique intelligent (**IP-PIS**) est créée selon le procédé de la revendication 22 et
à l'aide d'une base de données informatique de modules de programmation de microcontrôleurs (**MPD**) contenant des modules de programmation de microcontrôleurs (**IP-B-MP, PUG-MP**), et ce faisant
pour le type de base de l'ensemble de couplage périphérique sélectionné (**IP-B**), et/ou
pour chaque sous-ensemble de couplage périphérique (**PUG**) qui devient partie intégrante du sous-ensemble de couplage périphérique intelligent (**IP**) à fabriquer,
comprend respectivement un module de programmation de microcontrôleur associé (**IP-B-MP, PUG-MP**) nécessaire pour le fonctionnement programmé du ou des sous-ensembles de couplage de périphériques respectifs (**PUG**) par le sous-ensemble de microcontrôleur (**MUG**) et/ou le type de base d'ensemble de couplage de périphériques sélectionné (**IP-B**),
pour le type de base de l'ensemble de couplage périphérique sélectionné (**IP-B**) et/ou
pour chaque sous-ensemble de couplage périphérique (**PUG**) qui devient partie intégrante du sous-ensemble de couplage périphérique intelligent (**IP**) à fabriquer,
le ou les modules de programmation de microcontrôleur (**IP-B-MP, PUG-MP**) associés au sous-ensemble de couplage périphérique (**PUG**) respectif et/ou au type de base de sous-ensemble de couplage périphérique (**IP-B**) sélectionné sont sélectionnés à partir de la base de données d'ordinateur de module de programmation de microcontrôleur (**MPD**), et sont ajoutés au contenu d'une mémoire de données pour la programmation de microcontrôleur (**IP-MP-MEM**) du sous-ensemble de couplage périphérique intelligent (**IP**) à fabriquer, et
la programmation de microcontrôleur (**IP-MP-MEM**) ainsi créée dans la mémoire de données pour la programmation de microcontrôleur (**IP-MP**) par l'ajout du module de programmation de microcontrôleur respectif (**IP-B-MP, PUG-MP**) pour le module de couplage périphérique intelligent (**IP**) à fabriquer est adaptée de manière correspondante à l'affectation de données à partir de la structure d'image de processus de module de couplage périphérique (**IP-PIS**) pour le module de couplage périphérique intelligent (**IP**) à fabriquer, que le module de programmation de microcontrôleur (**PUG-MP**) associé au sous-ensemble de couplage périphérique (**PUG**) respectif opère sur la zone de données respective de l'image de processus du sous-ensemble de couplage périphérique intelligent (**IP**) à fabriquer, qui présente les données du sous-ensemble de couplage périphérique (**PUG**) respectif
et ainsi la programmation de microcontrôleur (**IP-MP**) pour le fonctionnement programmé du module de couplage périphérique intelligent (**IP**) à fabriquer est créée dans la mémoire de données pour la programmation de microcontrôleur (**IP-MP-MEM**).

24. Procédé assisté par ordinateur pour la fabrication d'un module de couplage périphérique intelligent (**IP**) selon l'une des revendications 5 à 14, **caractérisé en ce que** pour le module de couplage périphérique intelligent (**IP**) à fabriquer
- un layout de pistes conductrices (**IP-L**) est établi selon le procédé selon l'une des revendications 15 à 18 et
- un plan d'assemblage de composants (**IP-BOM**) est établi selon le procédé de la revendication 19 et
au moyen du layout de pistes conductrices (**IP-L**) établi pour le module de couplage périphérique intelligent (**IP**) à **fabriquer** et du plan d'assemblage de composants (**IP-BOM**) établi pour le module de couplage périphérique intelligent (**IP**) à fabriquer, le module de couplage périphérique intelligent (**IP**) est fabriqué.

25. Procédé assisté par ordinateur pour la fabrication d'un module de couplage périphérique intelligent (**IP**) selon la revendication 24, **caractérisé en ce que** pour le module de couplage périphérique intelligent (**IP**) à fabriquer
- un layout de pistes conductrices (**IP-L**) est établi selon le procédé de la revendication 17 ou 18 et
- une programmation logique (**IP-LO**) d'une logique programmable (**PL**) pour le module de couplage périphérique intelligent (**IP**) à fabriquer est établie selon le procédé de la revendication 21 et
le module de couplage périphérique intelligent (**IP**) est également fabriqué au moyen de la programmation logique créée (**IP-LO**) en programmant la logique programmable (**PL**) située sur le module de couplage périphérique intelligent (**IP**) au moyen de la programmation logique (**IP-LO**) créée dans la mémoire de données pour la logique programmable (**IP-LOM-MEM**).

26. Procédé assisté par ordinateur pour réaliser un ensemble de couplage périphérique intelligent (IP) selon la revendication 24 ou 25, **caractérisé en ce que** pour l'ensemble de couplage périphérique intelligent à réaliser (**IP**), une programmation de microcontrôleur (**IP-MP**) d'un sous-ensemble de microcontrôleur (**MUG**) pour le fonctionnement programmé du l'ensemble de couplage périphérique intelligent (**IP**) a fabriquer soit créé selon le procédé de la revendication 23 et que l'ensemble de couplage périphérique intelligent (**IP**) soit également est fabriquée en au moyen de la programmation de microcontrôleur (**IP-MP**) programmant le sous-ensemble de microcontrôleur (**MUG**) se trouvant sur le module de couplage périphérique intelligent (**IP**) au moyen de la programmation de microcontrôleur (**IP-MP**) créée dans la mémoire de données pour la programmation de microcontrôleur (**IP-MP-MEM**).

27. Procédé assisté par ordinateur pour la configuration d'un système basé sur un réseau de données pour la commande et/ou la régulation et/ou la surveillance d'au moins un appareil périphérique (**PG**) par un appareil de commande (**CON**) - de préférence central- - au moyen d'une transmission de données entre des participants d'un réseau de données (**DN**), dans lequel
au moins un module de couplage périphérique intelligent (**IP**) selon l'une des revendications 5 à 14 est connecté en tant qu'abonné au réseau de données (**DN**), et
l'appareil de commande (**CON**) est également relié en tant qu'abonné au réseau de données (**DN**), l'appareil de commande (**CON**) présentant
un sous-ensemble de couplage au réseau du calculateur pour coupler le calculateur au réseau de données (**DN**),
au moins un processeur et au moins une mémoire, et
l'appareil de commande (**CON**) commande et/ou régule et/ou surveille l'appareil périphérique (**PG**) couplé au sous-groupe de couplage périphérique (**PUG**) respectif avec un module de commande logiciel (**PUG-SSM**) respectif appartenant au -sous-groupe de couplage périphérique (**PUG**) respectif et enregistré dans la mémoire de l'appareil de commande, au moyen de la transmission d'une image de processus par l'intermédiaire du réseau de données (**DN**), l'image de processus dans une zone de données associée au module de couplage périphérique intelligent respectif (**IP**) correspondant à une structure d'image de processus de module de couplage périphérique intelligent (**IP-PIS**) également déposée dans la mémoire de l'appareil de commande (**CON**), qui appartient au module de couplage périphérique intelligent (**IP**), qui présente le sous-module de couplage périphérique respectif (**PUG**) servant à la commande et/ou à la régulation et/ou à la surveillance de l'appareil périphérique (**PG**)
**caractérisé en ce que**
à l'aide d'une base de données informatique de sous-ensembles de couplage de périphériques (**PUGDB**), qui met à disposition, pour le sous-ensemble de couplage de périphériques (**PUG**) respectif, une spécification technique de sous-ensembles de couplage de périphériques (**PUG-TS**), qui présente au moins la taille du sous-ensemble de couplage de périphériques (**PUG**) respectif en emplacements de grille (**RP**) nécessaires dans la grille des sous-ensembles de couplage de périphériques- Zone (**SG**) du sous-ensemble de couplage de périphériques (**IP**) intelligent respectif,
des sous-ensembles de couplage périphérique (PUG) sont sélectionnés, qui font partie du système basé sur un réseau de données intelligent pour le contrôle et/ou la régulation et/ou la surveillance à configurer,
à l'aide d'une base de données informatique de sous-ensembles de couplage périphérique intelligents (**IPDB**), dans laquelle on peut prélever une spécification de sous-ensembles de couplage périphérique (**IP-SPEC**), qui indique au moins quels sous-ensembles de couplage périphérique (**PUG**) le sous-ensemble de couplage périphérique respectif (**IP**) est en mesure de recevoir dans la zone de sous-ensembles de couplage périphérique- (**SG**) avec la grille (**R**) comportant les multiples emplacements de grille (**RP**),
les sous-ensembles de couplage de périphériques **(PUG**) sélectionnés sont distribués (**D**) à au moins un ensemble de couplage de périphériques intelligent (**IP**) pour la réception, et
pour chacun des sous-ensembles de couplage de périphériques intelligents (**IP**) ainsi prévus pour recevoir des sous-ensembles de couplage de périphériques (**PUG**), une structure d'image de processus d'ensemble de couplage de périphériques intelligents (**IP-PIS**) est déterminée selon le procédé de la revendication 22, et
à l'aide d'une base de données informatique de modules logiciels de sous-ensembles de couplage de périphériques (SSMDB), qui comprend des modules de commande logiciels (PUG-SSM) associés à des sous-ensembles de couplage de périphériques (PUG),
pour chaque sous-ensemble de couplage périphérique (PUG) qui devient partie intégrante du système intelligent basé sur un réseau de données à configurer pour la commande et/ou la régulation et/ou la surveillance, le module de commande logiciel (PUG-SSM) appartenant au sous-ensemble de couplage périphérique (PUG) respectif est sélectionné, et
dans la mémoire de l'appareil de commande (**CON**) sont déposés la structure d'image de processus de module de couplage périphérique intelligent (**IP-PIS**) déterminée de chaque module de couplage périphérique intelligent (**IP**) prévu pour recevoir des sous-ensembles de couplage périphérique (**PUG**) et les modules de commande logiciels (**PUG-SSM**) sélectionnés associés aux sous-ensembles de couplage périphérique (**PUG**), qui deviennent partie intégrante du système intelligent à base de réseau de données à configurer pour la commande et/ou la régulation et/ou la surveillance.

28. Procédé assisté par ordinateur pour la configuration d'un système basé sur un réseau de données pour la commande et/ou la régulation et/ou la surveillance d'au moins un appareil périphérique (**PG**) par un appareil de commande (**CON**) au moyen d'une transmission de données entre des participants (**CON, IP**) d'un réseau de données (**DN**) selon la revendication 27, **caractérisé en ce qu'**on utilise comme réseau de données (**DN**) un bus de terrain - de préférence en temps réel -, de préférence un Ethernet industriel.

29. Procédé assisté par ordinateur pour la configuration d'un système basé sur un réseau de données pour la commande et/ou la régulation et/ou la surveillance d'au moins un appareil périphérique (**PG**) par un appareil de commande (**CON**) au moyen d'une transmission de données entre des abonnés (**CON, IP**) d'un réseau de données (**DN**) selon la revendication 27, **caractérisé en ce que**
lors de la transmission de l'image ou des images de processus entre les participants (**CON, IP**) du réseau de données (**DN**), un télégramme de données est retransmis de participant (**CON, IP**) à participant (**CON, IP**), et
pour chaque participant (**CON, IP**), une zone de données est prévue dans le télégramme de données, qui est prévue pour des données de ou pour ce participant (**CON, IP**), et où le participant respectif (**CON, IP**) peut écrire des données dans la zone du télégramme de données qui est prévue pour des données de ce participant (**CON, IP**), ou où le participant respectif (**CON, IP**) peut lire des données dans la zone du télégramme de données qui est prévue pour des données pour ce participant (**CON, IP**), et
le télégramme de données démarre à partir de l'appareil de commande (**CON**) et est retransmis à l'appareil de commande (**CON**) après réception par le dernier participant (**IP**) du réseau de données (**DN**), et dans la mémoire de l'appareil de commande (**CON**) sont également déposées des entrées concernant la structure du télégramme de données en ce sens que telle zone de données respective du télégramme de données est prévue pour l'image de processus de tel module de couplage périphérique intelligent (**IP**) en tant que participant du réseau de données (**DN**).
